# EUROPEAN PATENT APPLICATION

(11) **EP 4 672 218 A1**
(43) Date of publication of application: **31.12.2025**
(21) Application number: 25185354.5
(22) Date of filing: 25.06.2025
(51) Int. Cl.: G09G 3/3233, H10K 59/12

(54) **DISPLAY DEVICE AND ELECTRONIC DEVICE INCLUDING THE SAME**

(30) Priority: 26.06.2024 KR 20240083847; 14.08.2024 KR 20240109226
(71) Applicant: Samsung Display Co., Ltd., Yongin-si, Gyeonggi-do 17113 (KR)
(72) Inventor: BOK, Seung Lyong, 17113 Yongin-si (KR); KIM, Chang Sik, 17113 Yongin-si (KR); KIM, Sung Hoon, 17113 Yongin-si (KR); RYU, An Na, 17113 Yongin-si (KR)
(74) Representative: Walaski, Jan Filip

(57) **Abstract**

A display device includes a pixel (PXL) comprising a sub-pixel area (SPA) in which a plurality of sub-pixels (SP1, SP2, SP3) are disposed on a substrate, and a window area (WDA) positioned adjacent to the sub-pixel area in a first direction (DR1) on the substrate and including an area through which light is transmitted through the substrate on a plane.

## Description

This application claims priority to Korean Patent Applications No. 10-2024-0083847, filed on 26 June 2024, and No. 10-2024-0109226, filed on 14 August 2024.

### BACKGROUND

### 1. FIELD

The disclosure relates to a display device and an electronic device including the same.

### 2. DESCRIPTION OF THE RELATED ART

As information technology develops, the importance of a display device which is a connection medium between a user and information is being highlighted. In response to this, use of display devices such as a liquid crystal display device (LCD) and an organic light emitting display device is increasing.

Display devices are gradually being used in various environments. In this atmosphere, the display device is required to be in harmony with surrounding environment. As one method for achieving this, research on a so-called transparent display device that allows a user to see a background beyond the display device is being conducted.

### SUMMARY

A technical feature to be solved is to provide a display device and an electronic device including the same capable of increasing light transmittance of a transparent display device.

Embodiments may provide a display device. The display device may include a sub-pixel area in which a plurality of sub-pixels are disposed on a substrate, and a window area positioned adjacent to the sub-pixel area in a first direction on the substrate and including an area through which light is transmitted through the substrate on a plane.

The sub-pixel area may include a pixel circuit area in which a pixel circuit, which includes at least one transistor and at least one capacitor, of each of the plurality of sub-pixels is disposed, and a light transmission area positioned adjacent to the window area in the first direction and adjacent to the pixel circuit area in a second direction intersecting the first direction, and in which at least one line extending in the second direction and electrically connected to the transistor on the substrate is disposed.

A first scan line and a second scan line may extend in the first direction. The window area may include a first window area positioned adjacent to the pixel circuit area in the first direction, and a second window area positioned adjacent to the first window area in the second direction with at least one of the first scan line and the second scan line interposed therebetween.

The pixel circuit may include a first transistor including a gate electrode connected to a first node and connected between a first power line and a second node, a second transistor controlled in response to a first scan signal applied to the first scan line and connected between a data line and the first node, and a third transistor controlled in response to a second scan signal applied to the second scan line and connected between the second node and a reference voltage line.

The first power line and the data line may extend in the second direction and cross the light transmission area.

The pixel circuits of the plurality of sub-pixels may be positioned adjacent to each other in the first direction. The pixel circuits of the plurality of sub-pixels may be positioned adjacent to the light transmission area in the second direction.

The plurality of sub-pixels may include at least one light emitting element. The light emitting element may be positioned so as not to overlap the window area on the plane.

The plurality of sub-pixels may include a first sub-pixel configured to emit light of a first wavelength band, a second sub-pixel configured to emit light of a second wavelength band different from the first wavelength band, and a third sub-pixel configured to emit light of a third wavelength band different from the first and second wavelength bands.

Each of the first to third sub-pixels may include a light emitting element. The light emitting element of the first sub-pixel may be positioned to overlap the pixel circuit area. The light emitting element of each of the second and third sub-pixels may be positioned to overlap the light transmission area.

A second power line extending in the second direction may be further disposed in the light transmission area. The first to third sub-pixels may include corresponding one of a first light emitting element, a second light emitting element, and a third light emitting element positioned adjacent to each other in the first direction. Each of the first to third light emitting elements may include an anode electrode connected to the pixel circuit, and a cathode electrode electrically connected to the second power line through a connection electrode.

The cathode electrode of each of the first to third sub-pixels may be positioned to overlap a semiconductor layer of the second transistor of each of the first to third sub-pixels on the plane.

The cathode electrode of each of the first to third sub-pixels may be positioned between a semiconductor layer of the third transistor of each of the first to third sub-pixels and the light transmission area.

The first to third sub-pixels may include a corresponding one of a first light emitting element, a second light emitting element, and a third light emitting element positioned adjacent to each other in the first direction. Each of the first to third light emitting elements may include an anode electrode connected to the pixel circuit at a lower surface of the first to third light emitting elements, and a cathode electrode to which a second power voltage is applied at an upper surface of the first to third light emitting elements.

The cathode electrode of each of the first to third sub-pixels may be positioned so as to overlap a semiconductor layer of the second transistor of each of the first to third sub-pixels on the plane.

The cathode electrode of each of the first to third sub-pixels may be positioned between a semiconductor layer of the third transistor of each of the first to third sub-pixels and the light transmission area.

A second power line extending in the second direction may be further disposed in the light transmission area. The pixel circuit of each of the first to third sub-pixels may be electrically connected to a light emitting element. The light emitting element may include first to third anode electrodes respectively connected to the pixel circuits of the first to third sub-pixels, and a cathode electrode electrically connected to the second power line.

The light emitting element may be positioned between a semiconductor layer of the third transistor of each of the first to third sub-pixels and the light transmission area.

The first window area may be positioned adjacent to a semiconductor layer of the first transistor in the first direction. The second window area may not be positioned adjacent to the semiconductor layer of the first transistor in the first direction.

Each of the first to third transistors may include an N-type semiconductor layer.

The first window area and at least a portion of the second window area may be positioned adjacent to a semiconductor layer of the first transistor in the first direction.

The semiconductor layer of the first transistor may include a P-type semiconductor layer, and a semiconductor layer of the third transistor may include an N-type semiconductor layer.

Embodiments may provide an electronic device including a display device and a host to control the display device, wherein the display device includes a sub-pixel area in which a plurality of sub-pixels are disposed on a substrate, and a window area positioned adjacent to the sub-pixel area in a first direction on the substrate and including an area through which light is transmitted through the substrate on a plane.

The sub-pixel area may include a pixel circuit area in which a pixel circuit, which includes at least one transistor and at least one capacitor, of each of the plurality of sub-pixels is disposed, and a light transmission area positioned adjacent to the window area in the first direction and adjacent to the pixel circuit area in a second direction intersecting the first direction, and in which at least one line extending in the second direction and electrically connected to the transistor on the substrate is disposed.

The first scan line and a second scan line may extend in the first direction. The window area may include a first window area positioned adjacent to the pixel circuit area in the first direction, and a second window area positioned adjacent to the first window area in the second direction with at least one of the first scan line and the second scan line interposed therebetween.

The pixel circuit may include a first transistor including a gate electrode connected to a first node and connected between a first power line and a second node, a second transistor controlled in response to a first scan signal applied to the first scan line and connected between a data line and the first node, and a third transistor controlled in response to a second scan signal applied to the second scan line and connected between the second node and a reference voltage line.

### BRIEF DESCRIPTION OF THE DRAWINGS

The above and other features of the invention will become more apparent by describing in further detail embodiments thereof with reference to the accompanying drawings.
FIG. 1 is a system block diagram of a display device.
FIG. 2 is an equivalent circuit diagram of a sub-pixel.
FIG. 3 is a first embodiment of a pixel.
FIG. 4 is a drawing specifically illustrating a pixel circuit area and a light transmission area in the pixel of FIG. 3.
FIG. 5 is a drawing illustrating that pixel circuits are positioned adjacent in a first direction in the pixel circuit area of FIG. 3.
FIGS. 6, 7, 8, 9, 10, 11, 12, and 13 are drawings illustrating a method of manufacturing a display device.
FIG. 14 is an equivalent circuit diagram of a sub-pixel.
FIGS. 15, 16, 17, 18, 19, 20, 21, 22, 23, 24, and 25 are diagrams illustrating a method of manufacturing a display device.
FIG. 26 is a second embodiment of the pixel, in which a flip type light emitting element is disposed.
FIGS. 27, 28, 29, 30, 31, 32, and 33 are diagrams illustrating a method of manufacturing a display device.
FIG. 34 is the second embodiment of the pixel, in which a vertical-type light emitting element is disposed.
FIGS. 35, 36, 37, 38, 39, 40, and 41 are diagrams illustrating a method of manufacturing a display device.
FIG. 42 is a third embodiment of the pixel, in which the flip type light emitting element is disposed.
FIGS. 43, 44, 45, 46, 47, 48, and 49 are diagrams illustrating a method of manufacturing a display device.
FIG. 50 is the third embodiment of the pixel in which the vertical-type light emitting element is disposed.
FIGS. 51, 52, 53, 54, 55, 56, and 57 are diagrams illustrating a method of manufacturing a display device.
FIG. 58 is a fourth embodiment of the pixel, in which a monolithic type light emitting element is disposed.
FIG. 59 is an example of a cross-sectional view of the monolithic type light emitting element of FIG. 58 taken along line A-A'.
FIGS. 60, 61, 62, 63, 64, 65, and 66 are drawings illustrating a method of manufacturing a display device.

### DETAILED DESCRIPTION

Hereinafter, various embodiments will be described in detail with reference to the accompanying drawings so that those skilled in the art may easily carry out the disclosure. The disclosure may be implemented in various different forms and is not limited to the embodiments described herein.

In order to clearly describe the disclosure, parts that are not related to the description are omitted, and the same or similar elements are denoted by the same reference numerals throughout the specification. Therefore, the above-described reference numerals may be used in other drawings.

In addition, sizes and thicknesses of each component shown in the drawings are arbitrarily shown for convenience of description, and thus the disclosure is not necessarily limited to those shown in the drawings. In the drawings, thicknesses may be exaggerated to clearly express various layers and areas.

In addition, an expression "is the same" in the description may mean "is substantially the same". That is, the expression "is the same" may be the same enough for those of ordinary skill to understand that it is the same. Other expressions may also be expressions in which "substantially" is omitted.

Terms of "first", "second", and the like may be used to describe various components, but the components should not be limited by the terms. The terms are used only for the purpose of distinguishing one component from another component. For example, without departing from the scope of the disclosure, a first component may be referred to as a second component, and similarly, a second component may also be referred to as a first component. The singular expressions include plural expressions unless the context clearly indicates otherwise.

Terms of "under", "below", "on", and "above" are used to describe an association of configurations shown in the drawings. The terms are described based on a direction indicated in the drawings as relative concepts.

Unless defined otherwise, all terms (including technical terms and scientific terms) used herein have the same meaning as a meaning generally understood by one of ordinary skill in the art to which the disclosure belongs. In addition, terms such as terms defined in a generally used dictionary are to be interpreted as having a meaning consistent with a meaning in a context of the related art, and are explicitly defined herein unless interpreted in an ideal or overly formal meaning.

It should be understood that a term of "include", "have", or the like is used to specify that there is a feature, a number, a step, an operation, a component, a part, or a combination thereof described in the specification, but does not exclude a possibility of the presence or addition of one or more other features, numbers, steps, operations, components, parts, or combinations thereof in advance.

Hereinafter, embodiments are described in detail with reference to the accompanying drawings.

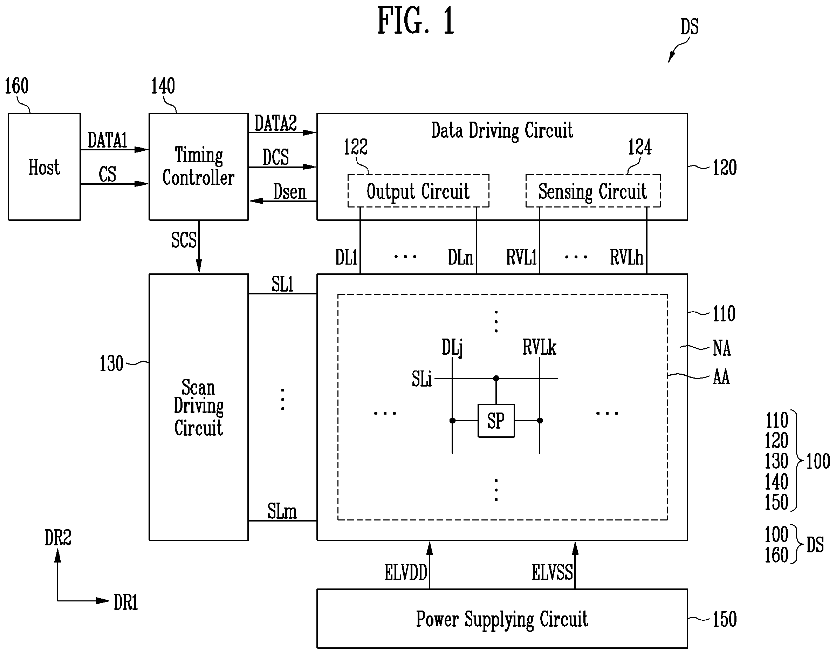

FIG. 1 is a system block diagram of a display device 100.

Referring to FIG. 1, the display device 100 may include a display panel 110, a data driving circuit 120, a scan driving circuit 130, a timing controller 140, and a power supply circuit 150, and the like.

A plurality of sub-pixels SP are disposed in the display panel 110. In the display panel 110, a plurality of data lines DL1 to DLn (n is an integer of 2 or more), a plurality of scan lines SL1 to SLm (m is an integer of 2 or more), a plurality of reference voltage lines RVL1 to RVLh (h is an integer of 2 or more), and the like electrically connected to the plurality of sub-pixels SP may be disposed. In the display panel 110, one or more power lines configured to apply a power voltage (for example, a first power voltage ELVDD, a second power voltage ELVSS, and the like) to a plurality of sub-pixels SP may be disposed. The data lines DL1 to DLn, the scan lines SL1 to SLm, the reference voltage lines RVL1 to RVLh, and the power line may be referred to as "lines".

The display panel 110 may include a display area AA where the plurality of sub-pixels SP are disposed, and a non-display area NA positioned in a peripheral area of the display area AA (for example, an edge of the display area AA).

The display panel 110 may be formed flat, but is not limited thereto. For example, the display panel 110 may include a curved surface portion formed at left and right ends. A curved surface may have a constant curvature or a changing curvature. In addition, the display panel 110 may be flexible so as to be curved, warped, bent, folded, or rolled.

The plurality of sub-pixels SP may be disposed in a matrix type in the display area AA. The plurality of sub-pixels SP or pixel circuits thereof may be disposed in a stripe type in which the plurality of sub-pixels SP or the pixel circuits thereof are disposed side by side in one direction in the display area AA. However, embodiments are not limited thereto.

The plurality of data lines DL1 to DLn may extend in one direction in the display panel 110. For example, the one direction may be a second direction DR2. The plurality of data lines DL1 to DLn may extend and may be disposed in the second direction DR2 (for example, overall in the second direction DR2) in the display panel 110. For example, the second direction DR2 may be a direction crossing from an upper side to a lower side of the display panel 110, but it is not limited thereto.

The plurality of scan lines SL1 to SLm may extend in one direction in the display panel 110. For example, the one direction may be a first direction DR1. The plurality of scan lines SL1 to SLm may extend and may be disposed in the first direction DR1 (for example, overall in the first direction DR1) in the display panel 110. The first direction DR1 may be a direction different from the second direction DR2, but it is not limited thereto. For example, the first direction DR1 may be a direction crossing from a left side to a right side of the display panel 110.

The plurality of reference voltage lines RVL1 to RVLh may extend in one direction in the display panel 110. The plurality of reference voltage lines RVL1 to RVLh may extend and may be disposed in the second direction DR2 (for example, overall in the second direction DR2). However, embodiments are not limited thereto.

The data driving circuit 120 may include an output circuit 122 and a sensing circuit 124. The output circuit 122 and the sensing circuit 124 may be disposed to be functionally separate in the same integrated circuit. The output circuit 122 and the sensing circuit 124 may be respectively disposed in different integrated circuits.

The output circuit 122 may be configured to supply a data voltage to the plurality of data lines DL1 to DLn. The output circuit 122 may generate the data voltage based on second image data DATA2 and a data driving circuit control signal DCS, and output the generated data voltage to the plurality of data lines DL1 to DLn according to a timing. The data driving circuit control signal DCS may include, for example, a source start pulse (SSP) signal, a source shift clock (SSC) signal, and a source output enable (SOE) signal, and the like.

The sensing circuit 124 is configured to input a reference voltage to the plurality of reference voltage lines RVL1 to RVLh in response to the data driving circuit control signal DCS and sense a voltage of the plurality of reference voltage lines RVL1 to RVLh. The sensing circuit 124 may convert a sensed analog voltage into a digital sensing value Dsen corresponding thereto. The sensing circuit 124 may include one or more analog-to-digital converters (ADCs). The data driving circuit control signal DCS may include, for example, a reference voltage switching signal, a sampling control signal, a hold control signal, and the like.

The data driving circuit 120 may be implemented as an integrated circuit (for example, a source driver integrated circuit (SDIC)) formed separately from the display panel 110. The data driving circuit 120 may be formed together with the display panel 110, and may be formed in at least a partial area of the non-display area NA of the display panel 110.

The scan driving circuit 130 is configured to output a scan signal to the plurality of scan lines SL1 to SLm in response to a scan driving circuit control signal SCS. The scan driving circuit control signal SCS may include a start signal indicating a start of a frame, a horizontal synchronization signal for outputting the scan signal according to a timing at which the data voltage is applied, and the like.

The scan driving circuit 130 may be implemented as an integrated circuit (for example, a gate driving integrated circuit (GDIC)) formed separately from the display panel 110. The scan driving circuit 130 may be formed together with the display panel 110, and may be formed in at least a partial area of the non-display area NA of the display panel 110.

The timing controller 140 may be configured to control the data driving circuit 120 and the scan driving circuit 130. The timing controller 140 may generate and output the control signals DCS and SCS for controlling the data driving circuit 120 and the scan driving circuit 130 based on a control signal (for example, a synchronization signal, a clock signal, a data enable signal, and the like) received through a host 160. The timing controller 140 may generate the synchronization signal, the data enable signal, and the like therein, based on the control signal (for example, information on a driving frequency (or a frame rate) of an image displayed on the display panel 110) received through the host 160.

The timing controller 140 may receive first image data DATA1 from the host 160 and align the input first image data DATA1 in a pixel row unit. The timing controller 140 may convert the input first image data DATA1 according to a preset interface (for example, low voltage differential signaling (LVDS), a display port (DP), an embedded display port (eDP), and the like). The second image data DATA2 output from the timing controller 140 to the data driving circuit 120 may be obtained by conversion inside the timing controller 140 according to the preset interface.

The timing controller 140 may generate the second image data DATA2 based on the input first image data DATA1 and the sensing value Dsen. The second image data DATA2 may be obtained by compensation for a characteristic value change (for example, a change in a characteristic value due to deterioration of a circuit element, and the like) of the sub-pixel SP.

The timing controller 140 may be disposed in the display device 100 in a logic type. The timing controller 140 may be disposed in the display device 100 in a processor type. The timing controller 140 may include one or more memories (for example, a register, and the like).

The power supply circuit 150 may be configured to output a constant voltage of a constant voltage level. The power supply circuit 150 may output a power voltage (for example, the first power voltage ELVDD, the second power voltage ELVSS, and the like) supplied to the display panel 110. The power supply circuit 150 may output a voltage (for example, a gate high voltage, a gate low voltage, and the like) supplied to the scan driving circuit 130. The power supply circuit 150 may output a voltage (for example, a gamma voltage, a reference voltage, and the like) supplied to the data driving circuit 120. For example, the power supply circuit 150 may include a regulator (for example, a low dropout (LDO) regulator, and the like). For example, the power supply circuit 150 may be implemented as a power management integrated circuit (PMIC).

The host 160 may include a set-top box, an application processor (AP), and the like. The host 160 may be a configuration external to the display device 100, which is not included in the display device 100. The host 160 may be mounted in the display device 100. Transmission and reception of the first image data DATA1 and the control signal CS may be performed between the host 160 and the display device 100 through an interface. For example, the interface may be a serial programming interface (SPI), an inter integrated circuit (I2C), a mobile industry processor interface (MIPI), and the like. However, it is not limited thereto.

An electronic device DS may include the display device 100 and the host 160.

In FIG. 1, circuits that supply a signal, a voltage, and the like to the display panel 110 are merely classified according to function. For example, the data driving circuit 120 and the timing controller 140 may be formed in one integrated circuit. The data driving circuit 120 and the timing controller 140 may be classified according to function in one integrated circuit in the display device 100.

The display device 100 may be used as a display screen of various products, including not only a mobile electronic device such as a mobile phone, a smart phone, a tablet personal computer (PC), a smart watch, a watch phone, a mobile communication terminal, an electronic notebook, an electronic book, a portable multimedia player (PMP), a navigation device, and an ultra-mobile personal computer (UMPC), but also a television, a notebook computer, a monitor, a billboard, and internet of things (IoT) devices.

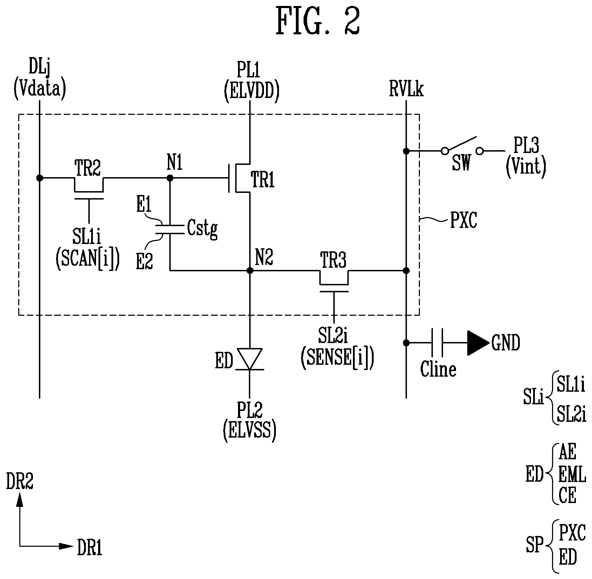

FIG. 2 is an equivalent circuit diagram of a sub-pixel SP.

The sub-pixel SP may include a light emitting element ED and a pixel circuit PXC configured to supply a current (for example, a driving current) to the light emitting element ED. The pixel circuit PXC may include two or more switching elements (for example, transistors) and one or more storage elements (for example, a capacitor).

Referring to FIG. 2, the pixel circuit PXC may include a first transistor TR1, a second transistor TR2, a third transistor TR3, and a storage capacitor Cstg. However, it is not limited thereto, and a configuration of the pixel circuit PXC may be freely implemented according to design of a person skilled in the art. Below, an embodiment in which the pixel circuit PXC includes the first to third transistors TR1 to TR3 and the storage capacitor Cstg is described as an example.

The light emitting element ED may include a first electrode (one of an anode electrode AE and a cathode electrode CE), a second electrode (the other of the anode electrode AE and the cathode electrode CE), and an emission layer EML. For example, the emission layer EML may include an organic material and/or an inorganic material. For example, the light emitting element ED may be implemented as an organic light emitting diode having an organic emission layer. For example, the light emitting element ED may be implemented as an inorganic light emitting diode having an inorganic emission layer. For example, the emission layer EML of the light emitting element ED may include a nano rod.

Referring to FIG. 2, the first electrode (for example, the anode electrode AE) of the light emitting element ED may be electrically connected to a second node N2. The second electrode (for example, the cathode electrode CE) of the light emitting element ED may be electrically connected to a second power line PL2.

The second power voltage ELVSS is applied to the second power line PL2. For example, the second power voltage ELVSS may be a ground voltage or a low potential voltage of a level lower than the ground voltage.

The light emitting element ED may be formed as a separate chip type and may be connected to the pixel circuit PXC. For example, the light emitting element ED may be a flip type, a vertical type, or a monolithic type.

The light emitting element ED of the flip type may have both of a first electrode (for example, an anode electrode AE) and a second electrode (for example, a cathode electrode CE) facing a lower surface of the light emitting element ED, and may be connected to the pixel circuit PXC and the second power line PL2 at the lower surface. Light emitted from the light emitting element ED may be entirely emitted in an upper surface direction of the light emitting element ED.

The light emitting element ED of the vertical type may have a first electrode (for example, an anode electrode) facing a lower surface of the light emitting element ED, and may be connected to the pixel circuit PXC at the lower surface. A second electrode (for example, a cathode electrode) may face an upper surface of the light emitting element ED, and may be connected to the second power line PL2 at the upper surface. Light emitted from the light emitting element ED may be entirely emitted in an upper surface direction.

The light emitting element ED of the monolithic type may include a plurality of first electrodes (for example, the anode electrodes AE) and one second electrode (for example, cathode electrode CE). The plurality of respective first electrodes may be connected to the pixel circuits PXC of different sub-pixels SP. The second electrode may be connected to the second power line PL2. The plurality of first electrodes and the second electrode may face a lower surface of the light emitting element ED, and may be connected to the pixel circuit PXC and the second power line PL2 at the lower surface, respectively.

The first transistor TR1 may be configured to control a size of a current flowing from a first power line PL1 toward the second node N2 based on a voltage applied to a first node N1. The first transistor TR1 may include a gate electrode, a first electrode (one of a source electrode and a drain electrode), and a second electrode (the other of the source electrode and the drain electrode). The gate electrode of the first transistor TR1 may be electrically connected to the first node N1. The first electrode (for example, the drain electrode) of the first transistor TR1 may be electrically connected to the first power line PL1. The first power voltage ELVDD may be applied to the first power line PL1. For example, the first power voltage ELVDD may be a high potential voltage. The second electrode (for example, the source electrode) of the first transistor TR1 may be electrically connected to the second node N2. A data voltage Vdata or a voltage corresponding to the data voltage Vdata may be applied to the first node N1. A current corresponding to the voltage applied to the first node N1 may flow through the first transistor TR1. The first transistor TR1 may be referred to as a driving transistor.

The second transistor TR2 may be configured to switch an electrical connection between a j-th data line DLj (j is an integer that is greater than or equal to 2 and less than or equal to n) and the first node N1. An operation timing of the second transistor TR2 may be controlled by a first scan signal SCAN[i] (i is an integer that is greater than or equal to 2 and less than or equal to m). The first scan signal SCAN[i] may be applied to an i-th first scan line SL1i (hereinafter, abbreviated as a first scan line SL1i). The second transistor TR2 may be turned on in response to the first scan signal SCAN[i] of a turn-on level. When the second transistor TR2 is turned on, the data voltage Vdata may be applied to the first node N1. The second transistor TR2 may be referred to as a scan transistor.

The third transistor TR3 may be configured to switch an electrical connection between the second node N2 and the k-th reference voltage line RVLk (k is an integer that is greater than or equal to 2 and less than or equal to h, and hereinafter, the k-th reference voltage line RVLk is abbreviated as the reference voltage line RVLk). An operation timing of the third transistor TR3 may be controlled by a second scan signal SENSE[i]. The second scan signal SENSE[i] may be applied to an i-th second scan line SL2i (hereinafter, abbreviated as a second scan line SL2i). The first scan line SL1i and the second scan line SL2i may be collectively referred to as the scan line SLi. The third transistor TR3 may be turned on in response to the second scan signal SENSE[i] of a turn-on level. When the third transistor TR3 is turned on, the second node N2 and the reference voltage line RVLk may be electrically connected. An initialization voltage Vint may be applied to the reference voltage line RVLk through a third power line PL3. A switching element SW may be provided between the reference voltage line RVLk and the third power line PL3. A voltage applied to the reference voltage line RVLk may be stored in a line capacitor Cline. The line capacitor Cline may be an intentionally and physically formed capacitor element rather than a parasitic capacitor. For example, a line capacitor Cline may be formed between a reference voltage line RVLk and ground GND. However, it is not limited thereto. The third transistor TR3 may be referred to as a sensing transistor.

Referring to FIG. 2, each of the first to third transistors TR1 to TR3 may be a transistor including an N-type semiconductor layer. In this case, a turn-on level voltage of the first to third transistors TR1 to TR3 may be a high level voltage (for example, a gate high voltage), and a turn-off level voltage may be a low level voltage (for example, a gate low voltage). At least one of the first to third transistors TR1 to TR3 may include a P-type semiconductor layer. In this case, a turn-on level voltage of the transistor including the P-type semiconductor layer may be a low level voltage (for example, a gate low voltage), and a turn-off level voltage may be a high level voltage (for example, a gate high voltage).

Referring to FIG. 2, the first transistor TR1 may display a high-grayscale image in response to a high level data voltage Vdata, and may display a low-grayscale image in response to a low level data voltage Vdata.

At least one of the first to third transistors TR1 to TR3 may include a semiconductor layer of amorphous silicon (a-Si). At least one of the first to third transistors TR1 to TR3 may include a semiconductor layer of polycrystalline silicon (poly-Si). At least one of the first to third transistors TR1 to TR3 may include an oxide semiconductor layer including metal oxide.

The storage capacitor Cstg may be configured to maintain a voltage difference between the first node N1 and the second node N2. The storage capacitor Cstg may include a first electrode E1 electrically connected to the first node N1 and a second electrode E2 electrically connected to the second node N2. The first electrode E1 and the second electrode E2 may be positioned so as to face each other and overlap each other on a plane. The storage capacitor Cstg may be an intentionally and physically formed capacitor element, not a parasitic capacitor.

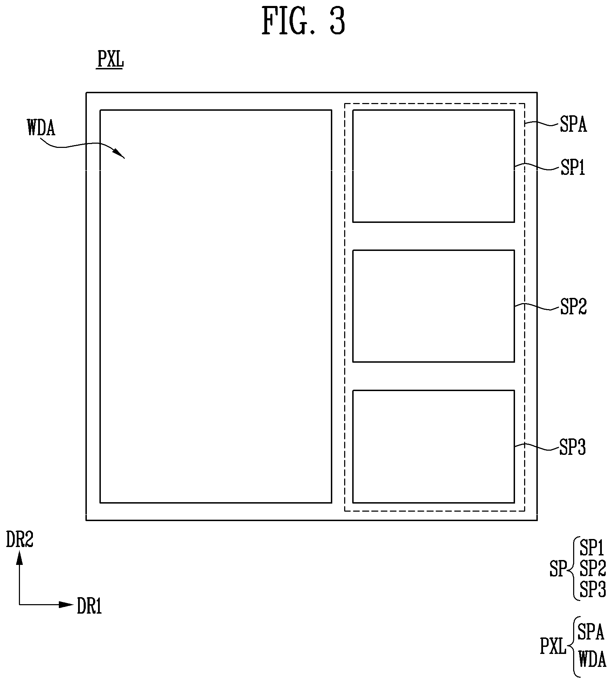

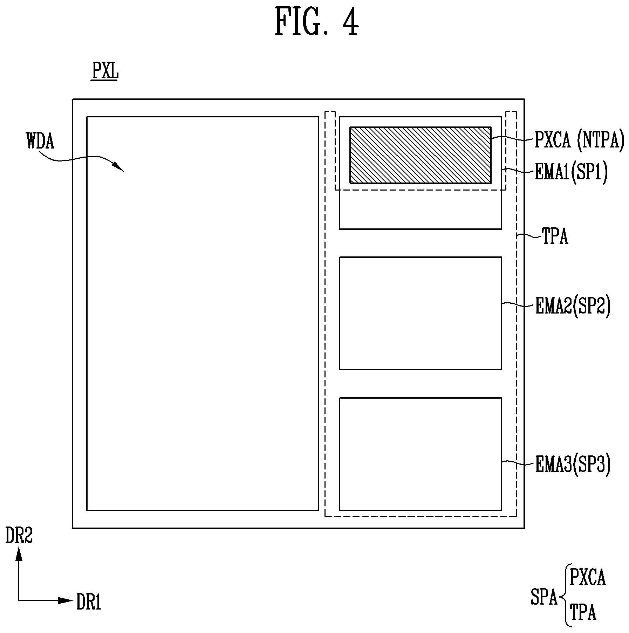

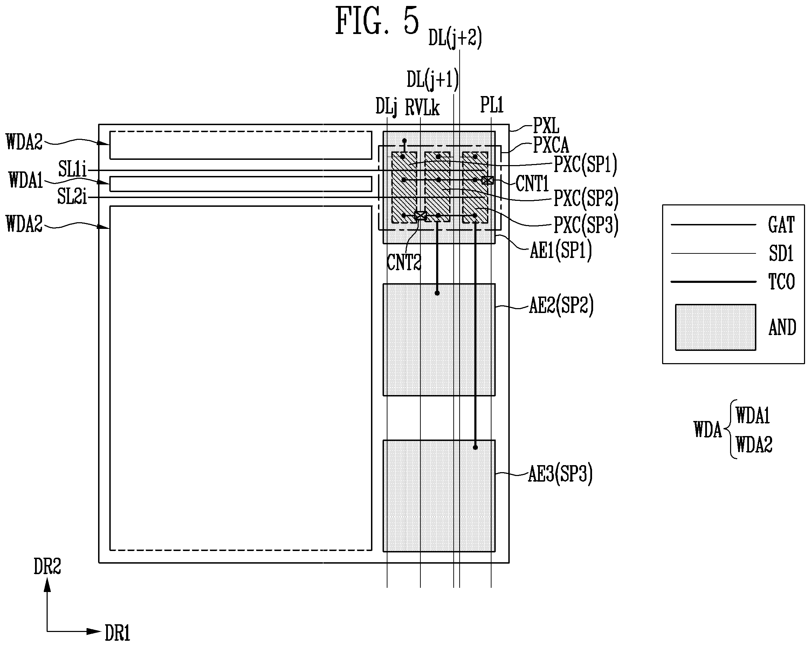

FIG. 3 is a first embodiment of a pixel PXL. FIG. 4 is a drawing specifically illustrating a pixel circuit area PXCA and a light transmission area TPA in the pixel PXL of FIG. 3. FIG. 5 is a drawing illustrating that pixel circuits are positioned adjacent to each other in the first direction DR1 in the pixel circuit area PXCA of FIG. 3.

Referring to FIG. 3, the pixel PXL may include a sub-pixel area SPA in which the sub-pixel SP is positioned and a window area WDA positioned adjacent to the sub-pixel area SPA.

A plurality of sub-pixels SP may be positioned in the sub-pixel area SPA. The plurality of sub-pixels SP may include a first sub-pixel SP1, a second sub-pixel SP2, and a third sub-pixel SP3.

Each of the first sub-pixel SP1, the second sub-pixel SP2, and the third sub-pixel SP3 may be configured to emit light of different wavelength bands. For example, the first sub-pixel SP1 may be configured to emit light of a first wavelength band. The second sub-pixel SP2 may be configured to emit light of a second wavelength band. The third sub-pixel SP3 may be configured to emit light of a third wavelength band.

The first wavelength band may be, for example, a red wavelength band. The second wavelength band may be, for example, a green wavelength band. The third wavelength band may be, for example, a blue wavelength band. The red wavelength band may be about 630 to 750 nanometers (nm). The green wavelength band may be about 495 to 570 nm. The blue wavelength band may be about 450 to 495 nm.

Light of various wavelength bands may be achieved by employing a light emitting elements ED (see FIG. 2) that emit light of various wavelength bands. Light of various wavelength bands may be achieved by employing a light emitting element ED that emit light of a single wavelength band (for example, a blue wavelength band) and a color filter configured to convert a wavelength.

Light of different wavelength bands may be emitted by the sub-pixels SP1, SP2, and SP3 positioned in the sub-pixel area SPA, and thus light of various grayscales and variously colors may be recognized.

Referring to FIG. 5, the window area WDA may include a first window area WDA1 and a second window area WDA2. The first scan line SL1i or the second scan line SL2i may be positioned between the first window area WDA1 and the second window area WDA2. On the plane, the first window area WDA1 and the second window area WDA2 may be positioned apart from each other in the second direction DR2 with the first scan line SL1i or the second scan line SL2i interposed therebetween.

Referring further to FIG. 5 described above, the area of the window area WDA may correspond to about 67% of the area of the pixel PXL. For example, the area of the first window area WDA1 may correspond to about 7% of the area of the pixel PXL. The area of the second window area WDA2 may correspond to about 60% of the area of the pixel PXL.

The window area WDA may include an area through which light may pass through a substrate. A semiconductor layer and a line may not be positioned in the window area WDA. For example, referring further to FIGS. 2 and 5, a semiconductor layer of the transistors TR1, TR2, and TR3 configuring the pixel circuit PXC, and a source electrode and a drain electrode of the transistors TR1, TR2, and TR3 may not be positioned in the window area WDA. The first electrode E1 and the second electrode E2 of the storage capacitor Cstg may not be positioned in the window area WDA. The first and second power lines PL1 and PL2 may not be positioned in the window area WDA. The first and second scan lines SL1i and SL2i may not be positioned in the window area WDA.

Referring to FIG. 3, the window area WDA and the sub-pixel area SPA may be positioned adjacent to each other in the first direction DR1. The first to third sub-pixels SP1 to SP3 may be positioned adjacent to each other in the second direction DR2 in the sub-pixel area SPA. For example, the first sub-pixel SP1 may be positioned adjacent to the second sub-pixel SP2 in the second direction DR2, and the second sub-pixel SP2 may be positioned adjacent to the third sub-pixel SP3 in the second direction DR2. However, embodiments are not limited thereto. For example, the first sub-pixel SP1 may be positioned adjacent to the third sub-pixel SP3 in the second direction DR2, and the third sub-pixel SP3 and the second sub-pixel SP2 may be positioned adjacent to each other in the second direction DR2.

Referring to FIG. 4, an emission area of each of the first to third sub-pixels SP1 to SP3 is shown.

The emission area of the first sub-pixel SP1 may be a first emission area EMA1. The emission area of the second sub-pixel SP2 may be a second emission area EMA2. The emission area of the third sub-pixel SP3 may be a third emission area EMA3.

The first to third emission areas EMA1 to EMA3 may be positioned adjacent to each other in the second direction DR2. For example, the first emission area EMA1 may be positioned adjacent to the second emission area EMA2 in the second direction DR2. The second emission area EMA2 may be positioned adjacent to the third emission area EMA3 in the second direction DR2.

The pixel circuit PXC (see FIG. 5) of each of the first to third sub-pixels SP1 to SP3 may be positioned in the pixel circuit area PXCA. The pixel circuit area PXCA may be an opaque area NTPA.

The sub-pixel area SPA may include the light transmission area TPA and the opaque area NTPA.

The light transmission area TPA may be positioned around the pixel circuit area PXCA. For example, referring to FIG. 4, the light transmission area TPA may surround a periphery of the pixel circuit area PXCA, and may have an opening that is open in the second direction DR2 of the pixel circuit area PXCA.

The light transmission area TPA may overlap at least a portion of the emission areas. For example, the light transmission area TPA may include at least a portion of a remaining area excluding the pixel circuit area PXCA in the first emission area EMA1. The light transmission area TPA may include the second emission area EMA2 and the third emission area EMA3. However, embodiments are not limited thereto. For example, in an embodiment in which the pixel circuit area PXCA is positioned to overlap the second emission area EMA2, the light transmission area TPA may entirely include the first emission area EMA1.

Referring to FIG. 5, predetermined lines may be positioned in an area shown as the light transmission area TPA of FIG. 4. For example, in the light transmission area TPA, the j-th data line DLj, a (j+1)-th data line DL(j+1), a (j+2)-th data line DL(j+2), the reference voltage line RVLk, the first power line PL1, and the like may be positioned. The above-described lines may be included in a first source drain electrode layer SD1.

The j-th data line DLj may be connected to the first sub-pixel SP1. The (j+1)-th data line DL(j+1) may be connected to the second sub-pixel SP2. The (j+2)-th data line DL(j+2) may be connected to the third sub-pixel SP3.

The first power line PL1 may be commonly connected to the first to third sub-pixels SP1 to SP3. The first power line PL1 may be connected to a gate electrode layer GAT in a first contact hole CNT1, and may be commonly connected to the first to third sub-pixels SP1 to SP3 through the gate electrode layer GAT.

The reference voltage line RVLk may be commonly connected to the first to third sub-pixels SP1 to SP3. The reference voltage line RVLk may be connected to the gate electrode layer GAT in a second contact hole CNT2, and may be commonly connected to the first to third sub-pixels SP1 to SP3 through the gate electrode layer GAT.

The first and second scan lines SL1i and SL2i may be included in the gate electrode layer GAT. The first and second scan lines SL1i and SL2i may entirely extend in the first direction DR1 and may overlap the pixel circuit PXC of the first to third sub-pixels SP1 to SP3 on the plane.

Referring to FIG. 5, the pixel circuit PXC of the first to third sub-pixels SP1 to SP3 may be positioned adjacent to each other in the first direction DR1 in the pixel circuit area PXCA. For example, the pixel circuit PXC of the first sub-pixel SP1 and the pixel circuit PXC of the second sub-pixel SP2 may be positioned adjacent to each other in the first direction DR1. For example, the pixel circuit PXC of the second sub-pixel SP2 and the pixel circuit PXC of the third sub-pixel SP3 may be positioned adjacent to each other in the first direction DR1.

The pixel circuit PXC of the first sub-pixel SP1 may be connected to a first anode electrode AE1 of the light emitting element included in the first sub-pixel SP1. The pixel circuit PXC of the first sub-pixel SP1 and the first anode electrode AE1 may be connected to each other through a light transmission line TCO.

The pixel circuit PXC of the second sub-pixel SP2 may be connected to a second anode electrode AE2 of the light emitting element included in the second sub-pixel SP2. The pixel circuit PXC of the second sub-pixel SP2 and the second anode electrode AE2 may be connected to each other through a light transmission line TCO. The second anode electrode AE2 may be positioned adjacent to the first anode electrode AE1 in the second direction DR2.

The pixel circuit PXC of the third sub-pixel SP3 may be connected to a third anode electrode AE3 of the light emitting element included in the third sub-pixel SP3. The pixel circuit PXC of the third sub-pixel SP3 and the third anode electrode AE3 may be connected to each other through a light transmission line TCO. The third anode electrode AE3 may be positioned adjacent to the second anode electrode AE2 in the second direction DR2.

The light transmission line TCO may include a metal having a light transmission property. For example, the light transmission line TCO may include indium tin oxide (ITO).

The first to third anode electrodes AE1 to AE3 may be formed as an anode electrode layer AND. The anode electrode layer AND may be connected to the light transmission line TCO. The anode electrode layer AND may include indium tin oxide (ITO). An area where each of the first to third anode electrodes AE1 to AE3 is positioned may correspond to the first to third emission areas EMA1 to EMA3 of FIG. 4.

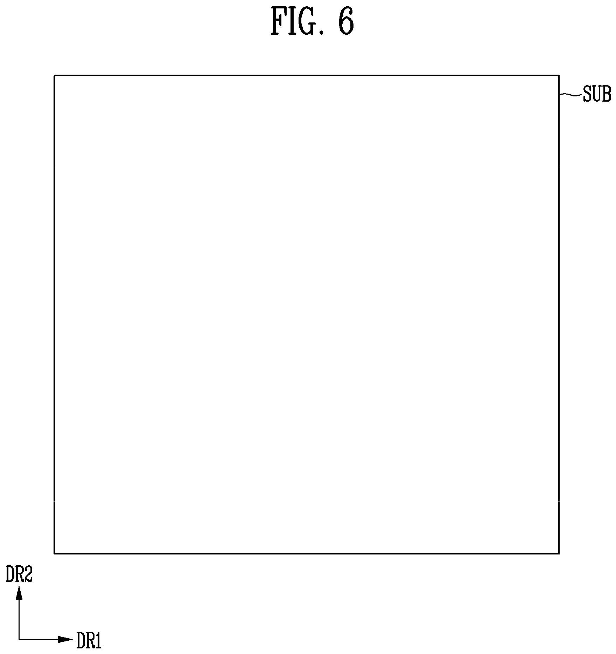

FIGS. 6 to 13 are drawings illustrating a method of manufacturing a display device 100 (refer to FIG. 1).

The display device shown through FIGS. 6 to 13 may include a transistor of a bottom-gate structure and/or a transistor of a top-gate structure. For example, the second and third transistors TR2 and TR3 may be implemented as transistors of a bottom-gate structure, and the first transistor TR1 may be implemented as a transistor of a top-gate structure. However, they are not limited thereto. For example, at least one of the second transistor TR2 and the third transistor TR3 may be implemented as a transistor of a top-gate structure, or the first transistor TR1 may be implemented as a transistor of a bottom-gate structure.

Hereafter, the disclosure is described with reference to FIG. 6.

A substrate SUB may be formed of an insulating material such as glass or resin.

In addition, the substrate SUB may be formed of a material having flexibility so that the substrate SUB may be bent or folded, and may have a single-layer structure or a multi-layer structure. The substrate SUB may include at least one base layer and at least one barrier layer that are sequentially stacked. The base layer may include polyimide (PI), polyethersulfone (PES), polyarylate, polyetherimide (PEI), polyethylene naphthalate (PEN), polyethylene terephthalate (PET), polyphenylene sulfide (PPS), polycarbonate (PC), cellulose triacetate (CTA), cellulose acetate propionate (CAP), and/or the like. The barrier layer may include an inorganic insulating material such as silicon oxide, silicon oxynitride, and/or silicon nitride.

A buffer layer may be disposed on the substrate SUB. The buffer layer may prevent an impurity from being diffused into a circuit element (for example, a transistor). The buffer layer may be omitted according to a material and a process condition of the base layer. The buffer layer may include an inorganic insulating material such as silicon oxide, silicon oxynitride, or silicon nitride. The buffer layer may be formed as a single-layer structure or a multi-layer structure including the above-described material.

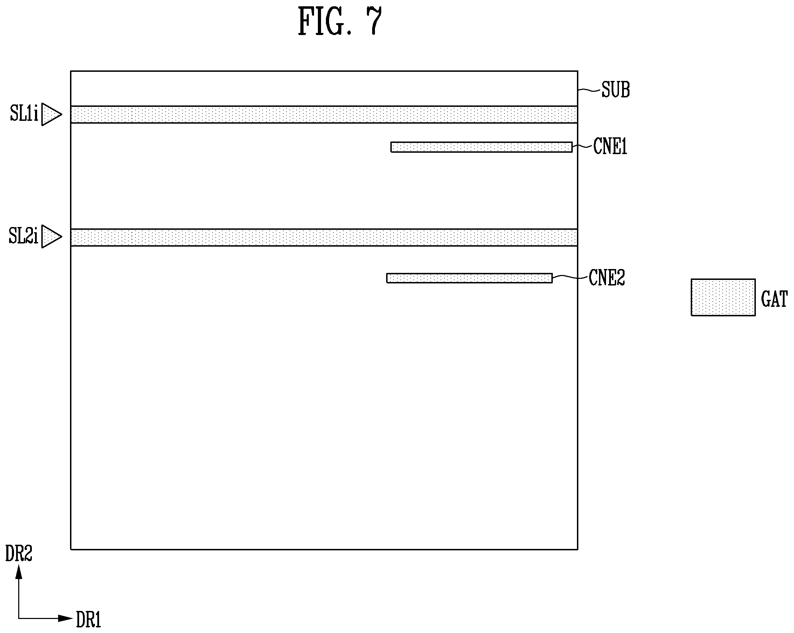

Hereinafter, the disclosure is described with reference to FIG. 7.

The gate electrode layer GAT may be formed on the substrate SUB (or on the buffer layer). The gate electrode layer GAT may include a metal. For example, the gate electrode layer GAT may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the gate electrode layer GAT may be formed as a single layer or may be formed as a multi-layer in which two or more materials among metals and alloys are stacked.

A gate insulating layer may be positioned on the gate electrode layer GAT. The gate insulating layer may include an inorganic insulating layer including an inorganic material. As the inorganic material, polysiloxane, silicon nitride, silicon oxide, silicon oxynitride, or the like may be used.

The gate electrode layer GAT may configure the first scan line SL1i, the second scan line SL2i, a first connection electrode CNE1, and a second connection electrode CNE2. The first scan line SL1i, the second scan line SL2i, the first connection electrode CNE1, and the second connection electrode CNE2 may entirely extend in the first direction DR1.

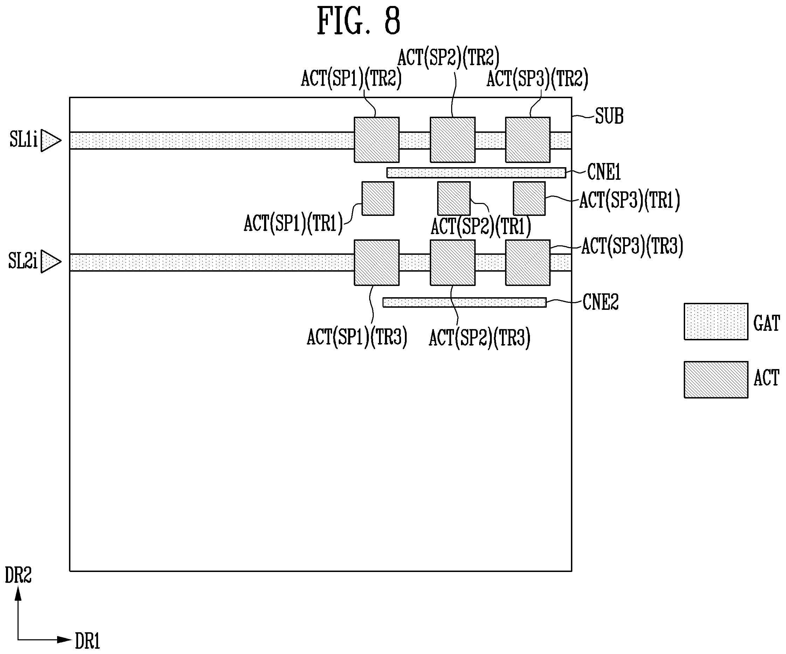

Hereinafter, the disclosure is described with reference to FIG. 8.

A semiconductor layer ACT may be positioned on the gate electrode layer GAT (or on the gate insulating layer). The semiconductor layer ACT may include an oxide semiconductor. For example, the semiconductor layer ACT may be formed through a metal oxide semiconductor forming process. However, it is not limited thereto. For example, the semiconductor layer ACT may be formed of a silicon semiconductor. For example, the semiconductor layer ACT may include a semiconductor of amorphous silicon (a-Si). The semiconductor layer ACT may include a semiconductor of polycrystalline silicon (poly-Si).

The semiconductor layer ACT configuring the semiconductor layer of the second transistor TR2 may be positioned to overlap the first scan line SL1i on the plane. The semiconductor layer ACT configuring the semiconductor layer of the third transistor TR3 may be positioned to overlap the second scan line SL2i on the plane. The semiconductor layer ACT configuring the semiconductor layer of the first transistor TR1 may be positioned between the first scan line SL1i and the second scan line SL2i. The first connection electrode CNE1 may be positioned between the semiconductor layer of the first transistor TR1 and the semiconductor layer of the second transistor TR2. The second connection electrode CNE2 may be positioned adjacent to the semiconductor layer of the third transistor TR3 in the second direction DR2.

An interlayer insulating layer may be provided on the semiconductor layer ACT. The interlayer insulating layer may include an inorganic insulating layer including an inorganic material. As the inorganic material, polysiloxane, silicon nitride, silicon oxide, silicon oxynitride, and the like may be used.

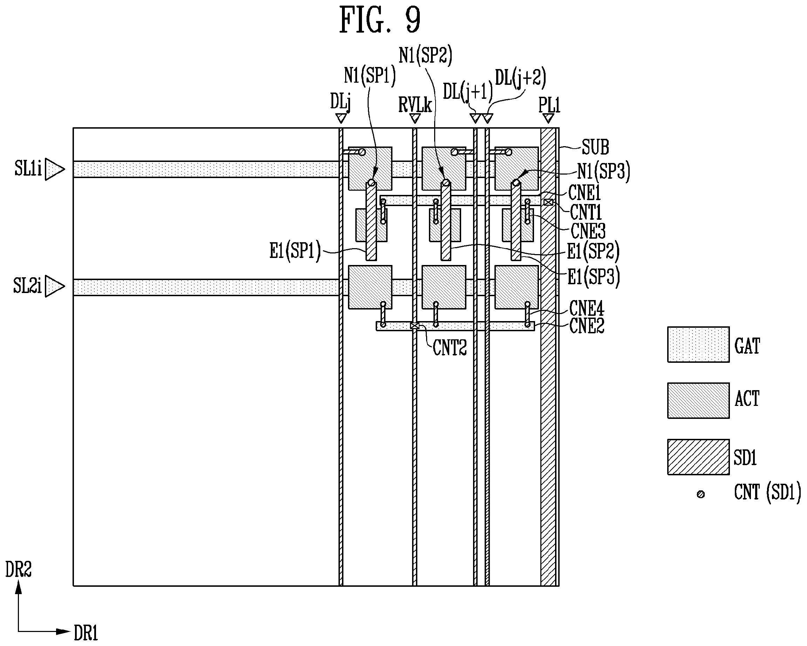

Hereinafter, the disclosure is described with reference to FIG. 9.

A first source drain electrode layer SD1 may be positioned on the semiconductor layer ACT (or on the interlayer insulating layer). The first source drain electrode layer SD1 may include a metal. The first source drain electrode layer SD1 may include a material having excellent conductivity. For example, the first source drain electrode layer SD1 may include a conductive material including molybdenum (Mo), aluminum (Al), copper (Cu), titanium (Ti), and the like. The first source drain electrode layer SD1 may be formed as a multi-layer structure or a single layer structure including the above-described material. For example, the first source drain electrode layer SD1 may have a multi-layer structure of Ti/Al/Ti.

The first source drain electrode layer SD1 may configure the j-th data line DLj, the (j+1)-th data line DL(j+1), the (j+2)-th data line DL(j+2), the reference voltage line RVLk, and the first power line PL1. The first source drain electrode layer SD1 may configure a third connection electrode CNE3 and a fourth connection electrode CNE4. The first source drain electrode layer SD1 may configure the first electrode E1.

The first source drain electrode layer SD1 configuring the first power line PL1 may be connected to the first connection electrode CNE1 in the first contact hole CNT1. The third connection electrode CNE3 may be connected to the first connection electrode CNE1. The third connection electrode CNE3 may be connected to the semiconductor layer ACT of the first transistor TR1.

The first source drain electrode layer SD1 configuring the j-th data line DLj may be connected to the semiconductor layer of the second transistor TR2 of the first sub-pixel SP1. The first source drain electrode layer SD1 configuring the (j+1)-th data line DL(j+1) may be connected to the semiconductor layer of the second transistor TR2 of the second sub-pixel SP2. The first source drain electrode layer SD1 configuring the (j+2)-th data line DL(j+2) may be connected to the semiconductor layer of the second transistor TR2 of the third sub-pixel SP3.

The (j+1)-th data line DL(j+1) and the (j+2)-th data line DL(j+2) may be positioned adjacent to each other in the first direction DR1. However, they are not limited thereto.

The reference voltage line RVLk may be positioned adjacent to each of the semiconductor layer of the first sub-pixel SP1 and the semiconductor layer of the second sub-pixel SP2 in the first direction DR1 on the plane. However, embodiments are not limited thereto.

The first source drain electrode layer SD1 configuring the reference voltage line RVLk may be connected to the second connection electrode CNE2 in the second contact hole CNT2. The fourth connection electrode CNE4 may be connected to the second connection electrode CNE2 and the semiconductor layer of the third transistor TR3.

The first power line PL1 may be positioned adjacent to the semiconductor layer of the third sub-pixel SP3 in the first direction DR1 on the plane. However, embodiments are not limited thereto.

The first source drain electrode layer SD1 configuring the first electrode E1 may be connected to the semiconductor layer of the second transistor TR2 and may extend in one direction (for example, the second direction DR2). The first electrode E1 may overlap at least a portion of the semiconductor layer of the first transistor TR1. An area overlapping the first electrode E1 in the semiconductor layer of the first transistor TR1 may configure a channel area of the first transistor TR1. The first electrode E1 may configure one side electrode of the storage capacitor Cstg (refer to FIG. 2) and may configure a gate electrode of the first transistor TR1. The first electrode E1 may correspond to the first node N1.

A first insulating layer may be provided on the first source drain electrode layer SD1. For example, the first insulating layer may be an organic insulating layer including an organic material. The first insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The first insulating layer may perform a function of planarizing an area on the first source drain electrode layer SD1.

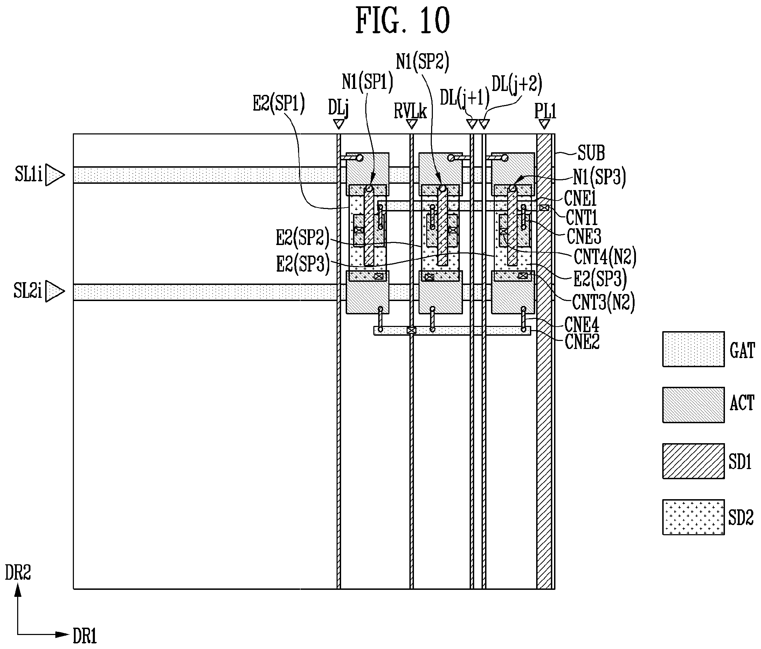

Hereinafter, the disclosure is described with reference to FIG. 10.

A second source drain electrode layer SD2 may be positioned on the first source drain electrode layer SD1 (or on the first insulating layer). The second source drain electrode layer SD2 may include a metal. The second source drain electrode layer SD2 may include a material having excellent conductivity. For example, the second source drain electrode layer SD2 may include a conductive material including molybdenum (Mo), aluminum (Al), copper (Cu), titanium (Ti), and the like. The second source drain electrode layer SD2 may be formed as a multi-layer structure or a single layer structure including the above-described material. For example, the second source drain electrode layer SD2 may have a multi-layer structure of Ti/Al/Ti.

The second source drain electrode layer SD2 may configure the second electrode E2.

The second source drain electrode layer SD2 configuring the second electrode E2 may be connected to the semiconductor layer of the third transistor TR3 through a third contact hole CNT3. The second source drain electrode layer SD2 may be directly connected to the semiconductor layer of the third transistor TR3. The second source drain electrode layer SD2 may be electrically connected to the semiconductor layer of the third transistor TR3 through the first source drain electrode layer SD1.

The second source drain electrode layer SD2 configuring the second electrode E2 may be connected to the semiconductor layer ACT of the first transistor TR1 through a fourth contact hole CNT4. The second source drain electrode layer SD2 may be directly connected to the semiconductor layer of the first transistor TR1. The second source drain electrode layer SD2 may be electrically connected to the semiconductor layer of the first transistor TR1 through the first source drain electrode layer SD1. The second electrode E2 may correspond to the second node N2.

A second insulating layer may be provided on the second source drain electrode layer SD2. For example, the second insulating layer may be an organic insulating layer including an organic material. The second insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The second insulating layer may perform a function of planarizing an area on the second source drain electrode layer SD2.

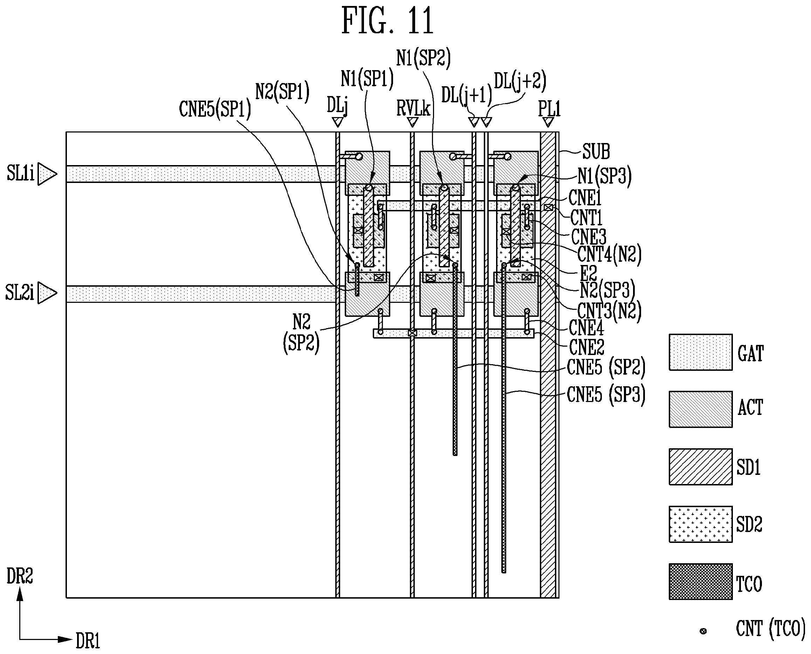

Hereinafter, the disclosure is described with reference to FIG. 11.

The light transmission line TCO may be positioned on the second source drain electrode layer SD2 (or on the second insulating layer). The light transmission line TCO may include at least one of transparent conductive materials such as indium tin oxide (ITO), indium zinc oxide (IZO), zinc oxide (ZnO), indium gallium zinc oxide (IGZO), and indium tin zinc oxide (ITZO). However, a material of the light transmission line TCO is not limited thereto. For example, the light transmission line TCO may include titanium nitride.

The light transmission line TCO may configure a fifth connection electrode CNE5.

The light transmission line TCO configuring the fifth connection electrode CNE5 may be connected to the second electrode E2 through a contact hole CNT.

Widths (for example, widths of the first direction DR1) of the fifth connection electrode CNE5 connected to the second electrode E2 of the first sub-pixel SP1, the fifth connection electrode CNE5 connected to the second electrode E2 of the second sub-pixel SP2, and the fifth connection electrode CNE5 connected to the second electrode E2 of the third sub-pixel SP3 may be substantially the same. However, they are not limited thereto.

The width of the fifth connection electrode CNE5 may be increased in proportion to a length of the fifth connection electrode CNE5. Accordingly, a resistor-capacitor delay (RC delay) may be reduced. For example, referring to FIG. 11, the width of the fifth connection electrode CNE5 connected to the second electrode E2 of the first sub-pixel SP1 may be the smallest, the width of the fifth connection electrode CNE5 connected to the second electrode E2 of the second sub-pixel SP2 may be longer than this, and the width of the fifth connection electrode CNE5 connected to the second electrode E2 of the third sub-pixel SP3 may be the longest.

A third insulating layer may be provided on the light transmission line TCO. For example, the third insulating layer may be an organic insulating layer including an organic material. The third insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof.

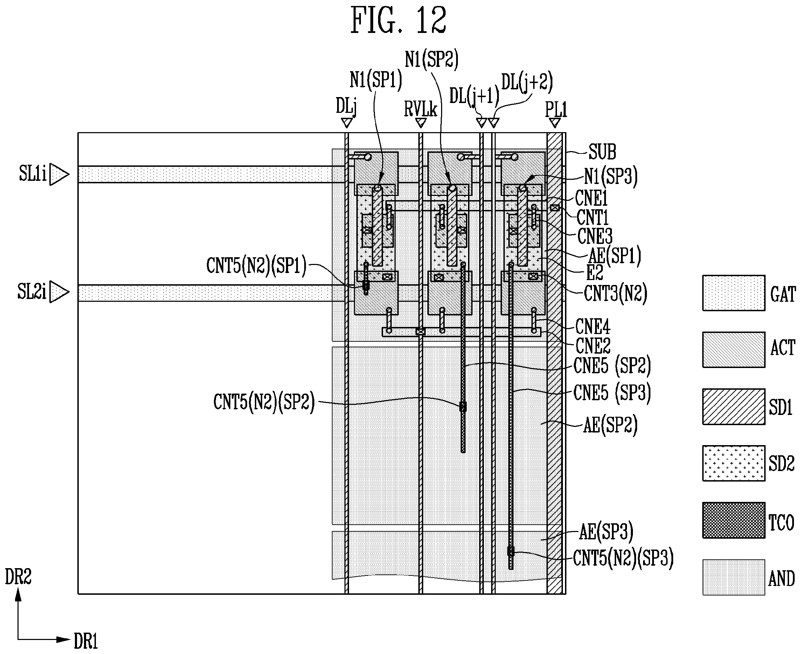

Hereinafter, the disclosure is described with reference to FIG. 12.

The anode electrode layer AND may be positioned on the light transmission line TCO (or on the third insulating layer). The anode electrode layer AND may include at least one of transparent conductive materials such as indium tin oxide (ITO), indium zinc oxide (IZO), zinc oxide (ZnO), indium gallium zinc oxide (IGZO), and indium tin zinc oxide (ITZO). However, a material of the anode electrode layer AND is not limited thereto. For example, the anode electrode layer AND may include titanium nitride.

The anode electrode layer AND may configure an anode electrode AE.

The anode electrode AE may be connected to the light transmission line TCO through a fifth contact hole CNT5. The light transmission line TCO connected to the anode electrode AE through the fifth contact hole CNT5 may configure the second node N2.

The anode electrode AE of the first sub-pixel SP1 may be positioned to overlap the first scan line SL1i and the second scan line SL2i on the plane. The anode electrode AE of the second sub-pixel SP2 may be positioned adjacent to the anode electrode AE of the first sub-pixel SP1 in the second direction DR2. The anode electrode AE of the third sub-pixel SP3 may be positioned adjacent to the anode electrode AE of the second sub-pixel SP2 in the second direction DR2. However, embodiments are not limited thereto.

Shapes or sizes of the anode electrodes AE of each of the first to third sub-pixels SP1 to SP3 may be substantially the same. For example, lengths of the second direction DR2 and/or widths of the first direction DR1 of the anode electrode AE of each of the first to third sub-pixels SP1 to SP3 may be equal to each other. However, they are not limited thereto. For example, the shapes or the sizes of the anode electrodes AE of each of the first to third sub-pixels SP1 to SP3 may be different from each other.

An emission layer EML (refer to FIG. 2), a bank layer, the cathode electrode CE (refer to FIG. 2), and the like may be positioned on the anode electrode AE.

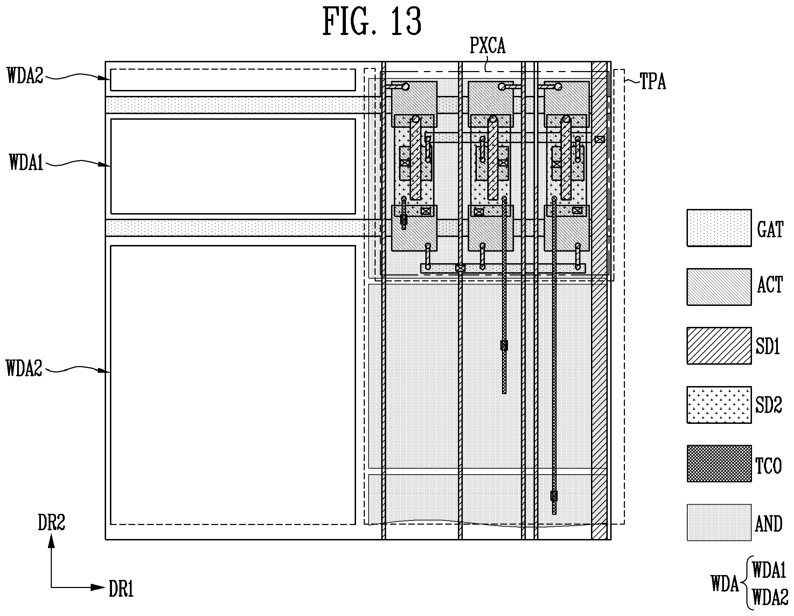

Hereinafter, the disclosure is described with reference to FIG. 13.

The window area WDA may transmit light through the substrate SUB. The window area WDA may include the first window area WDA1 and the second window area WDA2. A semiconductor layer ACT and a metal layer may not be positioned in the window area WDA. For example, the gate electrode layer GAT, the semiconductor layer ACT, the first source drain electrode layer SD1, the second source drain electrode layer SD2, the light transmission line TCO, and the anode electrode layer AND may not be positioned in the window area WDA.

The first window area WDA1 may be positioned adjacent to the pixel circuit area PXCA in the first direction DR1. At least a portion of the second window area WDA2 may be positioned adjacent to the pixel circuit area PXCA in the first direction DR1. A remaining portion of the second window area WDA2 may be positioned adjacent to the light transmission area TPA in the first direction DR1.

The first window area WDA1 and the second window area WDA2 may be positioned spaced apart from each other in the second direction DR2. The gate electrode layer GAT may be positioned between the first window area WDA1 and the second window area WDA2.

A semiconductor layer ACT and a metal layer may be positioned in the pixel circuit area PXCA. For example, the gate electrode layer GAT, the semiconductor layer ACT, the first source drain electrode layer SD1, the second source drain electrode layer SD2, the light transmission line TCO, and the anode electrode layer AND may be positioned in the pixel circuit area PXCA.

The pixel circuit area PXCA may be positioned to completely overlap the anode electrode AE of the first sub-pixel SP1 on the plane. However, it is not limited thereto. For example, at least a portion of the pixel circuit area PXCA may be positioned between the anode electrode AE of the first sub-pixel SP1 and the anode electrode AE of the second sub-pixel SP2.

The first source drain electrode layer SD1, the light transmission line TCO, and the anode electrode layer AND may be positioned in the light transmission area TPA. Light may pass through the substrate SUB through the light transmission area TPA, but light transmittance of the light transmission area TPA may be lower than light transmittance of the window area WDA and may be higher than light transmittance of the pixel circuit area PXCA.

The cathode electrode CE (refer to FIG. 2) may be formed to avoid the window area WDA, by using a mask (for example, a metal mask, a silicon mask, or the like). Accordingly, a transmittance of the window area WDA may be improved.

Accordingly, light transmittance of the display device 100 (refer to FIG. 1) may be entirely increased.

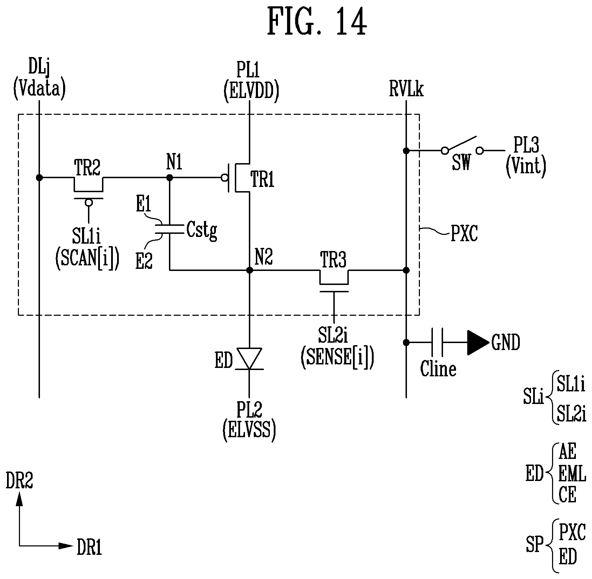

FIG. 14 is an equivalent circuit diagram of a sub-pixel SP.

Referring to FIG. 14, the sub-pixel SP may include the pixel circuit PXC and the light emitting element ED.

Compared to the embodiment shown in FIG. 2, the pixel circuit PXC may include both of the N-type transistor and the P-type transistor.

For example, each of the first transistor TR1 and the second transistor TR2 may be configured as the P-type transistor. The third transistor TR3 may be configured as the N-type transistor. However, they are not limited thereto. For example, at least one of the first and second transistors TR1 and TR2 may be configured as the N-type transistor. The third transistor TR3 may be configured as the P-type transistor.

Referring to FIG. 14, the first transistor TR1 may display a high-grayscale image in response to a low level data voltage Vdata, and may display a low-grayscale image in response to a high level data voltage Vdata.

The second transistor TR2 may be turned on in response to a first scan signal SCAN[i] of a low level, and may be turned off in response to a first scan signal SCAN[i] of a high level.

The first and second transistors TR1 and TR2 may include a semiconductor layer configured of a low temperature polycrystalline silicon (LTPS) semiconductor. The third transistor TR3 may include a semiconductor layer configured of a metal oxide semiconductor. However, they are not limited thereto.

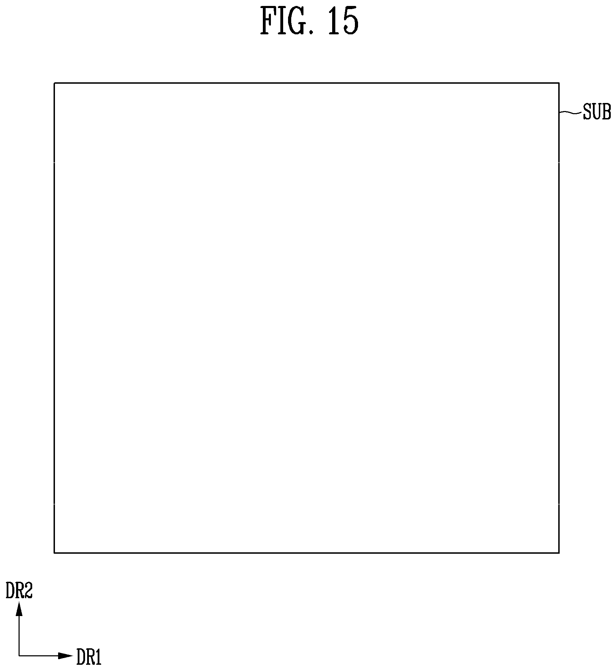

FIGS. 15 to 25 are drawings illustrating a method of manufacturing a display device 100 (refer to FIG. 1).

The display device shown through FIGS. 15 to 25 may include a transistor of a top-gate structure. However, it is not limited thereto, and the display device 100 (refer to FIG. 1) may include a transistor of a bottom-gate structure.

Hereinafter, the disclosure is described with reference to FIG. 15.

A substrate SUB may be formed of an insulating material such as glass or resin. In addition, the substrate SUB may be formed of a material having flexibility so that the substrate SUB may be bent or folded, and may have a single-layer structure or a multi-layer structure. The substrate SUB may include at least one base layer and at least one barrier layer that are sequentially stacked. The base layer may include polyimide (PI), polyethersulfone (PES), polyarylate, polyetherimide (PEI), polyethylene naphthalate (PEN), polyethylene terephthalate (PET), polyphenylene sulfide (PPS), polycarbonate (PC), cellulose triacetate (CTA), cellulose acetate propionate (CAP), and/or the like. The barrier layer may include an inorganic insulating material such as silicon oxide, silicon oxynitride, and/or silicon nitride.

A buffer layer may be disposed on the substrate SUB. The buffer layer may prevent an impurity from being diffused into a circuit element (for example, a transistor). The buffer layer may be omitted according to a material and a process condition of the base layer. The buffer layer may include an inorganic insulating material such as silicon oxide, silicon oxynitride, or silicon nitride. The buffer layer may be formed as a single-layer structure or a multi-layer structure including the above-described material.

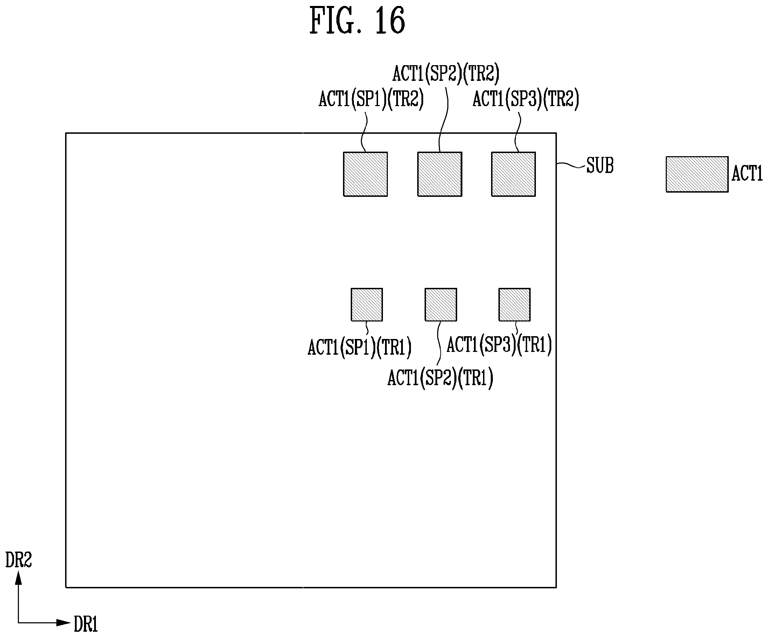

Hereinafter, the disclosure is described with reference to FIG. 16.

A first semiconductor layer ACT1 may be positioned on the substrate SUB (or on the buffer layer). The first semiconductor layer ACT1 may be formed of a silicon semiconductor. For example, the first semiconductor layer ACT1 may include a low temperature polycrystalline silicon semiconductor. However, it is not limited thereto. For example, the first semiconductor layer ACT1 may include a metal oxide semiconductor.

The first semiconductor layer ACT1 may configure a semiconductor layer of the first transistor TR1 and the second transistor TR2. The semiconductor layer of the first transistor TR1 and the semiconductor layer of the second transistor TR2 may be positioned adjacent to each other in the second direction DR2. The first sub-pixel SP1, the second sub-pixel SP2, and the third sub-pixel SP3 may be positioned adjacent in the first direction DR1.

A first gate insulating layer may be provided on the first semiconductor layer ACT1. The first gate insulating layer may include an inorganic insulating layer including an inorganic material. As the inorganic material, polysiloxane, silicon nitride, silicon oxide, silicon oxynitride, and the like may be used.

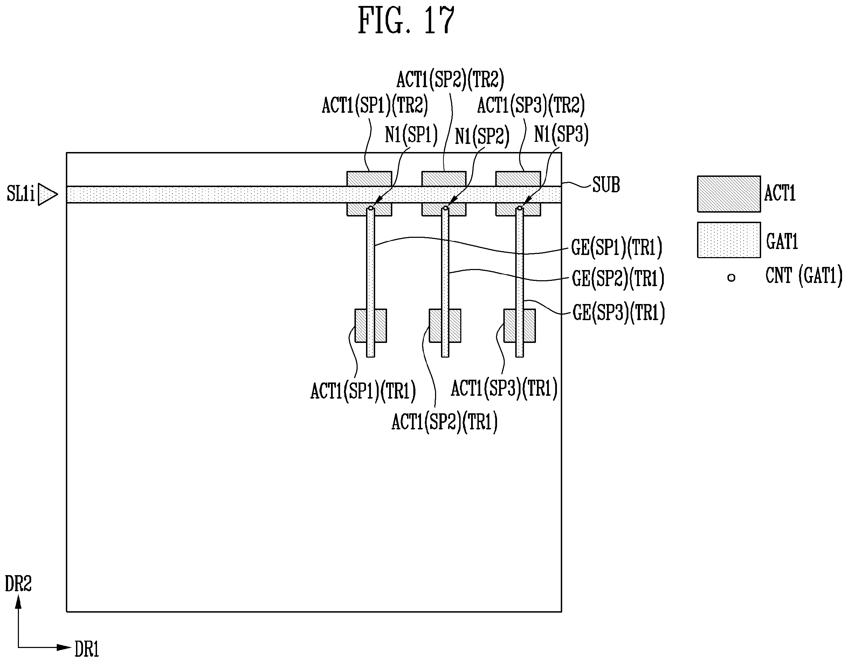

Hereinafter, the description will be made with reference to FIG. 17.

A first gate electrode layer GAT1 may be positioned on the first semiconductor layer ACT1 (or on the first gate insulating layer). The first gate electrode layer GAT1 may include a metal. For example, the first gate electrode layer GAT1 may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the first gate electrode layer GAT1 may be formed as a single layer or may be formed as a multi-layer in which two or more materials among metals and alloys are stacked.

The first gate electrode layer GAT1 may configure the first scan line SL1i and a gate electrode GE of the first transistor TR1. The first scan line SL1i may entirely extend in the first direction DR1. The gate electrode GE of the first transistor TR1 may entirely extend in the second direction DR2.

The first scan line SL1i may be positioned to overlap the semiconductor layer of the second transistor TR2. An area overlapping the first scan line SL1i in the semiconductor layer of the second transistor TR2 may be defined as a channel area. For example, the semiconductor layer of the second transistor TR2 may include a source area and a drain area positioned spaced apart from each other in the second direction DR2 with the channel area interposed therebetween.

The gate electrode GE of the first transistor TR1 may be connected to the semiconductor layer of the second transistor TR2 through the contact hole CNT. The gate electrode GE may be positioned to overlap the semiconductor layer of the first transistor TR1. An area overlapping the gate electrode GE in the semiconductor layer of the first transistor TR1 may be defined as a channel area. For example, the semiconductor layer of the first transistor TR1 may include a source area and a drain area positioned spaced apart from each other in the first direction DR1 with the channel area interposed therebetween. The gate electrode GE of the first transistor TR1 may configure the first node N1. The gate electrode GE of the first transistor TR1 may configure the first electrode E1 of the storage capacitor Cstg (refer to FIG. 14) described above.

A first interlayer insulating layer may be positioned on the first gate electrode layer GAT1. The first interlayer insulating layer may include an inorganic insulating layer including an inorganic material. As the inorganic material, polysiloxane, silicon nitride, silicon oxide, silicon oxynitride, and the like may be used.

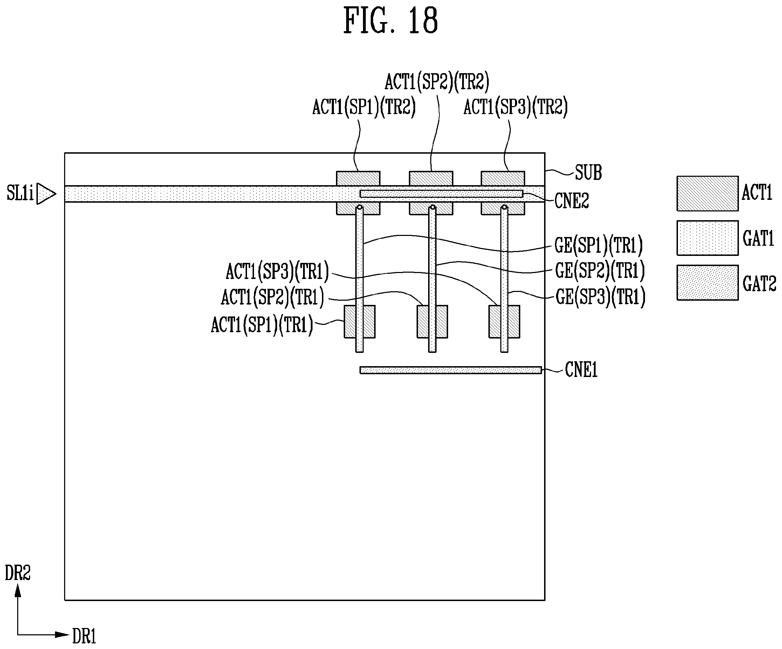

Hereinafter, the disclosure is described with reference to FIG. 18.

A second gate electrode layer GAT2 may be positioned on the first gate electrode layer GAT1 (or on the first interlayer insulating layer). The second gate electrode layer GAT2 may include a metal. For example, the second gate electrode layer GAT2 may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the second gate electrode layer GAT2 may be formed as a single layer or may be formed as a multi-layer in which two or more materials among metals and alloys are stacked.

The second gate electrode layer GAT2 may include the first connection electrode CNE1 and the second connection electrode CNE2. Each of the first connection electrode CNE1 and the second connection electrode CNE2 may entirely extend in the first direction DR1.

The first connection electrode CNE1 may be positioned adjacent to the semiconductor layer and the gate electrode GE of the first transistor TR1 in the second direction DR2. However, embodiments are not limited thereto. For example, the first connection electrode CNE1 may be positioned between the semiconductor layer of the second transistor TR2 and the semiconductor layer of the first transistor TR1 on the plane, and may be positioned to overlap the gate electrode GE of the first transistor TR1.

The second connection electrode CNE2 may be positioned so as to overlap the first scan line SL1i on the plane.

A second interlayer insulating layer may be positioned on the second gate electrode layer GAT2. The second interlayer insulating layer may include an inorganic insulating layer including an inorganic material. As the inorganic material, polysiloxane, silicon nitride, silicon oxide, silicon oxynitride, or the like may be used.

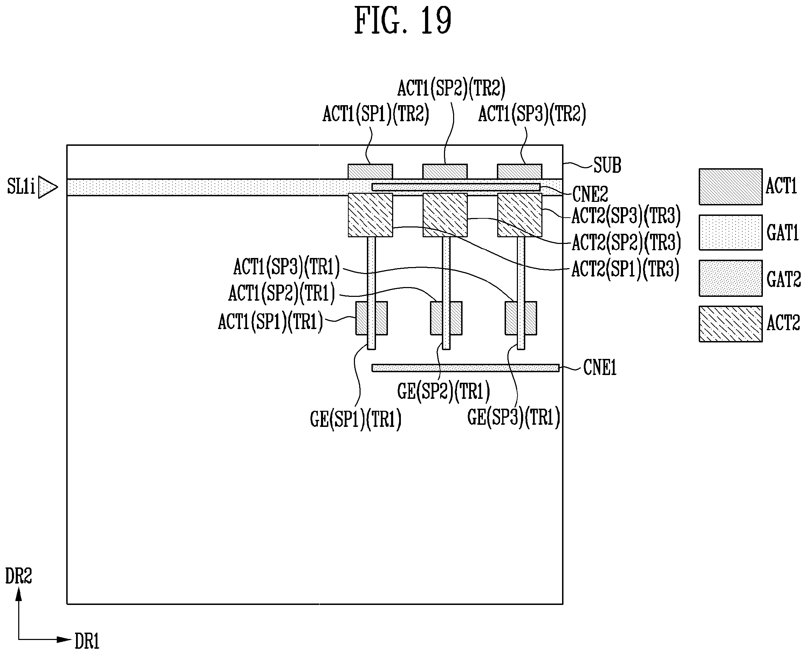

Hereinafter, the disclosure is described with reference to FIG. 19.

A second semiconductor layer ACT2 may be positioned on the second gate electrode layer GAT2 (or on the second interlayer insulating layer). The second semiconductor layer ACT2 may be formed of a metal oxide semiconductor. However, embodiments are not limited thereto. For example, the second semiconductor layer ACT2 may include a silicon semiconductor (for example, a polycrystalline silicon semiconductor).

The second semiconductor layer ACT2 may configure a semiconductor layer of the third transistor TR3.

The semiconductor layer of the third transistor TR3 may be positioned to overlap the gate electrode GE of the first transistor TR1 on the plane. In the above case, a saturation area of the semiconductor layer of the first transistor TR1 and a saturation area of the semiconductor layer of the third transistor TR3 may be configured differently from each other. Accordingly, a risk that the semiconductor layer of the third transistor TR3 malfunction due to a voltage applied to the gate electrode GE of the first transistor TR1 may be controlled.

At least a portion of the semiconductor layer of the third transistor TR3 may overlap the first scan line SL1i on the plane. However, it is not limited thereto.

The semiconductor layer of the third transistor TR3 may be positioned adjacent to the second connection electrode CNE2 in the second direction DR2 on the plane.

A second gate insulating layer may be provided on the second semiconductor layer ACT2. The second gate insulating layer may include an inorganic insulating layer including an inorganic material. As the inorganic material, polysiloxane, silicon nitride, silicon oxide, silicon oxynitride, or the like may be used.

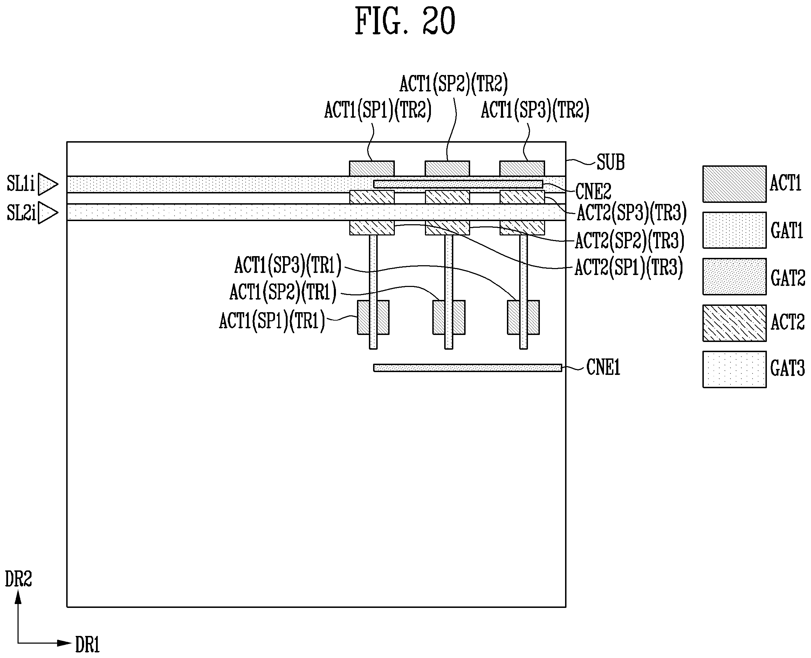

Hereinafter, the disclosure is described with reference to FIG. 20.

A third gate electrode layer GAT3 may be positioned on the second semiconductor layer ACT2 (or on the second gate insulating layer). The third gate electrode layer GAT3 may include a metal. For example, the third gate electrode layer GAT3 may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the third gate electrode layer GAT3 may be formed as a single layer or may be formed as a multi-layer in which two or more materials among metals and alloys are stacked.

The third gate electrode layer GAT3 may configure the second scan line SL2i. The second scan line SL2i may extend in the first direction DR1.

The second scan line SL2i may be positioned to overlap the semiconductor layer of the third transistor TR3. An area overlapping the second scan line SL2i in the semiconductor layer of the third transistor TR3 may be defined as a channel area. For example, the semiconductor layer of the third transistor TR3 may include a source area and a drain area positioned spaced apart from each other in the second direction DR2 with the channel area therebetween.

A third interlayer insulating layer may be positioned on the third gate electrode layer GAT3. The third interlayer insulating layer may include an inorganic insulating layer including an inorganic material. As the inorganic material, polysiloxane, silicon nitride, silicon oxide, silicon oxynitride, or the like may be used.

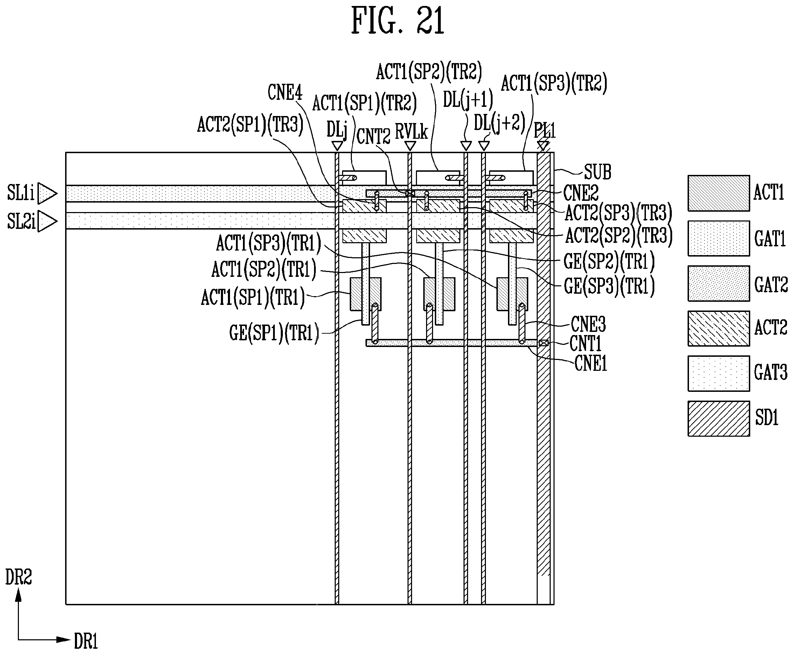

Hereinafter, the disclosure is described with reference to FIG. 21.

A first source drain electrode layer SD1 may be positioned on the third gate electrode layer GAT3 (or on the third interlayer insulating layer). The first source drain electrode layer SD1 may include a metal. The first source drain electrode layer SD1 may include a material having excellent conductivity. For example, the first source drain electrode layer SD1 may include a conductive material including molybdenum (Mo), aluminum (Al), copper (Cu), titanium (Ti), and the like. The first source drain electrode layer SD1 may be formed as a multi-layer structure or a single layer structure including the above-described material. For example, the first source drain electrode layer SD1 may have a multi-layer structure of Ti/Al/Ti.

The first source drain electrode layer SD1 may configure the j-th data line DLj, the (j+1)-th data line DL(j+1), the (j+2)-th data line DL(j+2), the reference voltage line RVLk, and the first power line PL1. The first source drain electrode layer SD1 may configure a third connection electrode CNE3 and a fourth connection electrode CNE4.

The first source drain electrode layer SD1 configuring the first power line PL1 may be connected to the first connection electrode CNE1 in the first contact hole CNT1. The third connection electrode CNE3 may be connected to the first connection electrode CNE1. The third connection electrode CNE3 may be connected to the semiconductor layer of the first transistor TR1.

The first source drain electrode layer SD1 configuring the j-th data line DLj may be connected to the semiconductor layer of the second transistor TR2 of the first sub-pixel SP1. The first source drain electrode layer SD1 configuring the (j+1)-th data line DL(j+1) may be connected to the semiconductor layer of the second transistor TR2 of the second sub-pixel SP2. The first source drain electrode layer SD1 configuring the (j+2)-th data line DL(j+2) may be connected to the semiconductor layer of the second transistor TR2 of the third sub-pixel SP3.

The (j+1)-th data line DL(j+1) and the (j+2)-th data line DL(j+2) may be positioned adjacent to each other in the first direction DR1. However, they are not limited thereto.

The reference voltage line RVLk may be positioned adjacent to each of the semiconductor layer of the first sub-pixel SP1 and the semiconductor layer of the second sub-pixel SP2 in the first direction DR1 on the plane. However, embodiments are not limited thereto.

The first source drain electrode layer SD1 configuring the reference voltage line RVLk may be connected to the second connection electrode CNE2 in the second contact hole CNT2. The fourth connection electrode CNE4 may be connected to the second connection electrode CNE2 and the semiconductor layer of the third transistor TR3.

The first power line PL1 may be positioned adjacent to the semiconductor layer of the third sub-pixel SP3 in the first direction DR1 on the plane. However, embodiments are not limited thereto.

A first insulating layer may be provided on the first source drain electrode layer SD1. For example, the first insulating layer may be an organic insulating layer including an organic material. The first insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The first insulating layer may perform a function of planarizing an area on the first source drain electrode layer SD1.

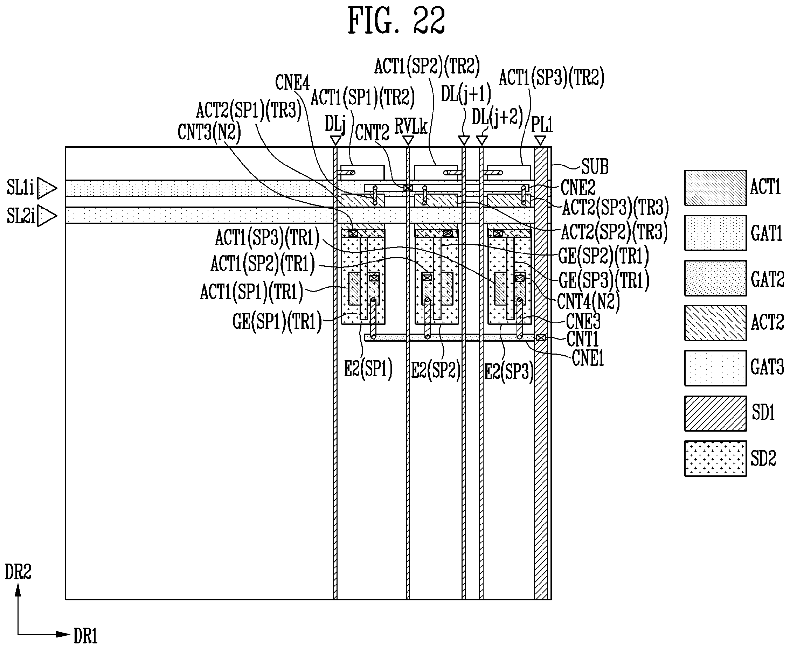

Hereinafter, the disclosure is described with reference to FIG. 22.

A second source drain electrode layer SD2 may be positioned on the first source drain electrode layer SD1 (or on the first insulating layer). The second source drain electrode layer SD2 may include a metal. The second source drain electrode layer SD2 may include a material having excellent conductivity. For example, the second source drain electrode layer SD2 may include a conductive material including molybdenum (Mo), aluminum (Al), copper (Cu), titanium (Ti), and the like. The second source drain electrode layer SD2 may be formed as a multi-layer structure or a single layer structure including the above-described material. For example, the second source drain electrode layer SD2 may have a multi-layer structure of Ti/Al/Ti.

The second source drain electrode layer SD2 may configure the second electrode E2.

The second source drain electrode layer SD2 configuring the second electrode E2 may be connected to the semiconductor layer of the third transistor TR3 through a third contact hole CNT3. The second source drain electrode layer SD2 may be directly connected to the semiconductor layer of the third transistor TR3. The second source drain electrode layer SD2 may be electrically connected to the semiconductor layer of the third transistor TR3 through the first source drain electrode layer SD1.

The second source drain electrode layer SD2 configuring the second electrode E2 may be connected to the semiconductor layer of the first transistor TR1 through a fourth contact hole CNT4. The second source drain electrode layer SD2 may be directly connected to the semiconductor layer of the first transistor TR1. The second source drain electrode layer SD2 may be electrically connected to the semiconductor layer of the first transistor TR1 through the first source drain electrode layer SD1.

A second insulating layer may be provided on the second source drain electrode layer SD2. For example, the second insulating layer may be an organic insulating layer including an organic material. The second insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The second insulating layer may perform a function of planarizing an area on the second source drain electrode layer SD2.

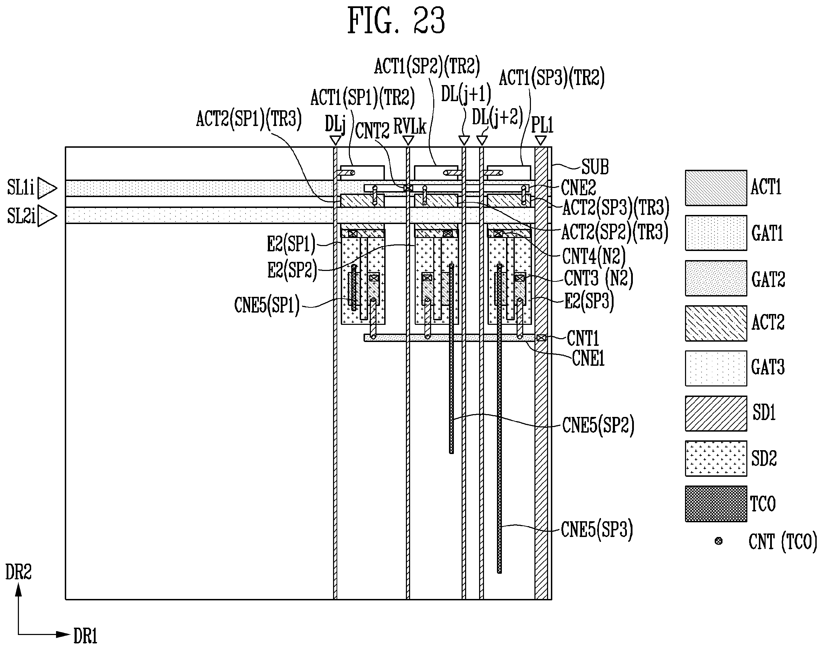

Hereinafter, the disclosure is described with reference to FIG. 23.

The light transmission line TCO may be positioned on the second source drain electrode layer SD2 (or on the second insulating layer). The light transmission line TCO may include at least one of transparent conductive materials such as indium tin oxide (ITO), indium zinc oxide (IZO), zinc oxide (ZnO), indium gallium zinc oxide (IGZO), and indium tin zinc oxide (ITZO). However, a material of the light transmission line TCO is not limited thereto. For example, the light transmission line TCO may include titanium nitride.

The light transmission line TCO may configure a fifth connection electrode CNE5.

The light transmission line TCO configuring the fifth connection electrode CNE5 may be connected to the second electrode E2 through a contact hole CNT.

Widths (for example, widths of the first direction DR1) of the fifth connection electrode CNE5 connected to the second electrode E2 of the first sub-pixel SP1, the fifth connection electrode CNE5 connected to the second electrode E2 of the second sub-pixel SP2, and the fifth connection electrode CNE5 connected to the second electrode E2 of the third sub-pixel SP3 may be substantially the same. However, embodiments are not limited thereto.

The width of the fifth connection electrode CNE5 may be increased in proportion to a length of the fifth connection electrode CNE5. Accordingly, a resistor-capacitor delay (RC delay) may be reduced. For example, referring to FIG. 23, the width of the fifth connection electrode CNE5 connected to the second electrode E2 of the first sub-pixel SP1 may be the smallest, the width of the fifth connection electrode CNE5 connected to the second electrode E2 of the second sub-pixel SP2 may be longer than this, and the width of the fifth connection electrode CNE5 connected to the second electrode E2 of the third sub-pixel SP3 may be the longest.

A third insulating layer may be provided on the light transmission line TCO. For example, the third insulating layer may be an organic insulating layer including an organic material. The third insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof.

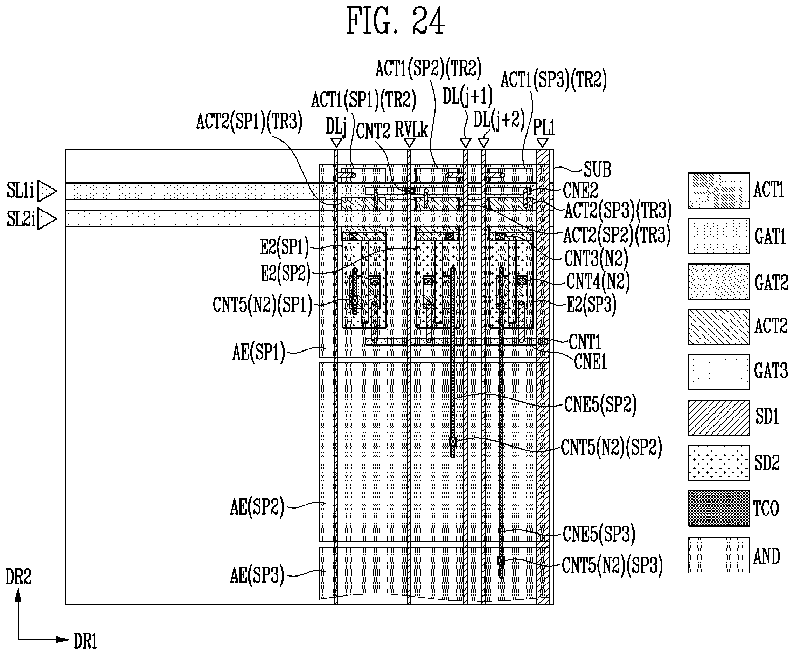

Hereinafter, the disclosure is described with reference to FIG. 24.

The anode electrode layer AND may be positioned on the light transmission line TCO (or on the third insulating layer). The anode electrode layer AND may include at least one of transparent conductive materials such as indium tin oxide (ITO), indium zinc oxide (IZO), zinc oxide (ZnO), indium gallium zinc oxide (IGZO), and indium tin zinc oxide (ITZO). However, a material of the anode electrode layer AND is not limited thereto. For example, the anode electrode layer AND may include titanium nitride.

The anode electrode layer AND may configure an anode electrode AE.

The anode electrode AE may be connected to the light transmission line TCO through a fifth contact hole CNT5. The light transmission line TCO connected to the anode electrode AE through the fifth contact hole CNT5 may configure the second node N2.

The anode electrode AE of the first sub-pixel SP1 may be positioned to overlap the first scan line SL1i and the second scan line SL2i on the plane. The anode electrode AE of the second sub-pixel SP2 may be positioned adjacent to the anode electrode AE of the first sub-pixel SP1 in the second direction DR2. The anode electrode AE of the third sub-pixel SP3 may be positioned adjacent to the anode electrode AE of the second sub-pixel SP2 in the second direction DR2. However, embodiments are not limited thereto.

Shapes or sizes of the anode electrodes AE of each of the first to third sub-pixels SP1 to SP3 may be substantially the same. For example, lengths of the second direction DR2 and/or widths of the first direction DR1 of the anode electrode AE of each of the first to third sub-pixels SP1 to SP3 may be equal to each other. However, embodiments are not limited thereto. For example, the shapes or the sizes of the anode electrodes AE of each of the first to third sub-pixels SP1 to SP3 may be different from each other.

An emission layer EML (refer to FIG. 14), a bank layer, a cathode electrode CE (refer to FIG. 14), and the like may be positioned on the anode electrode AE.

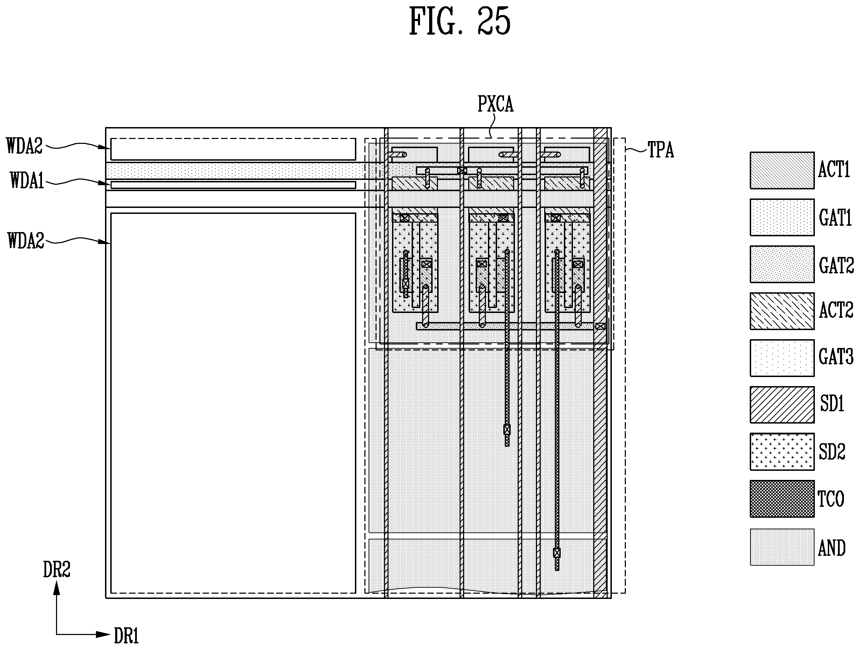

Hereinafter, the disclosure is described with reference to FIG. 25.

The window area WDA may transmit light through the substrate SUB. The window area WDA may include the first window area WDA1 and the second window area WDA2. A semiconductor layer and a metal layer may not be positioned in the window area WDA. For example, the first semiconductor layer ACT1, the first gate electrode layer GAT1, the second gate electrode layer GAT2, the second semiconductor layer ACT2, the third gate electrode layer GAT3, the first source drain electrode layer SD1, the second source drain electrode layer SD2, the light transmission line TCO, and the anode electrode layer AND may not be positioned in the window area WDA.

The first window area WDA1 may be positioned adjacent to the pixel circuit area PXCA in the first direction DR1. At least a portion of the second window area WDA2 may be positioned adjacent to the pixel circuit area PXCA in the first direction DR1. A remaining portion of the second window area WDA2 may be positioned adjacent to the light transmission area TPA in the first direction DR1.

The first window area WDA1 and the second window area WDA2 may be positioned spaced apart from each other in the second direction DR2. The first gate electrode layer GAT1 or the second gate electrode layer GAT2 may be positioned between the first window area WDA1 and the second window area WDA2.

A semiconductor layer and a metal layer may be positioned in the pixel circuit area PXCA. For example, the first semiconductor layer ACT1, the first gate electrode layer GAT1, the second gate electrode layer GAT2, the second semiconductor layer ACT2, the third gate electrode layer GAT3, the first source drain electrode layer SD1, the second source drain electrode layer SD2, the light transmission line TCO, and the anode electrode layer AND may be positioned in the pixel circuit area PXCA.

The pixel circuit area PXCA may be positioned to completely overlap the anode electrode AE of the first sub-pixel SP1 on the plane. However, it is not limited thereto. For example, at least a portion of the pixel circuit area PXCA may be positioned between the anode electrode AE of the first sub-pixel SP1 and the anode electrode AE of the second sub-pixel SP2.

The first source drain electrode layer SD1, the light transmission line TCO, and the anode electrode layer AND may be positioned in the light transmission area TPA. Light may pass through the substrate SUB through the light transmission area TPA, but light transmittance of the light transmission area TPA may be lower than light transmittance of the window area WDA and may be higher than light transmittance of the pixel circuit area PXCA.

Accordingly, light transmittance of the display device 100 (refer to FIG. 1) may be entirely increased.

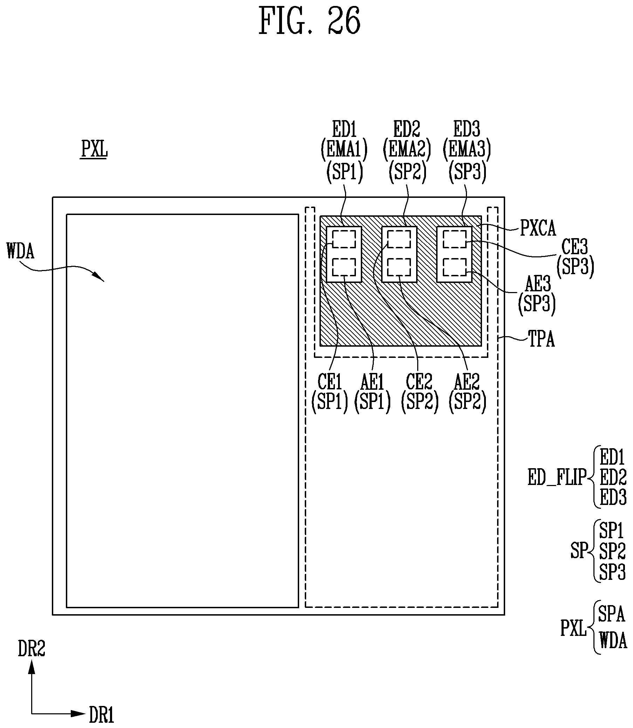

FIG. 26 is a second embodiment of the pixel PXL, in which a flip type light emitting element ED_FLIP is disposed.

Referring to FIG. 26, in the pixel PXL, emission areas of the sub-pixels SP may be positioned adjacent in the first direction DR1. For example, a first emission area EMA1 which is an emission area of the first sub-pixel SP1, a second emission area EMA2 which is an emission area of the second sub-pixel SP2, and a third emission area EMA3 which is an emission area of the third sub-pixel SP3 may be defined, respectively.

The first emission area EMA1 may correspond to a first light emitting element ED1 which is a light emitting element of the first sub-pixel SP1. The second emission area EMA2 may correspond to a second light emitting element ED2 which is a light emitting element of the second sub-pixel SP2. The third emission area EMA3 may correspond to a third light emitting element ED3 which is a light emitting element of the third sub-pixel SP3.

Each of the first to third light emitting elements ED1 to ED3 may be implemented as the flip type light emitting element ED_FLIP. A micro light emitting diode (LED) used in the art may be employed as the flip type light emitting element ED_FLIP.

In the flip type light emitting element ED_FLIP, each of an anode electrode and a cathode electrode may be positioned at a lower surface. For example, the first light emitting element ED1 may include a first anode electrode AE1 and a first cathode electrode CE1, and each of the first anode electrode AE1 and the first cathode electrode CE1 may be positioned at a lower surface of the first light emitting element ED1. The second light emitting element ED2 may include a second anode electrode AE2 and a second cathode electrode CE2, and each of the second anode electrode AE2 and the second cathode electrode CE2 may be positioned at a lower surface of the second light emitting element ED2. The third light emitting element ED3 may include a third anode electrode AE3 and a third cathode electrode CE3, and each of the third anode electrode AE3 and a third cathode electrode CE3 may be positioned at a lower surface of the third light emitting element ED3.

The flip type light emitting element ED_FLIP may include the emission layer EML (refer to FIG. 2). The emission layer EML may be positioned on the anode electrode and the cathode electrode.

Compared to the pixel PXL according to the first embodiment of FIG. 4 described above, in the pixel PXL according to the second embodiment, the emission areas EMA1, EMA2, and EMA3 are not positioned in the light transmission area TPA. Accordingly, light transmittance may be further increased in the light transmission area TPA.

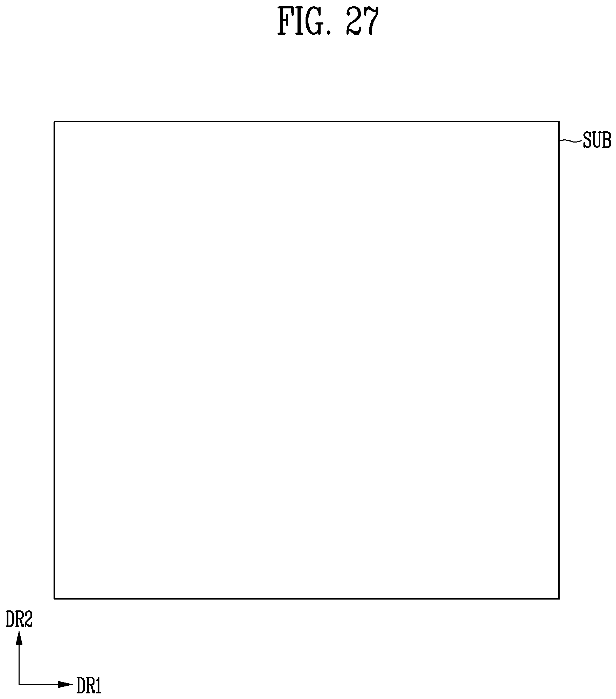

FIGS. 27 to 33 are drawings illustrating a method of manufacturing a display device.

The display device shown through FIGS. 27 to 33 may include a transistor of a bottom-gate structure and/or a transistor of a top-gate structure. For example, the second and third transistors TR2 and TR3 may be implemented as transistors of a bottom-gate structure, and the first transistor TR1 may be implemented as a transistor of a top-gate structure. However, they are not limited thereto. For example, at least one of the second transistor TR2 and the third transistor TR3 may be implemented as a transistor of a top-gate structure, or the first transistor TR1 may be implemented as a transistor of a bottom-gate structure.

Hereafter, the disclosure is described with reference to FIG. 27.

A substrate SUB may be formed of an insulating material such as glass or resin. In addition, the substrate SUB may be formed of a material having flexibility so that the substrate SUB may be bent or folded, and may have a single-layer structure or a multi-layer structure. The substrate SUB may include at least one base layer and at least one barrier layer that are sequentially stacked. The base layer may include polyimide (PI), polyethersulfone (PES), polyarylate, polyetherimide (PEI), polyethylene naphthalate (PEN), polyethylene terephthalate (PET), polyphenylene sulfide (PPS), polycarbonate (PC), cellulose triacetate (CTA), cellulose acetate propionate (CAP), and/or the like. The barrier layer may include an inorganic insulating material such as silicon oxide, silicon oxynitride, and/or silicon nitride.

A buffer layer may be disposed on the substrate SUB. The buffer layer may prevent an impurity from being diffused into a circuit element (for example, a transistor). The buffer layer may be omitted according to a material and a process condition of the base layer. The buffer layer may include an inorganic insulating material such as silicon oxide, silicon oxynitride, or silicon nitride. The buffer layer may be formed as a single-layer structure or a multi-layer structure including the above-described material.

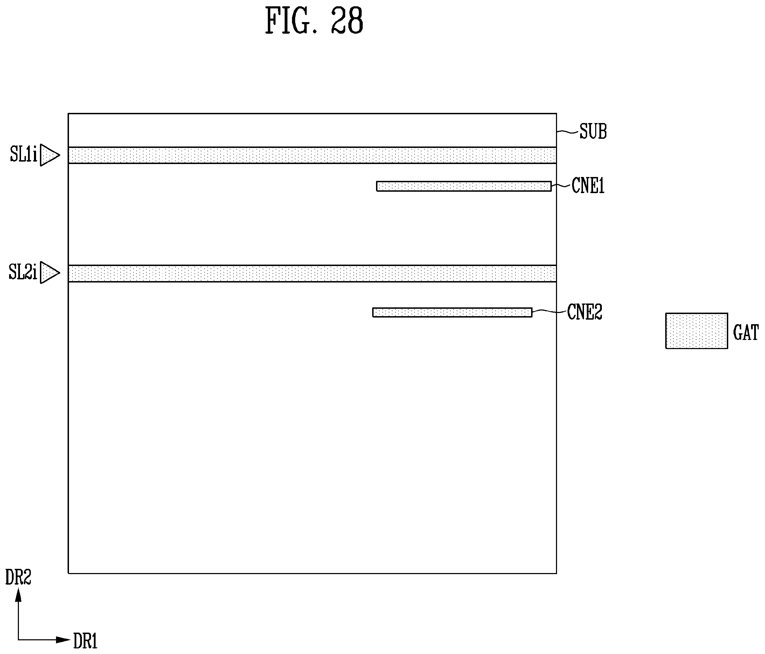

Hereinafter, the disclosure is described with reference to FIG. 28.

The gate electrode layer GAT may be formed on the substrate SUB (or on the buffer layer). The gate electrode layer GAT may include a metal. For example, the gate electrode layer GAT may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the gate electrode layer GAT may be formed as a single layer or may be formed as a multi-layer in which two or more materials among metals and alloys are stacked.

A gate insulating layer may be positioned on the gate electrode layer GAT. The gate insulating layer may include an inorganic insulating layer including an inorganic material. As the inorganic material, polysiloxane, silicon nitride, silicon oxide, silicon oxynitride, or the like may be used.

The gate electrode layer GAT may configure the first scan line SL1i, the second scan line SL2i, a first connection electrode CNE1, and a second connection electrode CNE2. The first scan line SL1i, the second scan line SL2i, the first connection electrode CNE1, and the second connection electrode CNE2 may entirely extend in the first direction DR1.

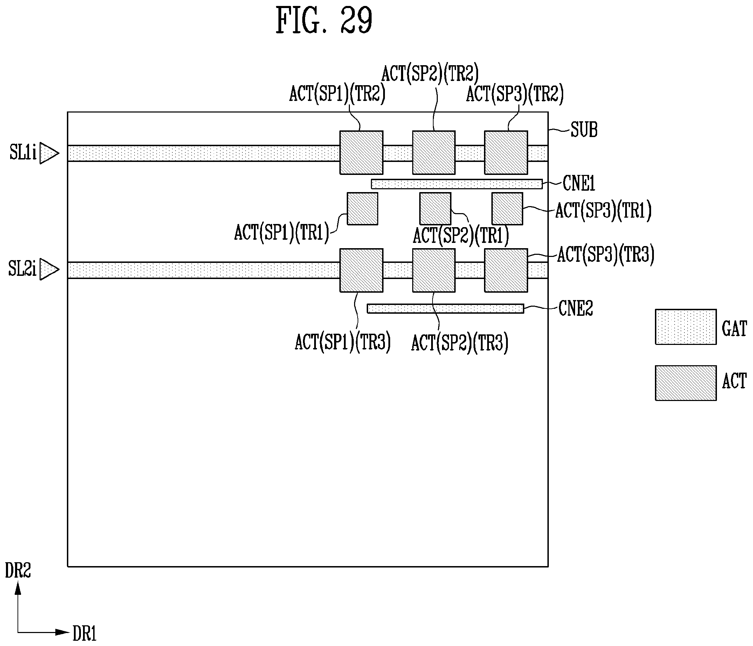

Hereinafter, the disclosure is described with reference to FIG. 29.

A semiconductor layer ACT may be positioned on the gate electrode layer GAT (or on the gate insulating layer). The semiconductor layer ACT may include an oxide semiconductor. For example, the semiconductor layer ACT may be formed through a metal oxide semiconductor forming process. However, embodiments are not limited thereto. For example, the semiconductor layer ACT may be formed of a silicon semiconductor. For example, the semiconductor layer ACT may include a semiconductor of amorphous silicon (a-Si). The semiconductor layer ACT may include a semiconductor of polycrystalline silicon (poly-Si).

The semiconductor layer ACT configuring the semiconductor layer of the second transistor TR2 may be positioned to overlap the first scan line SL1i on the plane. The semiconductor layer ACT configuring the semiconductor layer of the third transistor TR3 may be positioned to overlap the second scan line SL2i on the plane. The semiconductor layer ACT configuring the semiconductor layer of the first transistor TR1 may be positioned between the first scan line SL1i and the second scan line SL2i. The first connection electrode CNE1 may be positioned between the semiconductor layer of the first transistor TR1 and the semiconductor layer of the second transistor TR2. The second connection electrode CNE2 may be positioned adjacent to the semiconductor layer of the third transistor TR3 in the second direction DR2.

An interlayer insulating layer may be provided on the semiconductor layer ACT. The interlayer insulating layer may include an inorganic insulating layer including an inorganic material. As the inorganic material, polysiloxane, silicon nitride, silicon oxide, silicon oxynitride, and the like may be used.

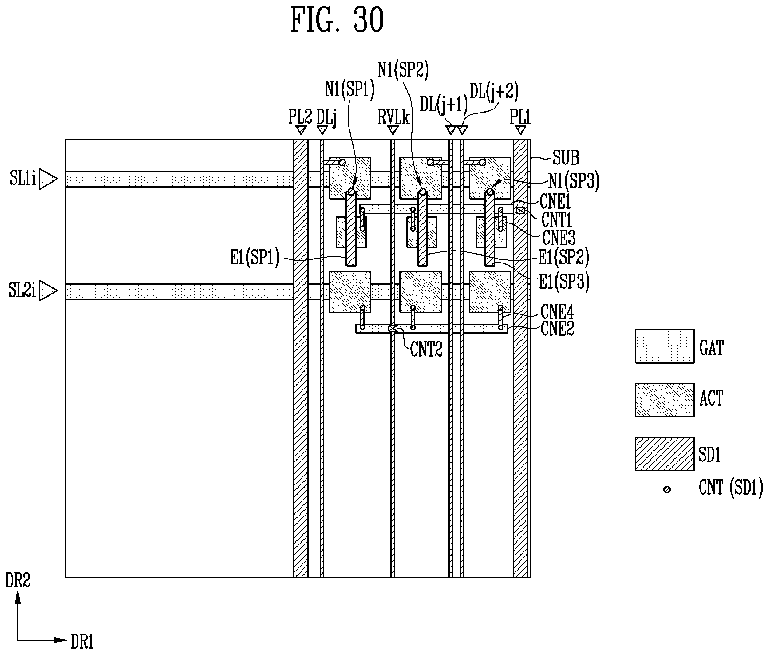

Hereinafter, the disclosure is described with reference to FIG. 30.

A first source drain electrode layer SD1 may be positioned on the semiconductor layer ACT (or on the interlayer insulating layer). The first source drain electrode layer SD1 may include a metal. The first source drain electrode layer SD1 may include a material having excellent conductivity. For example, the first source drain electrode layer SD1 may include a conductive material including molybdenum (Mo), aluminum (Al), copper (Cu), titanium (Ti), and the like. The first source drain electrode layer SD1 may be formed as a multi-layer structure or a single layer structure including the above-described material. For example, the first source drain electrode layer SD1 may have a multi-layer structure of Ti/Al/Ti.

The first source drain electrode layer SD1 may configure the j-th data line DLj, the (j+1)-th data line DL(j+1), the (j+2)-th data line DL(j+2), the reference voltage line RVLk, the first power line PL1, and the second power line PL2. The first source drain electrode layer SD1 may configure a third connection electrode CNE3 and a fourth connection electrode CNE4. The first source drain electrode layer SD1 may configure the first electrode E1.

The first source drain electrode layer SD1 configuring the first power line PL1 may be connected to the first connection electrode CNE1 in the first contact hole CNT1. The third connection electrode CNE3 may be connected to the first connection electrode CNE1. The third connection electrode CNE3 may be connected to the semiconductor layer of the first transistor TR1.

The first source drain electrode layer SD1 configuring the second power line PL2 may entirely extend in the second direction DR2. The second power line PL2 may be positioned to overlap the first scan line SL1i and the second scan line SL2i on the plane. The second power line PL2 may be positioned adjacent to the j-th data line DLj in the first direction DR1. However, embodiments are not limited thereto.

The first source drain electrode layer SD1 configuring the j-th data line DLj may be connected to the semiconductor layer of the second transistor TR2 of the first sub-pixel SP1. The first source drain electrode layer SD1 configuring the (j+1)-th data line DL(j+1) may be connected to the semiconductor layer of the second transistor TR2 of the second sub-pixel SP2. The first source drain electrode layer SD1 configuring the (j+2)-th data line DL(j+2) may be connected to the semiconductor layer of the second transistor TR2 of the third sub-pixel SP3.

The (j+1)-th data line DL(j+1) and the (j+2)-th data line DL(j+2) may be positioned adjacent to each other in the first direction DR1. However, embodiments are not limited thereto.

The reference voltage line RVLk may be positioned adjacent to each of the semiconductor layer of the first sub-pixel SP1 and the semiconductor layer of the second sub-pixel SP2 in the first direction DR1 on the plane. However, embodiments are not limited thereto.

The first source drain electrode layer SD1 configuring the reference voltage line RVLk may be connected to the second connection electrode CNE2 in the second contact hole CNT2. The fourth connection electrode CNE4 may be connected to the second connection electrode CNE2 and the semiconductor layer of the third transistor TR3.

The first power line PL1 may be positioned adjacent to the semiconductor layer of the third sub-pixel SP3 in the first direction DR1 on the plane. However, embodiments are not limited thereto.

The first source drain electrode layer SD1 configuring the first electrode E1 may be connected to the semiconductor layer of the second transistor TR2 and may extend in one direction (for example, the second direction DR2). The first electrode E1 may overlap at least a portion of the semiconductor layer of the first transistor TR1. An area overlapping the first electrode E1 in the semiconductor layer of the first transistor TR1 may configure a channel area of the first transistor TR1. The first electrode E1 may configure one side electrode of the storage capacitor Cstg (refer to FIG. 2) and may configure a gate electrode of the first transistor TR1. The first electrode E1 may correspond to the first node N1.

A first insulating layer may be provided on the first source drain electrode layer SD1. For example, the first insulating layer may be an organic insulating layer including an organic material. The first insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The first insulating layer may perform a function of planarizing an area on the first source drain electrode layer SD1.

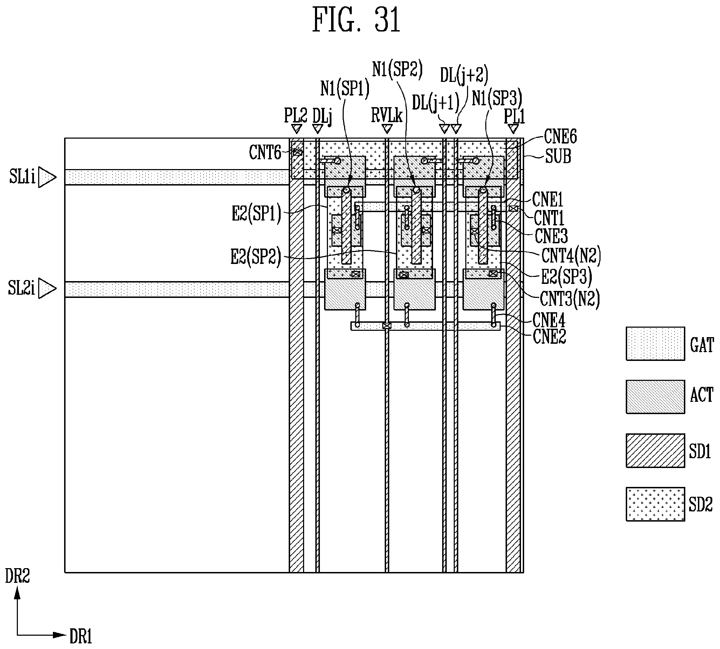

Hereinafter, the disclosure is described with reference to FIG. 31.

A second source drain electrode layer SD2 may be positioned on the first source drain electrode layer SD1 (or on the first insulating layer). The second source drain electrode layer SD2 may include a metal. The second source drain electrode layer SD2 may include a material having excellent conductivity. For example, the second source drain electrode layer SD2 may include a conductive material including molybdenum (Mo), aluminum (Al), copper (Cu), titanium (Ti), and the like. The second source drain electrode layer SD2 may be formed as a multi-layer structure or a single layer structure including the above-described material. For example, the second source drain electrode layer SD2 may have a multi-layer structure of Ti/Al/Ti.

The second source drain electrode layer SD2 may configure the second electrode E2 and a sixth connection electrode CNE6.

The second source drain electrode layer SD2 configuring the second electrode E2 may be connected to the semiconductor layer of the third transistor TR3 through a third contact hole CNT3. The second source drain electrode layer SD2 may be directly connected to the semiconductor layer of the third transistor TR3. The second source drain electrode layer SD2 may be electrically connected to the semiconductor layer of the third transistor TR3 through the first source drain electrode layer SD1.

The second source drain electrode layer SD2 configuring the second electrode E2 may be connected to the semiconductor layer of the first transistor TR1 through a fourth contact hole CNT4. The second source drain electrode layer SD2 may be directly connected to the semiconductor layer of the first transistor TR1. The second source drain electrode layer SD2 may be electrically connected to the semiconductor layer of the first transistor TR1 through the first source drain electrode layer SD1.

The second source drain electrode layer SD2 configuring the sixth connection electrode CNE6 may be connected to the first source drain electrode layer SD1 configuring the second power line PL2 through a sixth contact hole CNT6. The sixth connection electrode CNE6 may extend in the first direction DR1 on the second power line PL2, and may be positioned to overlap the j-th data line DLj, the reference voltage line RVLk, the (j+1)-th data line DL(j+1), and the (j+2)-th data line DL(j+2) on the plane. The sixth connection electrode CNE6 may be positioned to overlap the first power line PL1 on the plane, but embodiments are not limited thereto.

A second insulating layer may be provided on the second source drain electrode layer SD2. For example, the second insulating layer may be an organic insulating layer including an organic material. The second insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The second insulating layer may perform a function of planarizing an area on the second source drain electrode layer SD2.

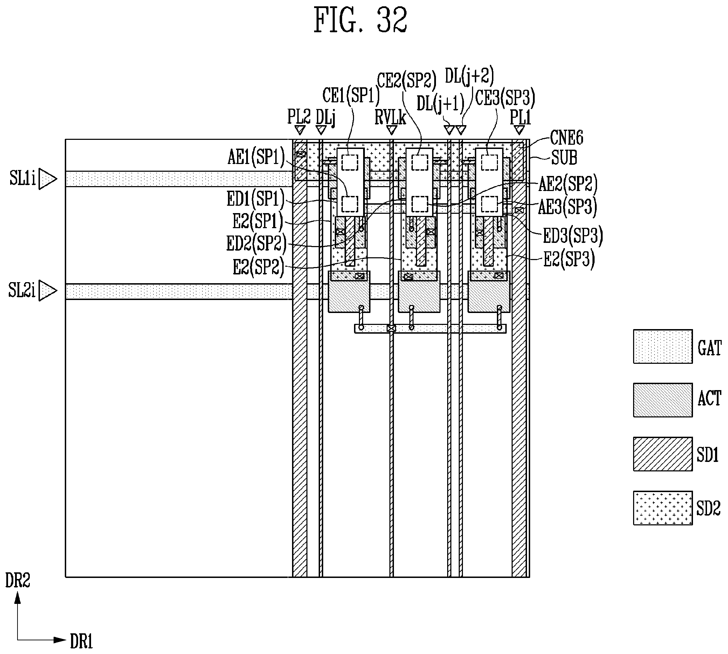

Hereinafter, the disclosure is described with reference to FIG. 32.

The first to third light emitting elements ED1 to ED3 may be positioned on the second source drain electrode layer SD2 (or on the second insulating layer).

The first anode electrode AE1 of the first light emitting element ED1 may be connected to the second electrode E2 of the first sub-pixel SP1. The first cathode electrode CE1 of the first light emitting element ED1 may be connected to the sixth connection electrode CNE6.

The second anode electrode AE2 of the second light emitting element ED2 may be connected to the second electrode E2 of the second sub-pixel SP2. The second cathode electrode CE2 of the second light emitting element ED2 may be connected to the sixth connection electrode CNE6.

The third anode electrode AE3 of the third light emitting element ED3 may be connected to the second electrode E2 of the third sub-pixel SP3. The third cathode electrode CE3 of the third light emitting element ED3 may be connected to the sixth connection electrode CNE6.

The respective first to third light emitting elements ED1 to ED3 may be positioned adjacent to each other in the first direction DR1.

The cathode electrodes CE1, CE2, and CE3 of the respective first to third light emitting elements ED1 to ED3 may overlap the semiconductor layer ACT on the plane. For example, the first to third cathode electrodes CE1 to CE3 may be positioned to overlap the semiconductor layer of the second transistor TR2 on the plane. As another example, the first to third cathode electrodes CE1 to CE3 may be positioned to overlap the semiconductor layer of the third transistor TR3 on the plane. In this case, the sixth connection electrode CNE6 may be positioned to overlap the semiconductor layer of the third transistor TR3 on the plane.

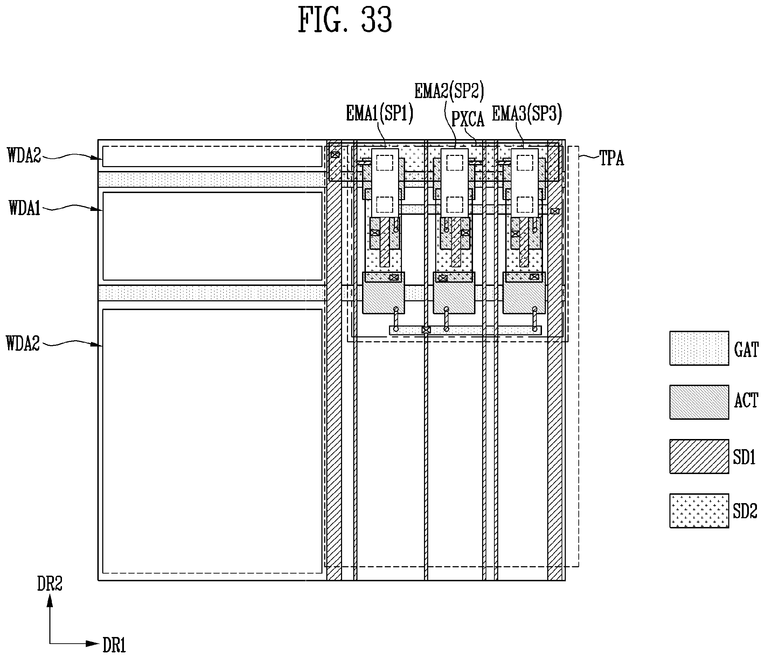

Hereinafter, the disclosure is described with reference to FIG. 33.

The window area WDA may transmit light through the substrate SUB. The window area WDA may include the first window area WDA1 and the second window area WDA2. A semiconductor layer ACT and a metal layer may not be positioned in the window area WDA. For example, the gate electrode layer GAT, the semiconductor layer ACT, the first source drain electrode layer SD1, and the second source drain electrode layer SD2 may not be positioned in the window area WDA.

The first window area WDA1 may be positioned adjacent to the pixel circuit area PXCA in the first direction DR1. At least a portion of the second window area WDA2 may be positioned adjacent to the pixel circuit area PXCA in the first direction DR1. A remaining portion of the second window area WDA2 may be positioned adjacent to the light transmission area TPA in the first direction DR1.

The first window area WDA1 and the second window area WDA2 may be positioned spaced apart from each other in the second direction DR2. The gate electrode layer GAT may be positioned between the first window area WDA1 and the second window area WDA2.

A semiconductor layer ACT and a metal layer may be positioned in the pixel circuit area PXCA. For example, the gate electrode layer GAT, the semiconductor layer ACT, the first source drain electrode layer SD1, and the second source drain electrode layer SD2 may be positioned in the pixel circuit area PXCA.

The first to third emission areas EMA1 to EMA3 may be positioned to completely overlap the pixel circuit area PXCA.

The first source drain electrode layer SD1 may be positioned in the light transmission area TPA. Light may pass through the substrate SUB through the light transmission area TPA, but light transmittance of the light transmission area TPA may be lower than light transmittance of the window area WDA and may be higher than light transmittance of the pixel circuit area PXCA.

Compared to FIGS. 13 and 25 described above, the light transmission line TCO and the anode electrode layer AND may not be positioned in the light transmission area TPA. Accordingly, light transmittance may be further increased in the light transmission area TPA.

In addition, the first to third cathode electrodes CE1 to CE3 may be positioned to overlap the semiconductor layer ACT on the plane, and thus the area of the light transmission area TPA may be further increased. Accordingly, light transmittance may be further increased.

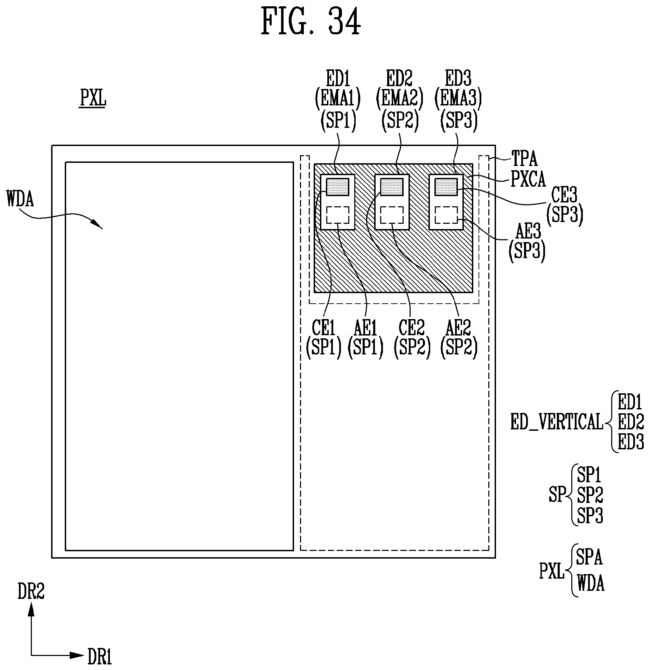

FIG. 34 is a second embodiment of the pixel PXL, in which a vertical type light emitting element ED_VERTICAL is disposed.

Referring to FIG. 34, in the pixel PXL, emission areas of the sub-pixels SP may be positioned adjacent in the first direction DR1. For example, a first emission area EMA1 which is an emission area of the first sub-pixel SP1, a second emission area EMA2 which is an emission area of the second sub-pixel SP2, and a third emission area EMA3 which is an emission area of the third sub-pixel SP3 may be defined, respectively.

The first emission area EMA1 may correspond to a first light emitting element ED1 which is a light emitting element of the first sub-pixel SP1. The second emission area EMA2 may correspond to a second light emitting element ED2 which is a light emitting element of the second sub-pixel SP2. The third emission area EMA3 may correspond to a third light emitting element ED3 which is a light emitting element of the third sub-pixel SP3.

Each of the first to third light emitting elements ED1 to ED3 may be implemented as the vertical type light emitting element ED_VERTICAL. A micro light emitting diode (LED) used in the art may be employed as the vertical type light emitting element ED_VERTICAL.

In the vertical type light emitting element ED_VERTICAL, an anode electrode may be positioned at a lower surface of the vertical type light emitting element ED_VERTICAL and a cathode electrode may be positioned at an upper surface of the vertical type light emitting element ED_VERTICAL. For example, the first light emitting element ED1 may include a first anode electrode AE1 and a first cathode electrode CE1, the first anode electrode AE1 may be positioned at a lower surface, and the first cathode electrode CE1 may be positioned at an upper surface. The second light emitting element ED2 may include a second anode electrode AE2 and a second cathode electrode CE2, the second anode electrode AE2 may be positioned at a lower surface, and the second cathode electrode CE2 may be positioned at an upper surface. The third light emitting element ED3 may include a third anode electrode AE3 and a third cathode electrode CE3, the third anode electrode AE3 may be positioned at a lower surface, and the third cathode electrode CE3 may be positioned at an upper surface.

The vertical type light emitting element ED_VERTICAL may include the emission layer EML (refer to FIG. 2). The emission layer EML may be positioned between the anode electrode and the cathode electrode.

Compared to the pixel PXL according to the first embodiment of FIG. 4 described above, in the pixel PXL according to the second embodiment, the emission areas EMA1, EMA2, and EMA3 are not positioned in the light transmission area TPA. Accordingly, light transmittance may be further increased in the light transmission area TPA.

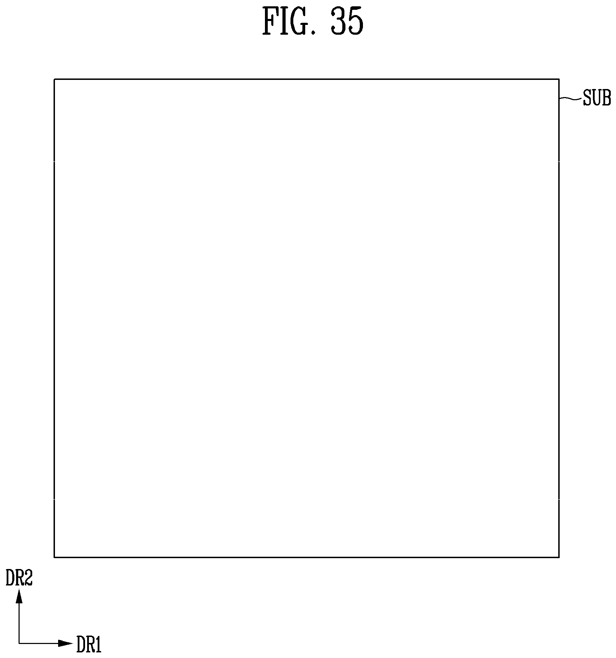

FIGS. 35 to 41 are drawings illustrating a method of manufacturing a display device.

The display device shown through FIGS. 35 to 41 may include a transistor of a bottom-gate structure and/or a transistor of a top-gate structure. For example, the second and third transistors TR2 and TR3 may be implemented as transistors of a bottom-gate structure, and the first transistor TR1 may be implemented as a transistor of a top-gate structure. However, they are not limited thereto. For example, at least one of the second transistor TR2 and the third transistor TR3 may be implemented as a transistor of a top-gate structure, or the first transistor TR1 may be implemented as a transistor of a bottom-gate structure.

Hereafter, the disclosure is described with reference to FIG. 35.

A substrate SUB may be formed of an insulating material such as glass or resin. In addition, the substrate SUB may be formed of a material having flexibility so that the substrate SUB may be bent or folded, and may have a single-layer structure or a multi-layer structure. The substrate SUB may include at least one base layer and at least one barrier layer that are sequentially stacked. The base layer may include polyimide (PI), polyethersulfone (PES), polyarylate, polyetherimide (PEI), polyethylene naphthalate (PEN), polyethylene terephthalate (PET), polyphenylene sulfide (PPS), polycarbonate (PC), cellulose triacetate (CTA), cellulose acetate propionate (CAP), and/or the like. The barrier layer may include an inorganic insulating material such as silicon oxide, silicon oxynitride, and/or silicon nitride.

A buffer layer may be disposed on the substrate SUB. The buffer layer may prevent an impurity from being diffused into a circuit element (for example, a transistor). The buffer layer may be omitted according to a material and a process condition of the base layer. The buffer layer may include an inorganic insulating material such as silicon oxide, silicon oxynitride, or silicon nitride. The buffer layer may be formed as a single-layer structure or a multi-layer structure including the above-described material.

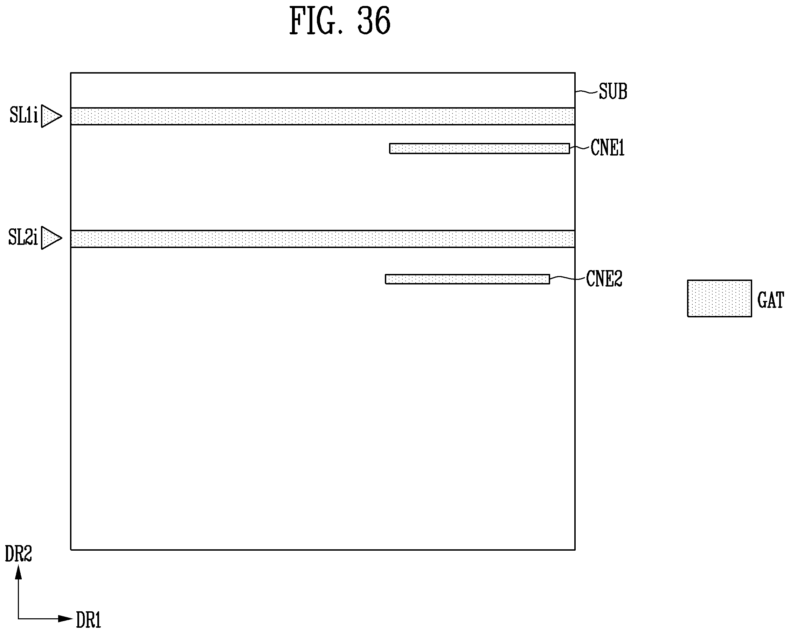

Hereinafter, the disclosure is described with reference to FIG. 36.

The gate electrode layer GAT may be formed on the substrate SUB (or on the buffer layer). The gate electrode layer GAT may include a metal. For example, the gate electrode layer GAT may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the gate electrode layer GAT may be formed as a single layer or may be formed as a multi-layer in which two or more materials among metals and alloys are stacked.

A gate insulating layer may be positioned on the gate electrode layer GAT. The gate insulating layer may include an inorganic insulating layer including an inorganic material. As the inorganic material, polysiloxane, silicon nitride, silicon oxide, silicon oxynitride, or the like may be used.

The gate electrode layer GAT may configure the first scan line SL1i, the second scan line SL2i, a first connection electrode CNE1, and a second connection electrode CNE2. The first scan line SL1i, the second scan line SL2i, the first connection electrode CNE1, and the second connection electrode CNE2 may entirely extend in the first direction DR1.

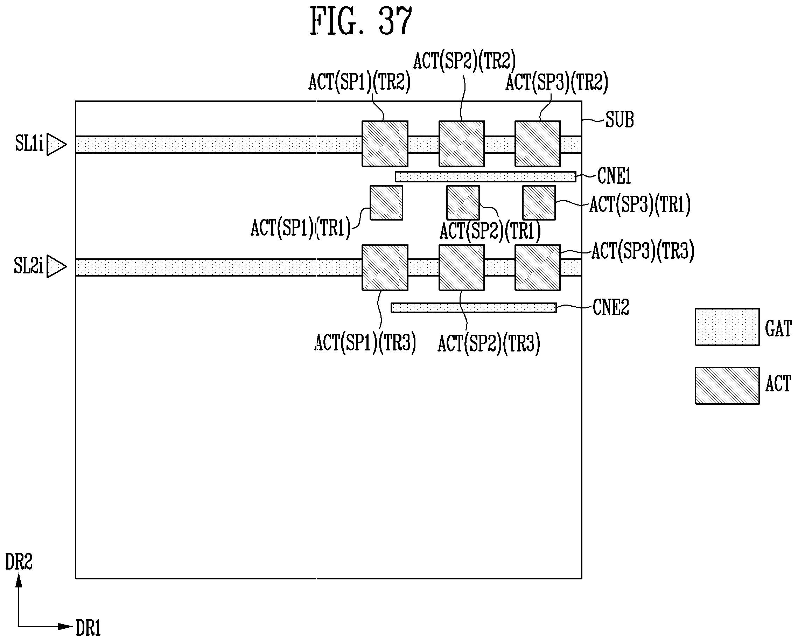

Hereinafter, the disclosure is described with reference to FIG. 37.

A semiconductor layer ACT may be positioned on the gate electrode layer GAT (or on the gate insulating layer). The semiconductor layer ACT may include an oxide semiconductor. For example, the semiconductor layer ACT may be formed through a metal oxide semiconductor forming process. However, embodiments are not limited thereto. For example, the semiconductor layer ACT may be formed of a silicon semiconductor. For example, the semiconductor layer ACT may include a semiconductor of amorphous silicon (a-Si). The semiconductor layer ACT may include a semiconductor of polycrystalline silicon (poly-Si).

The semiconductor layer ACT configuring the semiconductor layer of the second transistor TR2 may be positioned to overlap the first scan line SL1i on the plane. The semiconductor layer ACT configuring the semiconductor layer of the third transistor TR3 may be positioned to overlap the second scan line SL2i on the plane. The semiconductor layer ACT configuring the semiconductor layer of the first transistor TR1 may be positioned between the first scan line SL1i and the second scan line SL2i. The first connection electrode CNE1 may be positioned between the semiconductor layer of the first transistor TR1 and the semiconductor layer of the second transistor TR2. The second connection electrode CNE2 may be positioned adjacent to the semiconductor layer of the third transistor TR3 in the second direction DR2.

An interlayer insulating layer may be provided on the semiconductor layer ACT. The interlayer insulating layer may include an inorganic insulating layer including an inorganic material. As the inorganic material, polysiloxane, silicon nitride, silicon oxide, silicon oxynitride, and the like may be used.

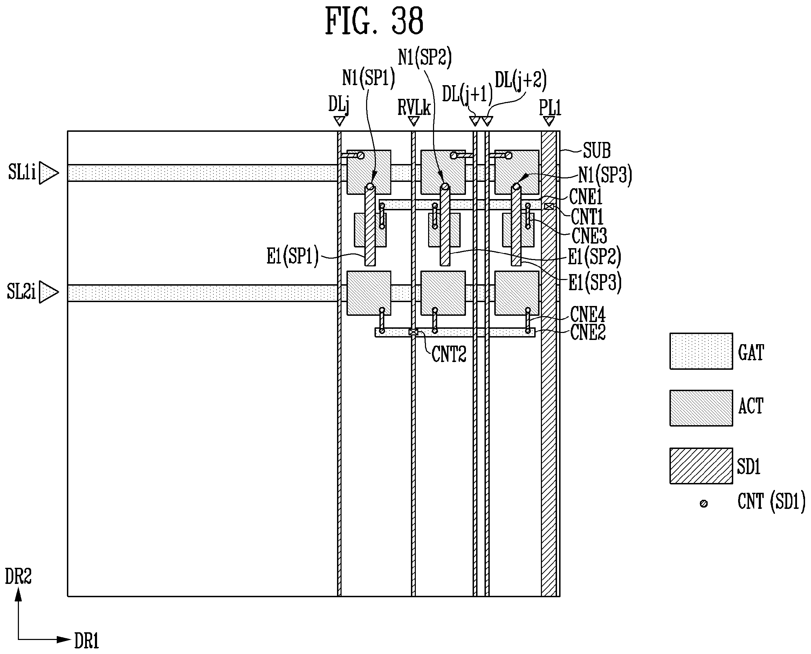

Hereinafter, the disclosure is described with reference to FIG. 38.

A first source drain electrode layer SD1 may be positioned on the semiconductor layer ACT (or on the interlayer insulating layer). The first source drain electrode layer SD1 may include a metal. The first source drain electrode layer SD1 may include a material having excellent conductivity. For example, the first source drain electrode layer SD1 may include a conductive material including molybdenum (Mo), aluminum (Al), copper (Cu), titanium (Ti), and the like. The first source drain electrode layer SD1 may be formed as a multi-layer structure or a single layer structure including the above-described material. For example, the first source drain electrode layer SD1 may have a multi-layer structure of Ti/Al/Ti.

The first source drain electrode layer SD1 may configure the j-th data line DLj, the (j+1)-th data line DL(j+1), the (j+2)-th data line DL(j+2), the reference voltage line RVLk, and the first power line PL1. The first source drain electrode layer SD1 may configure a third connection electrode CNE3 and a fourth connection electrode CNE4. The first source drain electrode layer SD1 may configure the first electrode E1.

The first source drain electrode layer SD1 configuring the first power line PL1 may be connected to the first connection electrode CNE1 in the first contact hole CNT1. The third connection electrode CNE3 may be connected to the first connection electrode CNE1. The third connection electrode CNE3 may be connected to the semiconductor layer of the first transistor TR1.

The first source drain electrode layer SD1 configuring the j-th data line DLj may be connected to the semiconductor layer of the second transistor TR2 of the first sub-pixel SP1. The first source drain electrode layer SD1 configuring the (j+1)-th data line DL(j+1) may be connected to the semiconductor layer of the second transistor TR2 of the second sub-pixel SP2. The first source drain electrode layer SD1 configuring the (j+2)-th data line DL(j+2) may be connected to the semiconductor layer of the second transistor TR2 of the third sub-pixel SP3.

The (j+1)-th data line DL(j+1) and the (j+2)-th data line DL(j+2) may be positioned adjacent to each other in the first direction DR1. However, embodiments are not limited thereto.

The reference voltage line RVLk may be positioned adjacent to each of the semiconductor layer of the first sub-pixel SP1 and the semiconductor layer of the second sub-pixel SP2 in the first direction DR1 on the plane. However, embodiments are not limited thereto.

The first source drain electrode layer SD1 configuring the reference voltage line RVLk may be connected to the second connection electrode CNE2 in the second contact hole CNT2. The fourth connection electrode CNE4 may be connected to the second connection electrode CNE2 and the semiconductor layer of the third transistor TR3.

The first power line PL1 may be positioned adjacent to the semiconductor layer of the third sub-pixel SP3 in the first direction DR1 on the plane. However, embodiments are not limited thereto.

The first source drain electrode layer SD1 configuring the first electrode E1 may be connected to the semiconductor layer of the second transistor TR2 and may extend in one direction (for example, the second direction DR2). The first electrode E1 may overlap at least a portion of the semiconductor layer of the first transistor TR1. An area overlapping the first electrode E1 in the semiconductor layer of the first transistor TR1 may configure a channel area of the first transistor TR1. The first electrode E1 may configure one side electrode of the storage capacitor Cstg (refer to FIG. 2) and may configure a gate electrode of the first transistor TR1. The first electrode E1 may correspond to the first node N1.

A first insulating layer may be provided on the first source drain electrode layer SD1. For example, the first insulating layer may be an organic insulating layer including an organic material. The first insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The first insulating layer may perform a function of planarizing an area on the first source drain electrode layer SD1.

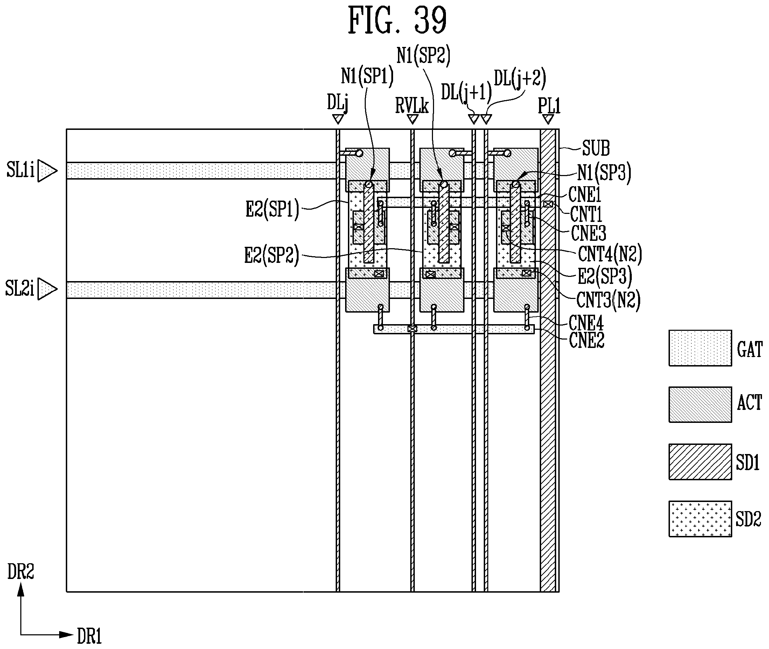

Hereinafter, the disclosure is described with reference to FIG. 39.

A second source drain electrode layer SD2 may be positioned on the first source drain electrode layer SD1 (or on the first insulating layer). The second source drain electrode layer SD2 may include a metal. The second source drain electrode layer SD2 may include a material having excellent conductivity. For example, the second source drain electrode layer SD2 may include a conductive material including molybdenum (Mo), aluminum (Al), copper (Cu), titanium (Ti), and the like. The second source drain electrode layer SD2 may be formed as a multi-layer structure or a single layer structure including the above-described material. For example, the second source drain electrode layer SD2 may have a multi-layer structure of Ti/Al/Ti.

The second source drain electrode layer SD2 may configure the second electrode E2.

The second source drain electrode layer SD2 configuring the second electrode E2 may be connected to the semiconductor layer of the third transistor TR3 through a third contact hole CNT3. The second source drain electrode layer SD2 may be directly connected to the semiconductor layer of the third transistor TR3. The second source drain electrode layer SD2 may be electrically connected to the semiconductor layer of the third transistor TR3 through the first source drain electrode layer SD1.

The second source drain electrode layer SD2 configuring the second electrode E2 may be connected to the semiconductor layer of the first transistor TR1 through a fourth contact hole CNT4. The second source drain electrode layer SD2 may be directly connected to the semiconductor layer of the first transistor TR1. The second source drain electrode layer SD2 may be electrically connected to the semiconductor layer of the first transistor TR1 through the first source drain electrode layer SD1.

A second insulating layer may be provided on the second source drain electrode layer SD2. For example, the second insulating layer may be an organic insulating layer including an organic material. The second insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The second insulating layer may perform a function of planarizing an area on the second source drain electrode layer SD2.

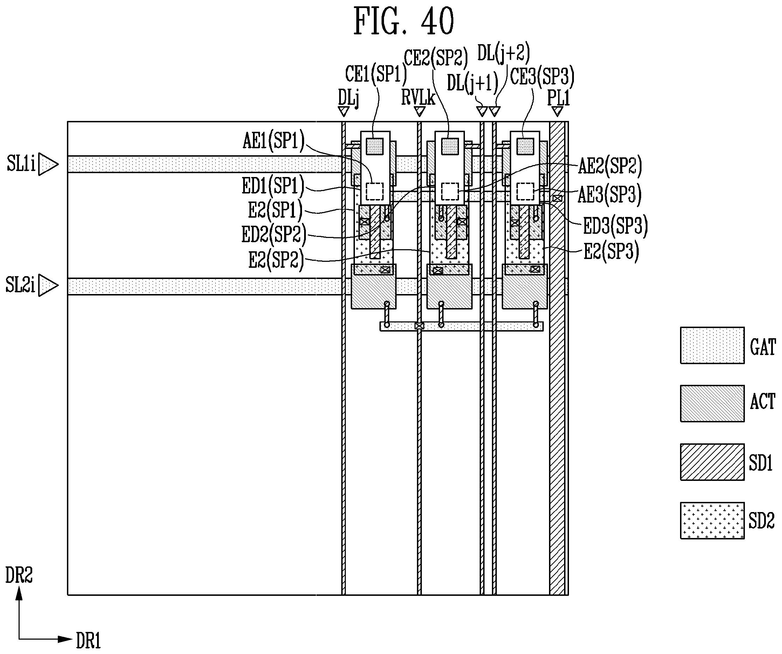

Hereinafter, the disclosure is described with reference to FIG. 40.

The first to third light emitting elements ED1 to ED3 may be positioned on the second source drain electrode layer SD2 (or on the second insulating layer).

The first anode electrode AE1 of the first light emitting element ED1 may be connected to the second electrode E2 of the first sub-pixel SP1.

The second anode electrode AE2 of the second light emitting element ED2 may be connected to the second electrode E2 of the second sub-pixel SP2.

The third anode electrode AE3 of the third light emitting element ED3 may be connected to the second electrode E2 of the third sub-pixel SP3.

The cathode electrodes CE1 to CE3 of the first to third light emitting elements ED1 to ED3 may be connected to the second power line PL2 (refer to FIGS. 2 and 14) on the first to third light emitting elements ED1 to ED3.

The respective first to third light emitting elements ED1 to ED3 may be positioned adjacent to each other in the first direction DR1.

The cathode electrodes CE1, CE2, and CE3 of the respective first to third light emitting elements ED1 to ED3 may overlap the semiconductor layer ACT on the plane. For example, the first to third cathode electrodes CE1 to CE3 may be positioned to overlap the semiconductor layer of the second transistor TR2 on the plane. As another example, the first to third cathode electrodes CE1 to CE3 may be positioned to overlap the semiconductor layer of the third transistor TR3 on the plane.

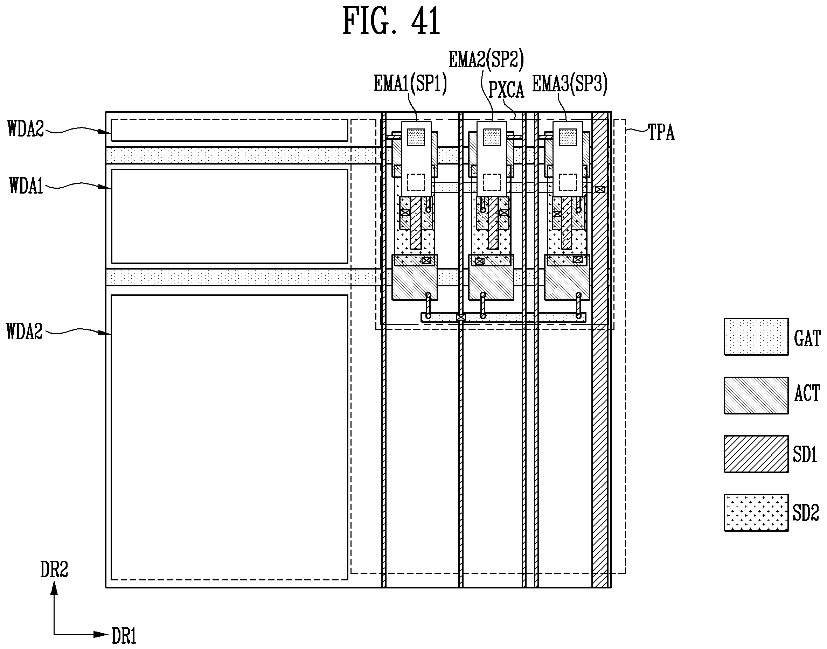

Hereinafter, the disclosure is described with reference to FIG. 41.

The window area WDA may transmit light through the substrate SUB. The window area WDA may include the first window area WDA1 and the second window area WDA2. A semiconductor layer ACT and a metal layer may not be positioned in the window area WDA. For example, the gate electrode layer GAT, the semiconductor layer ACT, the first source drain electrode layer SD1, and the second source drain electrode layer SD2 may not be positioned in the window area WDA.

The first window area WDA1 may be positioned adjacent to the pixel circuit area PXCA in the first direction DR1. At least a portion of the second window area WDA2 may be positioned adjacent to the pixel circuit area PXCA in the first direction DR1. A remaining portion of the second window area WDA2 may be positioned adjacent to the light transmission area TPA in the first direction DR1.

The first window area WDA1 and the second window area WDA2 may be positioned spaced apart from each other in the second direction DR2. The gate electrode layer GAT may be positioned between the first window area WDA1 and the second window area WDA2.

A semiconductor layer ACT and a metal layer may be positioned in the pixel circuit area PXCA. For example, the gate electrode layer GAT, the semiconductor layer ACT, the first source drain electrode layer SD1, and the second source drain electrode layer SD2 may be positioned in the pixel circuit area PXCA.

The first to third emission areas EMA1 to EMA3 may be positioned to completely overlap the pixel circuit area PXCA.

The first source drain electrode layer SD1 may be positioned in the light transmission area TPA. Light may pass through the substrate SUB through the light transmission area TPA, but light transmittance of the light transmission area TPA may be lower than light transmittance of the window area WDA and may be higher than light transmittance of the pixel circuit area PXCA.

Compared to the embodiment of FIGS. 13 and 25 described above, the light transmission line TCO and the anode electrode layer AND may not be positioned in the light transmission area TPA. Accordingly, light transmittance may be further increased in the light transmission area TPA.

Compared to the embodiment of FIG. 33 described above, the second power line PL2 may not be positioned in the light transmission area TPA. Accordingly, the area of the window area WDA may be relatively increased.

In addition, the first to third cathode electrodes CE1 to CE3 may be positioned to overlap the semiconductor layer ACT on the plane, and thus the area of the light transmission area TPA may be further increased. Accordingly, light transmittance may be further increased.

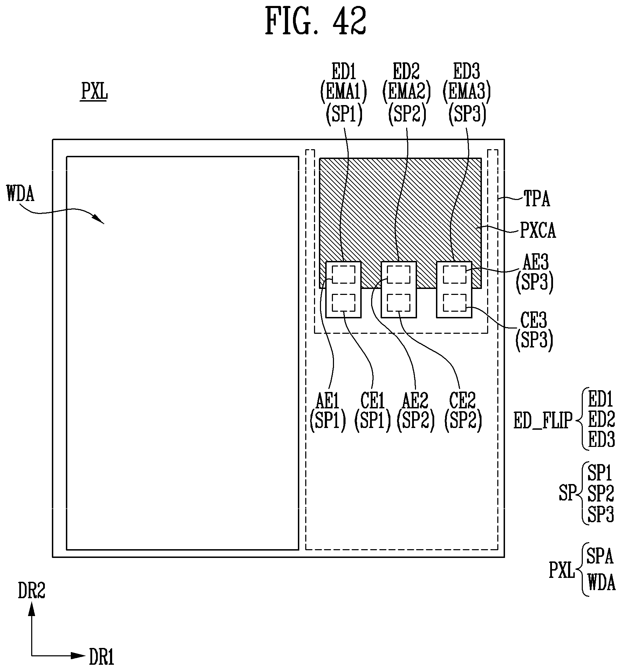

FIG. 42 is a third embodiment of the pixel PXL, in which a flip type light emitting element ED_FLIP is disposed.

Referring to FIG. 42, in the pixel PXL according to the third embodiment, emission areas of the sub-pixels SP may be positioned adjacent in the first direction DR1. For example, a first emission area EMA1 which is an emission area of the first sub-pixel SP1, a second emission area EMA2 which is an emission area of the second sub-pixel SP2, and a third emission area EMA3 which is an emission area of the third sub-pixel SP3 may be defined, respectively.

When comparing the pixel PXL according to the third embodiment with the pixel PXL according to the second embodiment described above through FIGS. 26 and 34, the cathode electrode of each of the light emitting elements ED1, ED2, and ED3 may be positioned outside the pixel circuit area PXCA on the plane. For example, the first to third cathode electrodes CE1 to CE3 may be positioned outside the pixel circuit area PXCA on the plane. Accordingly, force that the light emitting elements ED1, ED2, and ED3 press against an organic insulating layer and an inorganic insulating layer positioned in the pixel circuit area PXCA may be distributed. Accordingly, a problem that a transistor, a capacitor, a line, and the like collapse from their original positions in the pixel circuit area PXCA may be alleviated (or prevented).

The first emission area EMA1 may correspond to a first light emitting element ED1 which is a light emitting element of the first sub-pixel SP1. The second emission area EMA2 may correspond to a second light emitting element ED2 which is a light emitting element of the second sub-pixel SP2. The third emission area EMA3 may correspond to a third light emitting element ED3 which is a light emitting element of the third sub-pixel SP3.

Each of the first to third light emitting elements ED1 to ED3 may be implemented as the flip type light emitting element ED_FLIP.

In the flip type light emitting element ED_FLIP, each of an anode electrode and a cathode electrode may be positioned at a lower surface of the flip type light emitting element ED_FLIP. For example, the first light emitting element ED1 may include a first anode electrode AE1 and a first cathode electrode CE1, and each of the first anode electrode AE1 and the first cathode electrode CE1 may be positioned at a lower surface of the first light emitting element ED1. The second light emitting element ED2 may include a second anode electrode AE2 and a second cathode electrode CE2, and each of the second anode electrode AE2 and the second cathode electrode CE2 may be positioned at a lower surface of the second light emitting element ED2. The third light emitting element ED3 may include a third anode electrode AE3 and a third cathode electrode CE3, and each of the third anode electrode AE3 and a third cathode electrode CE3 may be positioned at a lower surface of the third light emitting element ED3.

The flip type light emitting element ED_FLIP may include the emission layer EML (refer to FIG. 2). The emission layer EML may be positioned on the anode electrode and the cathode electrode.

Compared to the pixel PXL according to the first embodiment of FIG. 4 described above, in the pixel PXL according to the third embodiment, the emission areas EMA1, EMA2, and EMA3 are not positioned in the light transmission area TPA. Accordingly, light transmittance may be further increased in the light transmission area TPA.

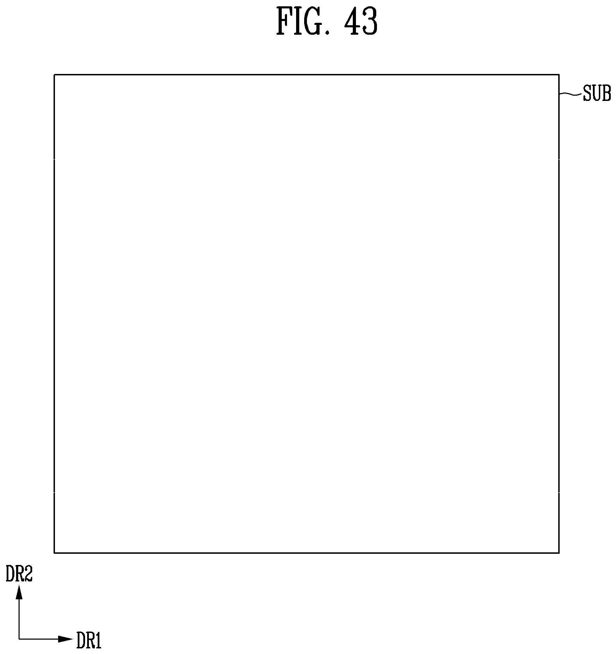

FIGS. 43 to 49 are drawings illustrating a method of manufacturing a display device.

The display device shown through FIGS. 43 to 49 may include a transistor of a bottom-gate structure and/or a transistor of a top-gate structure. For example, the second and third transistors TR2 and TR3 may be implemented as transistors of a bottom-gate structure, and the first transistor TR1 may be implemented as a transistor of a top-gate structure. However, they are not limited thereto. For example, at least one of the second transistor TR2 and the third transistor TR3 may be implemented as a transistor of a top-gate structure, or the first transistor TR1 may be implemented as a transistor of a bottom-gate structure.

Hereafter, the disclosure is described with reference to FIG. 43.

A substrate SUB may be formed of an insulating material such as glass or resin. In addition, the substrate SUB may be formed of a material having flexibility so that the substrate SUB may be bent or folded, and may have a single-layer structure or a multi-layer structure. The substrate SUB may include at least one base layer and at least one barrier layer that are sequentially stacked. The base layer may include polyimide (PI), polyethersulfone (PES), polyarylate, polyetherimide (PEI), polyethylene naphthalate (PEN), polyethylene terephthalate (PET), polyphenylene sulfide (PPS), polycarbonate (PC), cellulose triacetate (CTA), cellulose acetate propionate (CAP), and/or the like. The barrier layer may include an inorganic insulating material such as silicon oxide, silicon oxynitride, and/or silicon nitride.

A buffer layer may be disposed on the substrate SUB. The buffer layer may prevent an impurity from being diffused into a circuit element (for example, a transistor). The buffer layer may be omitted according to a material and a process condition of the base layer. The buffer layer may include an inorganic insulating material such as silicon oxide, silicon oxynitride, or silicon nitride. The buffer layer may be formed as a single-layer structure or a multi-layer structure including the above-described material.

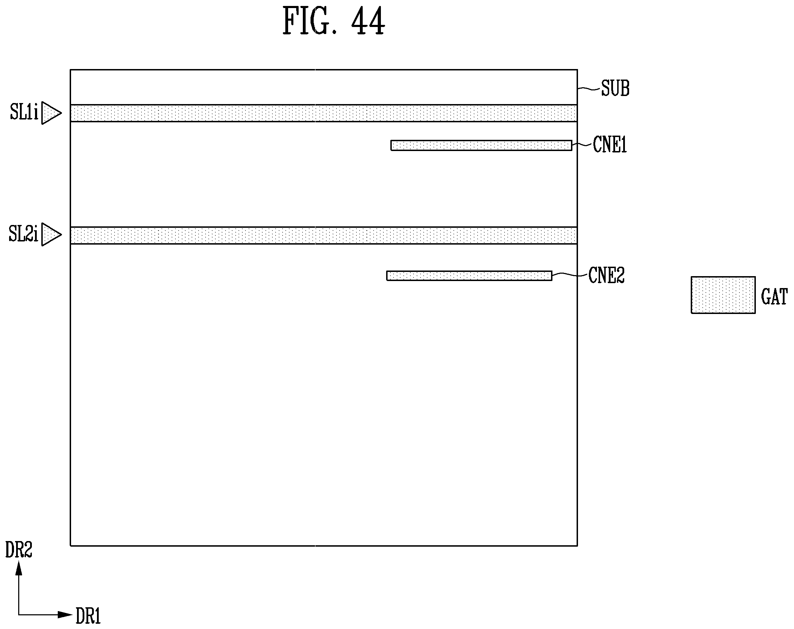

Hereinafter, the disclosure is described with reference to FIG. 44.

The gate electrode layer GAT may be formed on the substrate SUB (or on the buffer layer). The gate electrode layer GAT may include a metal. For example, the gate electrode layer GAT may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the gate electrode layer GAT may be formed as a single layer or may be formed as a multi-layer in which two or more materials among metals and alloys are stacked.

A gate insulating layer may be positioned on the gate electrode layer GAT. The gate insulating layer may include an inorganic insulating layer including an inorganic material. As the inorganic material, polysiloxane, silicon nitride, silicon oxide, silicon oxynitride, or the like may be used.

The gate electrode layer GAT may configure the first scan line SL1i, the second scan line SL2i, a first connection electrode CNE1, and a second connection electrode CNE2. The first scan line SL1i, the second scan line SL2i, the first connection electrode CNE1, and the second connection electrode CNE2 may entirely extend in the first direction DR1.

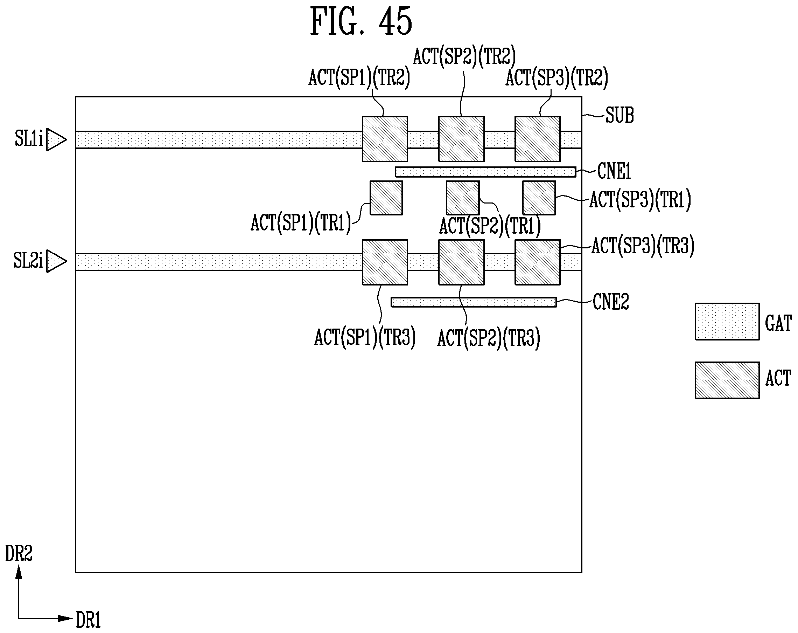

Hereinafter, the disclosure is described with reference to FIG. 45.

A semiconductor layer ACT may be positioned on the gate electrode layer GAT (or on the gate insulating layer). The semiconductor layer ACT may include an oxide semiconductor. For example, the semiconductor layer ACT may be formed through a metal oxide semiconductor forming process. However, embodiments are not limited thereto. For example, the semiconductor layer ACT may be formed of a silicon semiconductor. For example, the semiconductor layer ACT may include a semiconductor of amorphous silicon (a-Si). The semiconductor layer ACT may include a semiconductor of polycrystalline silicon (poly-Si).

The semiconductor layer ACT configuring the semiconductor layer of the second transistor TR2 may be positioned to overlap the first scan line SL1i on the plane. The semiconductor layer ACT configuring the semiconductor layer of the third transistor TR3 may be positioned to overlap the second scan line SL2i on the plane. The semiconductor layer ACT configuring the semiconductor layer of the first transistor TR1 may be positioned between the first scan line SL1i and the second scan line SL2i. The first connection electrode CNE1 may be positioned between the semiconductor layer of the first transistor TR1 and the semiconductor layer of the second transistor TR2. The second connection electrode CNE2 may be positioned adjacent to the semiconductor layer of the third transistor TR3 in the second direction DR2.

An interlayer insulating layer may be provided on the semiconductor layer ACT. The interlayer insulating layer may include an inorganic insulating layer including an inorganic material. As the inorganic material, polysiloxane, silicon nitride, silicon oxide, silicon oxynitride, and the like may be used.

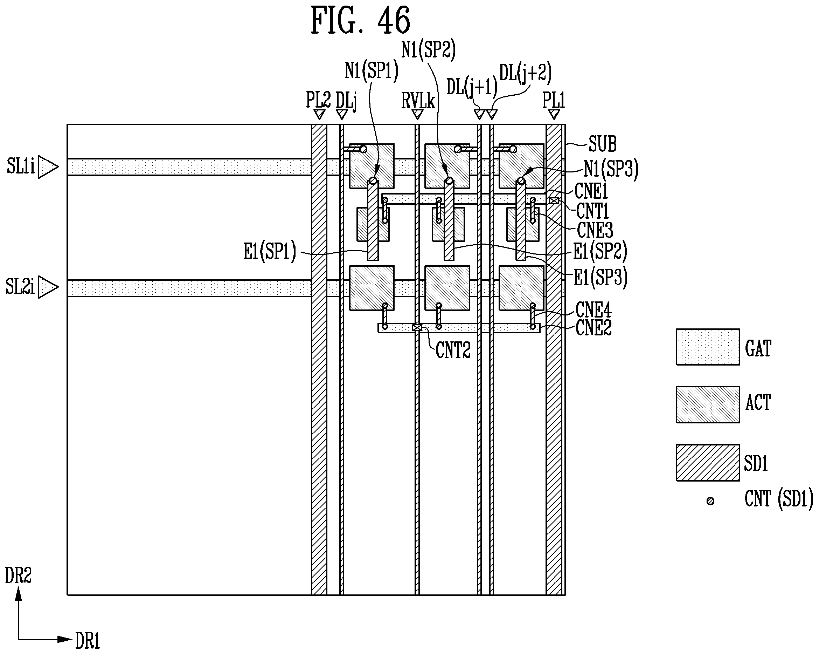

Hereinafter, the disclosure is described with reference to FIG. 46.

A first source drain electrode layer SD1 may be positioned on the semiconductor layer ACT (or on the interlayer insulating layer). The first source drain electrode layer SD1 may include a metal. The first source drain electrode layer SD1 may include a material having excellent conductivity. For example, the first source drain electrode layer SD1 may include a conductive material including molybdenum (Mo), aluminum (Al), copper (Cu), titanium (Ti), and the like. The first source drain electrode layer SD1 may be formed as a multi-layer structure or a single layer structure including the above-described material. For example, the first source drain electrode layer SD1 may have a multi-layer structure of Ti/Al/Ti.

The first source drain electrode layer SD1 may configure the j-th data line DLj, the (j+1)-th data line DL(j+1), the (j+2)-th data line DL(j+2), the reference voltage line RVLk, the first power line PL1, and the second power line PL2. The first source drain electrode layer SD1 may configure a third connection electrode CNE3 and a fourth connection electrode CNE4. The first source drain electrode layer SD1 may configure the first electrode E1.

The first source drain electrode layer SD1 configuring the first power line PL1 may be connected to the first connection electrode CNE1 in the first contact hole CNT1. The third connection electrode CNE3 may be connected to the first connection electrode CNE1. The third connection electrode CNE3 may be connected to the semiconductor layer of the first transistor TR1.

The first source drain electrode layer SD1 configuring the second power line PL2 may entirely extend in the second direction DR2. The second power line PL2 may be positioned to overlap the first scan line SL1i and the second scan line SL2i on the plane. The second power line PL2 may be positioned adjacent to the j-th data line DLj in the first direction DR1. However, embodiments are not limited thereto.

The first source drain electrode layer SD1 configuring the j-th data line DLj may be connected to the semiconductor layer of the second transistor TR2 of the first sub-pixel SP1. The first source drain electrode layer SD1 configuring the (j+1)-th data line DL(j+1) may be connected to the semiconductor layer of the second transistor TR2 of the second sub-pixel SP2. The first source drain electrode layer SD1 configuring the (j+2)-th data line DL(j+2) may be connected to the semiconductor layer of the second transistor TR2 of the third sub-pixel SP3.

The (j+1)-th data line DL(j+1) and the (j+2)-th data line DL(j+2) may be positioned adjacent to each other in the first direction DR1. However, embodiments are not limited thereto.

The reference voltage line RVLk may be positioned adjacent to each of the semiconductor layer of the first sub-pixel SP1 and the semiconductor layer of the second sub-pixel SP2 in the first direction DR1 on the plane. However, embodiments are not limited thereto.

The first source drain electrode layer SD1 configuring the reference voltage line RVLk may be connected to the second connection electrode CNE2 in the second contact hole CNT2. The fourth connection electrode CNE4 may be connected to the second connection electrode CNE2 and the semiconductor layer of the third transistor TR3.

The first power line PL1 may be positioned adjacent to the semiconductor layer of the third sub-pixel SP3 in the first direction DR1 on the plane. However, embodiments are not limited thereto.

The first source drain electrode layer SD1 configuring the first electrode E1 may be connected to the semiconductor layer of the second transistor TR2 and may extend in one direction (for example, the second direction DR2). The first electrode E1 may overlap at least a portion of the semiconductor layer of the first transistor TR1. An area overlapping the first electrode E1 in the semiconductor layer of the first transistor TR1 may configure a channel area of the first transistor TR1. The first electrode E1 may configure one side electrode of the storage capacitor Cstg (refer to FIG. 2) and may configure a gate electrode of the first transistor TR1. The first electrode E1 may correspond to the first node N1.

A first insulating layer may be provided on the first source drain electrode layer SD1. For example, the first insulating layer may be an organic insulating layer including an organic material. The first insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The first insulating layer may perform a function of planarizing an area on the first source drain electrode layer SD1.

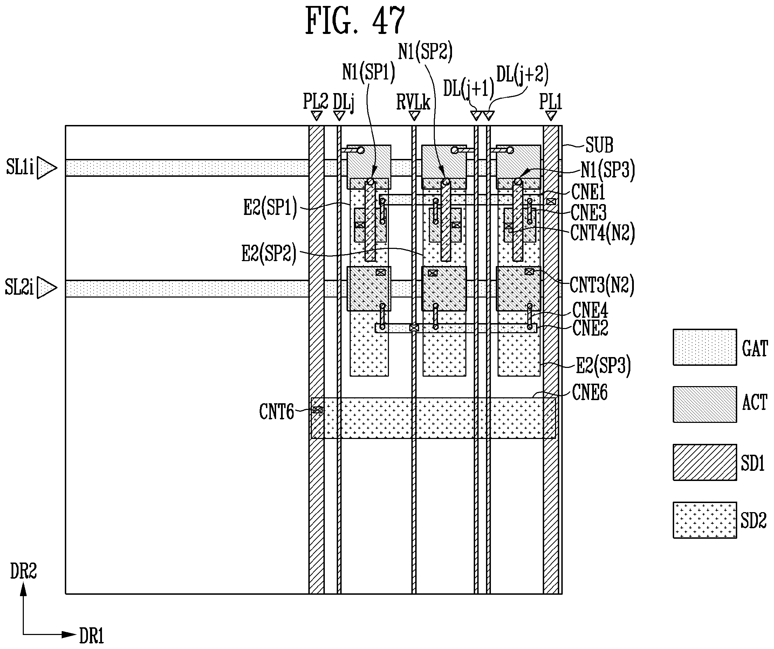

Hereinafter, the disclosure is described with reference to FIG. 47.

A second source drain electrode layer SD2 may be positioned on the first source drain electrode layer SD1 (or on the first insulating layer). The second source drain electrode layer SD2 may include a metal. The second source drain electrode layer SD2 may include a material having excellent conductivity. For example, the second source drain electrode layer SD2 may include a conductive material including molybdenum (Mo), aluminum (Al), copper (Cu), titanium (Ti), and the like. The second source drain electrode layer SD2 may be formed as a multi-layer structure or a single layer structure including the above-described material. For example, the second source drain electrode layer SD2 may have a multi-layer structure of Ti/Al/Ti.

The second source drain electrode layer SD2 may configure the second electrode E2 and a sixth connection electrode CNE6.

The second source drain electrode layer SD2 configuring the second electrode E2 may be connected to the semiconductor layer of the third transistor TR3 through a third contact hole CNT3. The second source drain electrode layer SD2 may be directly connected to the semiconductor layer of the third transistor TR3. The second source drain electrode layer SD2 may be electrically connected to the semiconductor layer of the third transistor TR3 through the first source drain electrode layer SD1.

The second source drain electrode layer SD2 configuring the second electrode E2 may be connected to the semiconductor layer of the first transistor TR1 through a fourth contact hole CNT4. The second source drain electrode layer SD2 may be directly connected to the semiconductor layer of the first transistor TR1. The second source drain electrode layer SD2 may be electrically connected to the semiconductor layer of the first transistor TR1 through the first source drain electrode layer SD1.

The second source drain electrode layer SD2 configuring the sixth connection electrode CNE6 may be connected to the first source drain electrode layer SD1 configuring the second power line PL2 through a sixth contact hole CNT6. The sixth connection electrode CNE6 may extend in the first direction DR1 on the second power line PL2, and may be positioned to overlap the j-th data line DLj, the reference voltage line RVLk, the (j+1)-th data line DL(j+1), and the (j+2)-th data line DL(j+2) on the plane. The sixth connection electrode CNE6 may be positioned to overlap the first power line PL1 on the plane, but it is not limited thereto.

Referring to FIG. 47, the sixth connection electrode CNE6 may not overlap the semiconductor layer ACT on the plane. For example, the sixth connection electrode CNE6 may be positioned adjacent to the second electrode E2 of each of the first to third sub-pixels SP1 to SP3 in the second direction DR2, and may be positioned in an opposite direction so as not to overlap the semiconductor layer of the second transistor TR2.

A second insulating layer may be provided on the second source drain electrode layer SD2. For example, the second insulating layer may be an organic insulating layer including an organic material. The second insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The second insulating layer may perform a function of planarizing an area on the second source drain electrode layer SD2.

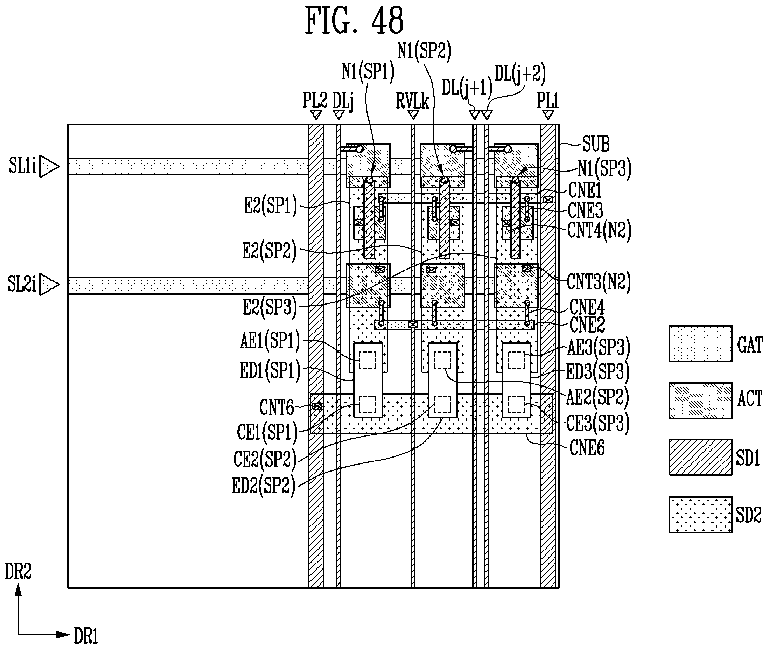

Hereinafter, the disclosure is described with reference to FIG. 48.

The first to third light emitting elements ED1 to ED3 may be positioned on the second source drain electrode layer SD2 (or on the second insulating layer).

The first anode electrode AE1 of the first light emitting element ED1 may be connected to the second electrode E2 of the first sub-pixel SP1. The first cathode electrode CE1 of the first light emitting element ED1 may be connected to the sixth connection electrode CNE6.

The second anode electrode AE2 of the second light emitting element ED2 may be connected to the second electrode E2 of the second sub-pixel SP2. The second cathode electrode CE2 of the second light emitting element ED2 may be connected to the sixth connection electrode CNE6.

The third anode electrode AE3 of the third light emitting element ED3 may be connected to the second electrode E2 of the third sub-pixel SP3. The third cathode electrode CE3 of the third light emitting element ED3 may be connected to the sixth connection electrode CNE6.

The respective first to third light emitting elements ED1 to ED3 may be positioned adjacent to each other in the first direction DR1.

The cathode electrodes CE1, CE2, and CE3 of the respective first to third light emitting elements ED1 to ED3 may not overlap the semiconductor layer ACT on the plane. For example, the first to third cathode electrodes CE1 to CE3 may be positioned so as not to overlap the semiconductor layer of the second transistor TR2 on the plane. As another example, the first to third cathode electrodes CE1 to CE3 may be positioned so as not to overlap the semiconductor layer of the third transistor TR3 on the plane. In this case, the sixth connection electrode CNE6 may be positioned so as not to overlap the semiconductor layer of the third transistor TR3 on the plane.

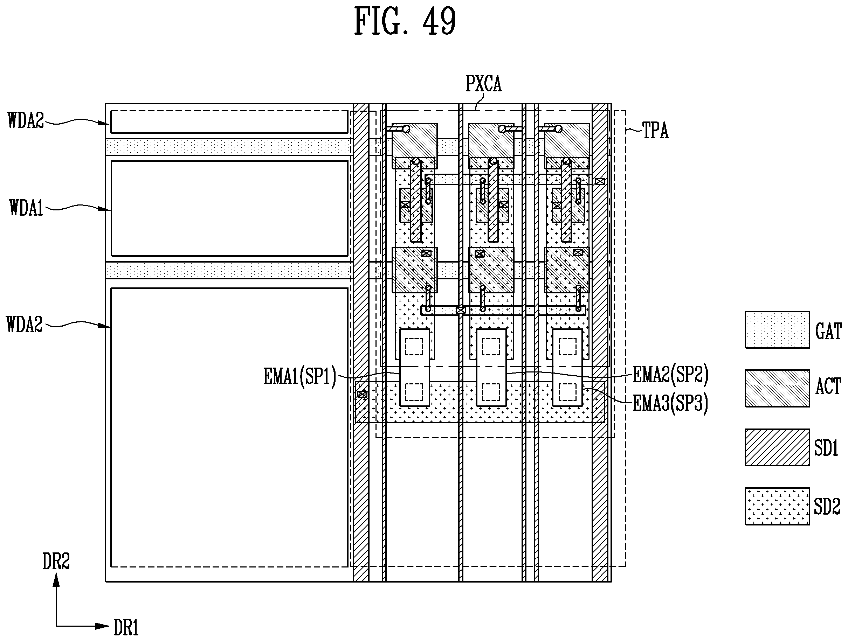

Hereinafter, the disclosure is described with reference to FIG. 49.

The window area WDA may transmit light through the substrate SUB. The window area WDA may include the first window area WDA1 and the second window area WDA2. A semiconductor layer ACT and a metal layer may not be positioned in the window area WDA. For example, the gate electrode layer GAT, the semiconductor layer ACT, the first source drain electrode layer SD1, and the second source drain electrode layer SD2 may not be positioned in the window area WDA.

The first window area WDA1 may be positioned adjacent to the pixel circuit area PXCA in the first direction DR1. At least a portion of the second window area WDA2 may be positioned adjacent to the pixel circuit area PXCA in the first direction DR1. A remaining portion of the second window area WDA2 may be positioned adjacent to the light transmission area TPA in the first direction DR1.

The first window area WDA1 and the second window area WDA2 may be positioned spaced apart from each other in the second direction DR2. The gate electrode layer GAT may be positioned between the first window area WDA1 and the second window area WDA2.

A semiconductor layer ACT and a metal layer may be positioned in the pixel circuit area PXCA. For example, the gate electrode layer GAT, the semiconductor layer ACT, the first source drain electrode layer SD1, and the second source drain electrode layer SD2 may be positioned in the pixel circuit area PXCA.

At least a portion of the first to third emission areas EMA1 to EMA3 may be positioned to overlap the pixel circuit area PXCA. A remaining portion of the first to third emission areas EMA1 to EMA3 may be positioned so as not to overlap the pixel circuit area PXCA on the plane.

The first source drain electrode layer SD1 may be positioned in the light transmission area TPA. Light may pass through the substrate SUB through the light transmission area TPA, but light transmittance of the light transmission area TPA may be lower than light transmittance of the window area WDA and may be higher than light transmittance of the pixel circuit area PXCA.

Compared to the embodiment of FIGS. 13 and 25 described above, the light transmission line TCO and the anode electrode layer AND may not be positioned in the light transmission area TPA. Accordingly, light transmittance may be further increased in the light transmission area TPA.

In addition, the first to third cathode electrodes CE1 to CE3 may be positioned so as not to overlap the semiconductor layer ACT on the plane, and thus force (or pressure) applied to the pixel circuit area PXCA may be distributed. Accordingly, transistors, capacitors, and lines may be stably formed.

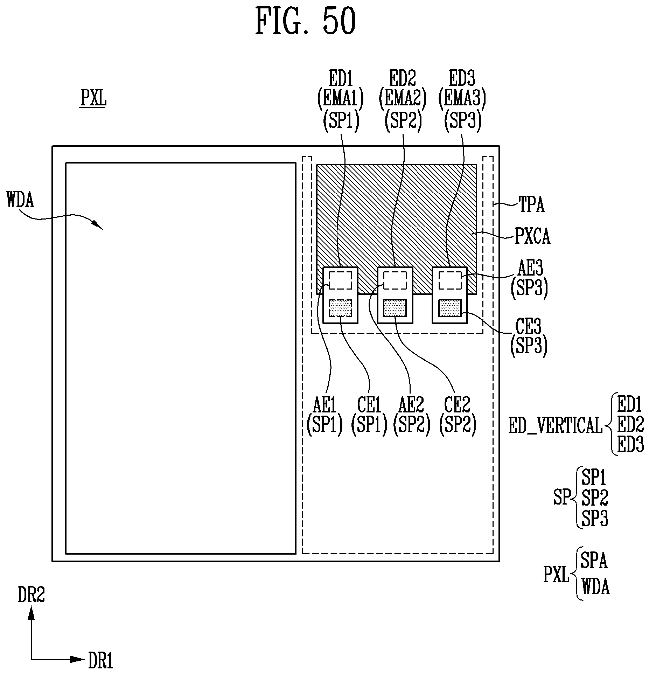

FIG. 50 is a third embodiment of the pixel PXL, in which a vertical type light emitting element ED_VERTICAL is disposed.

Referring to FIG. 50, in the pixel PXL according to the third embodiment, emission areas of the sub-pixels SP may be positioned adjacent in the first direction DR1. For example, a first emission area EMA1 which is an emission area of the first sub-pixel SP1, a second emission area EMA2 which is an emission area of the second sub-pixel SP2, and a third emission area EMA3 which is an emission area of the third sub-pixel SP3 may be defined, respectively.

When comparing the pixel PXL according to the third embodiment with the pixel PXL according to the second embodiment described above through FIGS. 26 and 34, the cathode electrode of each of the light emitting elements ED1, ED2, and ED3 may be positioned outside the pixel circuit area PXCA on the plane. For example, the first to third cathode electrodes CE1 to CE3 may be positioned outside the pixel circuit area PXCA on the plane. Accordingly, force that the light emitting elements ED1, ED2, and ED3 press against an organic insulating layer and an inorganic insulating layer positioned in the pixel circuit area PXCA may be distributed. Accordingly, a problem that a transistor, a capacitor, a line, and the like collapse from their original positions in the pixel circuit area PXCA may be alleviated (or prevented).

The first emission area EMA1 may correspond to a first light emitting element ED1 which is a light emitting element of the first sub-pixel SP1. The second emission area EMA2 may correspond to a second light emitting element ED2 which is a light emitting element of the second sub-pixel SP2. The third emission area EMA3 may correspond to a third light emitting element ED3 which is a light emitting element of the third sub-pixel SP3.

Each of the first to third light emitting elements ED1 to ED3 may be implemented as the vertical type light emitting element ED_VERTICAL.

In the vertical type light emitting element ED_VERTICAL, an anode electrode may be positioned at a lower surface of the vertical type light emitting element ED_VERTICAL and a cathode electrode may be positioned at an upper surface of the vertical type light emitting element ED_VERTICAL. For example, the first light emitting element ED1 may include a first anode electrode AE1 and a first cathode electrode CE1, the first anode electrode AE1 may be positioned at a lower surface, and the first cathode electrode CE1 may be positioned at an upper surface. The second light emitting element ED2 may include a second anode electrode AE2 and a second cathode electrode CE2, the second anode electrode AE2 may be positioned at a lower surface, and the second cathode electrode CE2 may be positioned at an upper surface. The third light emitting element ED3 may include a third anode electrode AE3 and a third cathode electrode CE3, the third anode electrode AE3 may be positioned at a lower surface, and the third cathode electrode CE3 may be positioned at an upper surface.

The vertical type light emitting element ED_VERTICAL may include the emission layer EML (refer to FIG. 2). The emission layer EML may be positioned between the anode electrode and the cathode electrode.

Compared to the pixel PXL according to the first embodiment of FIG. 4 described above, in the pixel PXL according to the third embodiment, the emission areas EMA1, EMA2, and EMA3 are not positioned in the light transmission area TPA. Accordingly, light transmittance may be further increased in the light transmission area TPA.

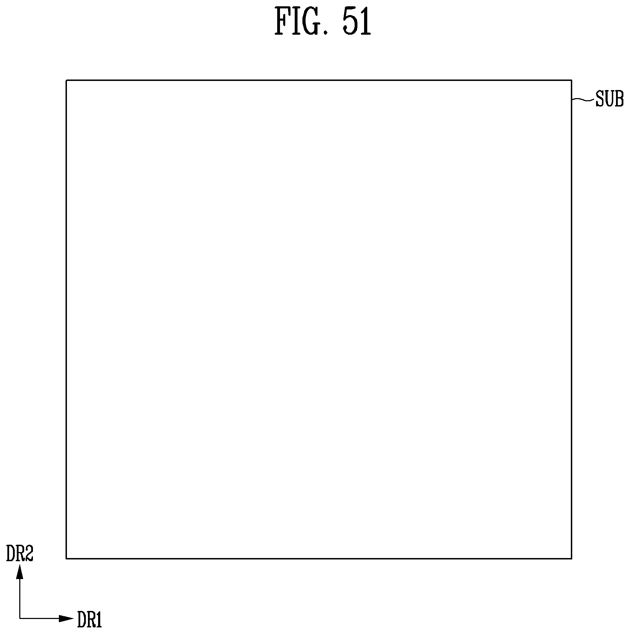

FIGS. 51 to 57 are drawings illustrating a method of manufacturing a display device.

The display device shown through FIGS. 51 to 57 may include a transistor of a bottom-gate structure and/or a transistor of a top-gate structure. For example, the second and third transistors TR2 and TR3 may be implemented as transistors of a bottom-gate structure, and the first transistor TR1 may be implemented as a transistor of a top-gate structure. However, they are not limited thereto. For example, at least one of the second transistor TR2 and the third transistor TR3 may be implemented as a transistor of a top-gate structure, or the first transistor TR1 may be implemented as a transistor of a bottom-gate structure.

Hereafter, the disclosure is described with reference to FIG. 51.

A substrate SUB may be formed of an insulating material such as glass or resin.

In addition, the substrate SUB may be formed of a material having flexibility so that the substrate SUB may be bent or folded, and may have a single-layer structure or a multi-layer structure. The substrate SUB may include at least one base layer and at least one barrier layer that are sequentially stacked. The base layer may include polyimide (PI), polyethersulfone (PES), polyarylate, polyetherimide (PEI), polyethylene naphthalate (PEN), polyethylene terephthalate (PET), polyphenylene sulfide (PPS), polycarbonate (PC), cellulose triacetate (CTA), cellulose acetate propionate (CAP), and/or the like. The barrier layer may include an inorganic insulating material such as silicon oxide, silicon oxynitride, and/or silicon nitride.

A buffer layer may be disposed on the substrate SUB. The buffer layer may prevent an impurity from being diffused into a circuit element (for example, a transistor). The buffer layer may be omitted according to a material and a process condition of the base layer. The buffer layer may include an inorganic insulating material such as silicon oxide, silicon oxynitride, or silicon nitride. The buffer layer may be formed as a single-layer structure or a multi-layer structure including the above-described material.

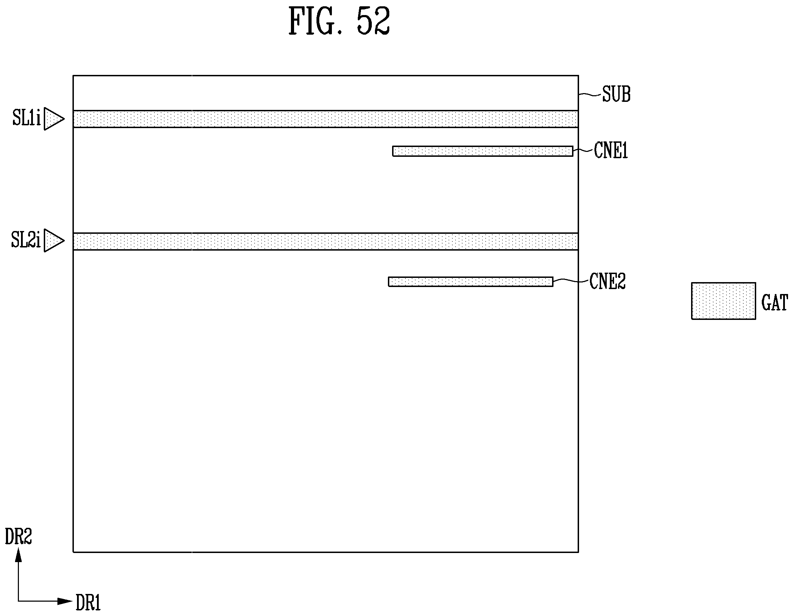

Hereinafter, the disclosure is described with reference to FIG. 52.

The gate electrode layer GAT may be formed on the substrate SUB (or on the buffer layer). The gate electrode layer GAT may include a metal. For example, the gate electrode layer GAT may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the gate electrode layer GAT may be formed as a single layer or may be formed as a multi-layer in which two or more materials among metals and alloys are stacked.

A gate insulating layer may be positioned on the gate electrode layer GAT. The gate insulating layer may include an inorganic insulating layer including an inorganic material. As the inorganic material, polysiloxane, silicon nitride, silicon oxide, silicon oxynitride, or the like may be used.

The gate electrode layer GAT may configure the first scan line SL1i, the second scan line SL2i, a first connection electrode CNE1, and a second connection electrode CNE2. The first scan line SL1i, the second scan line SL2i, the first connection electrode CNE1, and the second connection electrode CNE2 may entirely extend in the first direction DR1.

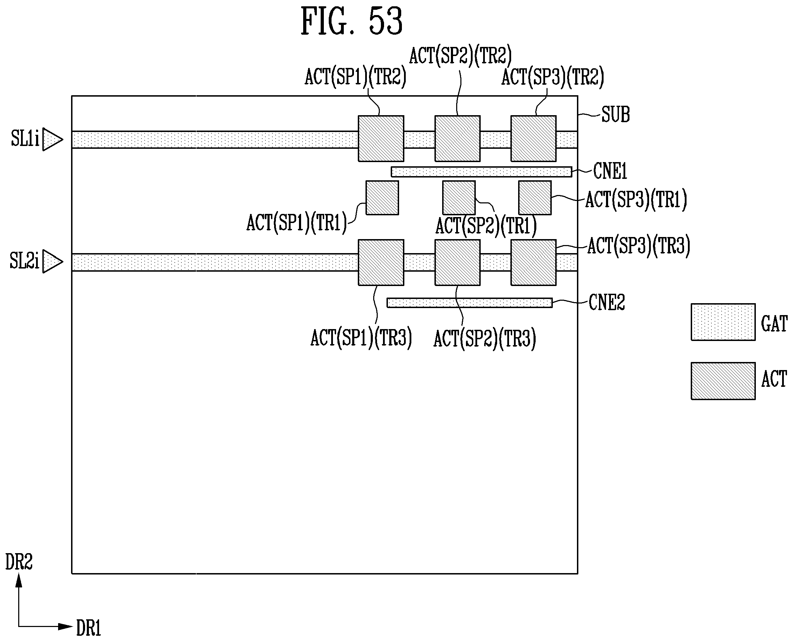

Hereinafter, the disclosure is described with reference to FIG. 53.

A semiconductor layer ACT may be positioned on the gate electrode layer GAT (or on the gate insulating layer). The semiconductor layer ACT may include an oxide semiconductor. For example, the semiconductor layer ACT may be formed through a metal oxide semiconductor forming process. However, embodiments are not limited thereto. For example, the semiconductor layer ACT may be formed of a silicon semiconductor. For example, the semiconductor layer ACT may include a semiconductor of amorphous silicon (a-Si). The semiconductor layer ACT may include a semiconductor of polycrystalline silicon (poly-Si).

The semiconductor layer ACT configuring the semiconductor layer of the second transistor TR2 may be positioned to overlap the first scan line SL1i on the plane. The semiconductor layer ACT configuring the semiconductor layer of the third transistor TR3 may be positioned to overlap the second scan line SL2i on the plane. The semiconductor layer ACT configuring the semiconductor layer of the first transistor TR1 may be positioned between the first scan line SL1i and the second scan line SL2i. The first connection electrode CNE1 may be positioned between the semiconductor layer of the first transistor TR1 and the semiconductor layer of the second transistor TR2. The second connection electrode CNE2 may be positioned adjacent to the semiconductor layer of the third transistor TR3 in the second direction DR2.

An interlayer insulating layer may be provided on the semiconductor layer ACT. The interlayer insulating layer may include an inorganic insulating layer including an inorganic material. As the inorganic material, polysiloxane, silicon nitride, silicon oxide, silicon oxynitride, and the like may be used.

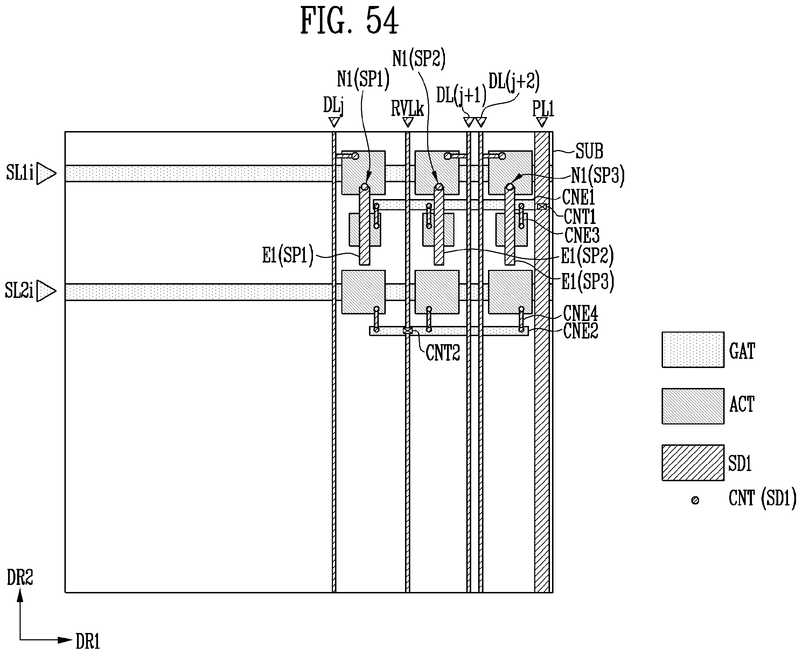

Hereinafter, the disclosure is described with reference to FIG. 54.

A first source drain electrode layer SD1 may be positioned on the semiconductor layer ACT (or on the interlayer insulating layer). The first source drain electrode layer SD1 may include a metal. The first source drain electrode layer SD1 may include a material having excellent conductivity. For example, the first source drain electrode layer SD1 may include a conductive material including molybdenum (Mo), aluminum (Al), copper (Cu), titanium (Ti), and the like. The first source drain electrode layer SD1 may be formed as a multi-layer structure or a single layer structure including the above-described material. For example, the first source drain electrode layer SD1 may have a multi-layer structure of Ti/Al/Ti.

The first source drain electrode layer SD1 may configure the j-th data line DLj, the (j+1)-th data line DL(j+1), the (j+2)-th data line DL(j+2), the reference voltage line RVLk, and the first power line PL1. The first source drain electrode layer SD1 may configure a third connection electrode CNE3 and a fourth connection electrode CNE4. The first source drain electrode layer SD1 may configure the first electrode E1.

The first source drain electrode layer SD1 configuring the first power line PL1 may be connected to the first connection electrode CNE1 in the first contact hole CNT1. The third connection electrode CNE3 may be connected to the first connection electrode CNE1. The third connection electrode CNE3 may be connected to the semiconductor layer of the first transistor TR1.

The first source drain electrode layer SD1 configuring the j-th data line DLj may be connected to the semiconductor layer of the second transistor TR2 of the first sub-pixel SP1. The first source drain electrode layer SD1 configuring the (j+1)-th data line DL(j+1) may be connected to the semiconductor layer of the second transistor TR2 of the second sub-pixel SP2. The first source drain electrode layer SD1 configuring the (j+2)-th data line DL(j+2) may be connected to the semiconductor layer of the second transistor TR2 of the third sub-pixel SP3.

The (j+1)-th data line DL(j+1) and the (j+2)-th data line DL(j+2) may be positioned adjacent to each other in the first direction DR1. However, embodiments are not limited thereto.

The reference voltage line RVLk may be positioned adjacent to each of the semiconductor layer of the first sub-pixel SP1 and the semiconductor layer of the second sub-pixel SP2 in the first direction DR1 on the plane. However, embodiments are not limited thereto.

The first source drain electrode layer SD1 configuring the reference voltage line RVLk may be connected to the second connection electrode CNE2 in the second contact hole CNT2. The fourth connection electrode CNE4 may be connected to the second connection electrode CNE2 and the semiconductor layer of the third transistor TR3.

The first power line PL1 may be positioned adjacent to the semiconductor layer of the third sub-pixel SP3 in the first direction DR1 on the plane. However, embodiments are not limited thereto.

The first source drain electrode layer SD1 configuring the first electrode E1 may be connected to the semiconductor layer of the second transistor TR2 and may extend in one direction (for example, the second direction DR2). The first electrode E1 may overlap at least a portion of the semiconductor layer of the first transistor TR1. An area overlapping the first electrode E1 in the semiconductor layer of the first transistor TR1 may configure a channel area of the first transistor TR1. The first electrode E1 may configure one side electrode of the storage capacitor Cstg (refer to FIG. 2) and may configure a gate electrode of the first transistor TR1. The first electrode E1 may correspond to the first node N1.

A first insulating layer may be provided on the first source drain electrode layer SD1. For example, the first insulating layer may be an organic insulating layer including an organic material. The first insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The first insulating layer may perform a function of planarizing an area on the first source drain electrode layer SD1.

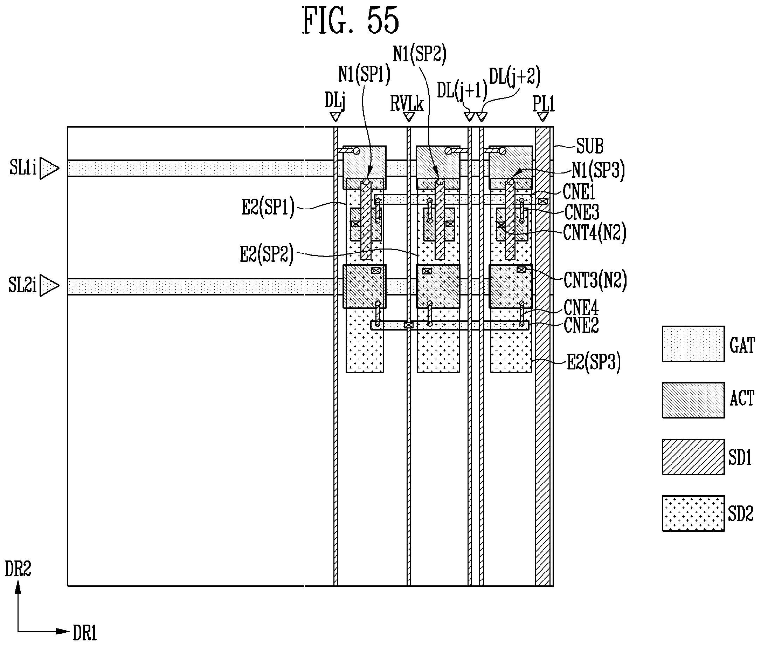

Hereinafter, the disclosure is described with reference to FIG. 55.

A second source drain electrode layer SD2 may be positioned on the first source drain electrode layer SD1 (or on the first insulating layer). The second source drain electrode layer SD2 may include a metal. The second source drain electrode layer SD2 may include a material having excellent conductivity. For example, the second source drain electrode layer SD2 may include a conductive material including molybdenum (Mo), aluminum (Al), copper (Cu), titanium (Ti), and the like. The second source drain electrode layer SD2 may be formed as a multi-layer structure or a single layer structure including the above-described material. For example, the second source drain electrode layer SD2 may have a multi-layer structure of Ti/Al/Ti.

The second source drain electrode layer SD2 may configure the second electrode E2.

The second source drain electrode layer SD2 configuring the second electrode E2 may be connected to the semiconductor layer of the third transistor TR3 through a third contact hole CNT3. The second source drain electrode layer SD2 may be directly connected to the semiconductor layer of the third transistor TR3. The second source drain electrode layer SD2 may be electrically connected to the semiconductor layer of the third transistor TR3 through the first source drain electrode layer SD1.

The second source drain electrode layer SD2 configuring the second electrode E2 may be connected to the semiconductor layer of the first transistor TR1 through a fourth contact hole CNT4. The second source drain electrode layer SD2 may be directly connected to the semiconductor layer of the first transistor TR1. The second source drain electrode layer SD2 may be electrically connected to the semiconductor layer of the first transistor TR1 through the first source drain electrode layer SD1.

A second insulating layer may be provided on the second source drain electrode layer SD2. For example, the second insulating layer may be an organic insulating layer including an organic material. The second insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The second insulating layer may perform a function of planarizing an area on the second source drain electrode layer SD2.

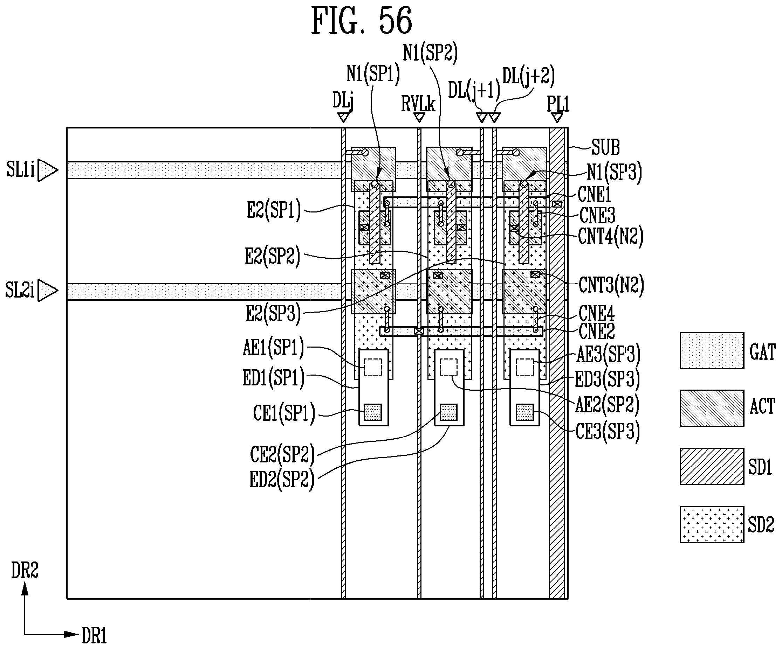

Hereinafter, the disclosure is described with reference to FIG. 56.

The first to third light emitting elements ED1 to ED3 may be positioned on the second source drain electrode layer SD2 (or on the second insulating layer).

The first anode electrode AE1 of the first light emitting element ED1 may be connected to the second electrode E2 of the first sub-pixel SP1.

The second anode electrode AE2 of the second light emitting element ED2 may be connected to the second electrode E2 of the second sub-pixel SP2.

The third anode electrode AE3 of the third light emitting element ED3 may be connected to the second electrode E2 of the third sub-pixel SP3.

The cathode electrodes CE1 to CE3 of the first to third light emitting elements ED1 to ED3 may be connected to the second power line PL2 (refer to FIGS. 2 and 14) on the first to third light emitting elements ED1 to ED3.

The respective first to third light emitting elements ED1 to ED3 may be positioned adjacent to each other in the first direction DR1.

The cathode electrodes CE1, CE2, and CE3 of the respective first to third light emitting elements ED1 to ED3 may not overlap the semiconductor layer ACT on the plane. For example, the first to third cathode electrodes CE1 to CE3 may be positioned so as not to overlap the semiconductor layer of the second transistor TR2 on the plane. As another example, the first to third cathode electrodes CE1 to CE3 may be positioned so as not to overlap the semiconductor layer of the third transistor TR3 on the plane.

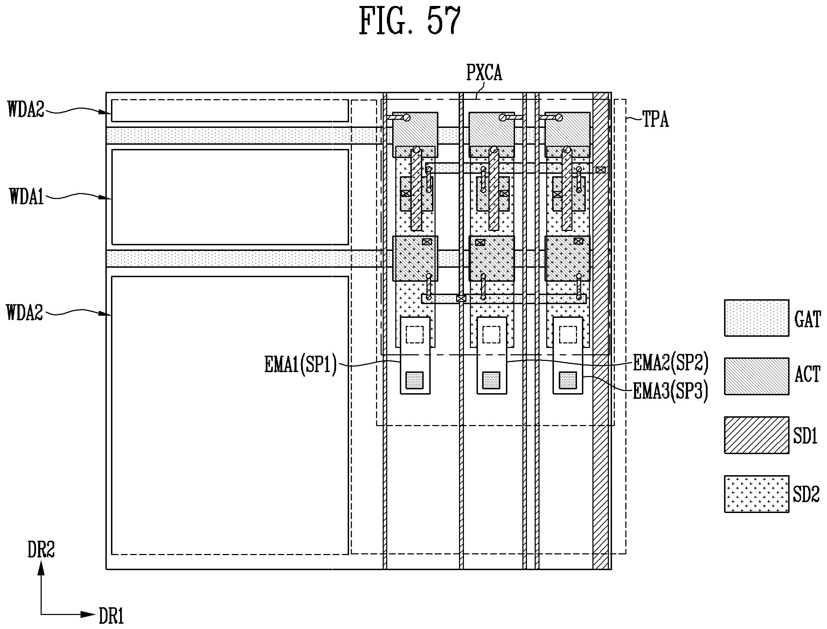

Hereinafter, the disclosure is described with reference to FIG. 57.

The window area WDA may transmit light through the substrate SUB. The window area WDA may include the first window area WDA1 and the second window area WDA2. A semiconductor layer ACT and a metal layer may not be positioned in the window area WDA. For example, the gate electrode layer GAT, the semiconductor layer ACT, the first source drain electrode layer SD1, and the second source drain electrode layer SD2 may not be positioned in the window area WDA.

The first window area WDA1 may be positioned adjacent to the pixel circuit area PXCA in the first direction DR1. At least a portion of the second window area WDA2 may be positioned adjacent to the pixel circuit area PXCA in the first direction DR1. A remaining portion of the second window area WDA2 may be positioned adjacent to the light transmission area TPA in the first direction DR1.

The first window area WDA1 and the second window area WDA2 may be positioned spaced apart from each other in the second direction DR2. The gate electrode layer GAT may be positioned between the first window area WDA1 and the second window area WDA2.

A semiconductor layer ACT and a metal layer may be positioned in the pixel circuit area PXCA. For example, the gate electrode layer GAT, the semiconductor layer ACT, the first source drain electrode layer SD1, and the second source drain electrode layer SD2 may be positioned in the pixel circuit area PXCA.

At least a portion of the first to third emission areas EMA1 to EMA3 may be positioned to overlap the pixel circuit area PXCA. A remaining portion of the first to third emission areas EMA1 to EMA3 may be positioned so as not to overlap the pixel circuit area PXCA on the plane.

The first source drain electrode layer SD1 may be positioned in the light transmission area TPA. Light may pass through the substrate SUB through the light transmission area TPA, but light transmittance of the light transmission area TPA may be lower than light transmittance of the window area WDA and may be higher than light transmittance of the pixel circuit area PXCA.

Compared to the embodiment of FIGS. 13 and 25 described above, the light transmission line TCO and the anode electrode layer AND may not be positioned in the light transmission area TPA. Accordingly, light transmittance may be further increased in the light transmission area TPA.

In addition, the first to third cathode electrodes CE1 to CE3 may be positioned so as not to overlap the semiconductor layer ACT on the plane, and thus force applied to the pixel circuit area PXCA may be distributed. Accordingly, transistors, capacitors, and lines may be stably formed.

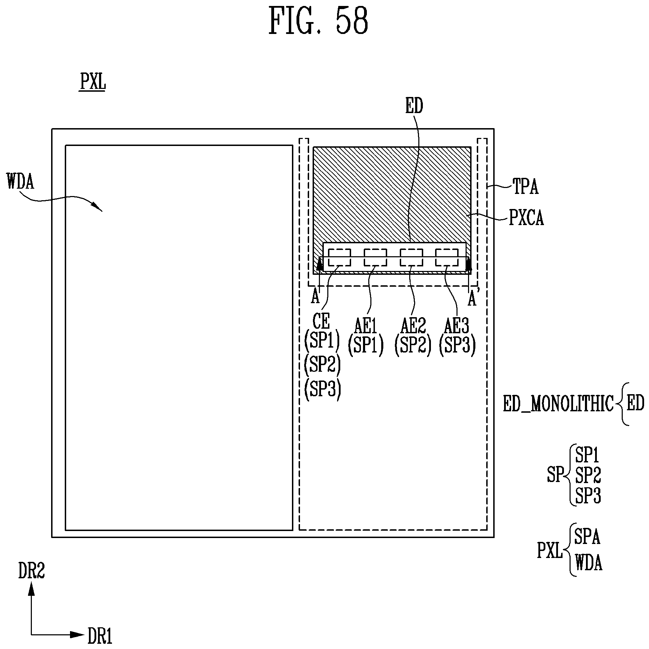

FIG. 58 is a fourth embodiment of a pixel PXL, in which a monolithic type light emitting element ED_MONOLITHIC is disposed.

Referring to FIG. 58, in the pixel PXL according to the fourth embodiment, the sub-pixels SP may include one light emitting element ED. For example, the first to third sub-pixels SP1 to SP3 may include one light emitting element ED.

Comparing the pixel PXL according to the fourth embodiment with the pixel PXL according to the second embodiment described through FIGS. 26 and 34 and the pixel PXL according to the third embodiment described through FIGS. 42 and 50, the number of light emitting elements ED may be less than the number of sub-pixels SP in the pixel PXL.

The monolithic type light emitting element ED_MONOLITHIC may include one cathode electrode CE and a plurality of anode electrodes AE1, AE2, and AE3 connected to the respective first to third sub-pixels SP1 to SP3.

In the monolithic type light emitting element ED_MONOLITHIC, each of the cathode electrode CE and the plurality of anode electrodes AE1, AE2, and AE3 may be positioned at a lower surface of the light emitting element ED. That is, the monolithic type light emitting element ED_MONOLITHIC may be implemented as a flip type. However, it is not limited thereto. For example, the monolithic type light emitting element ED_MONOLITHIC may be implemented as a vertical type.

Compared to the pixel PXL according to the first embodiment of FIG. 4 described above, in the pixel PXL according to the fourth embodiment, the light emitting element ED is not positioned in the light transmission area TPA. Accordingly, light transmittance may be further increased in the light transmission area TPA.

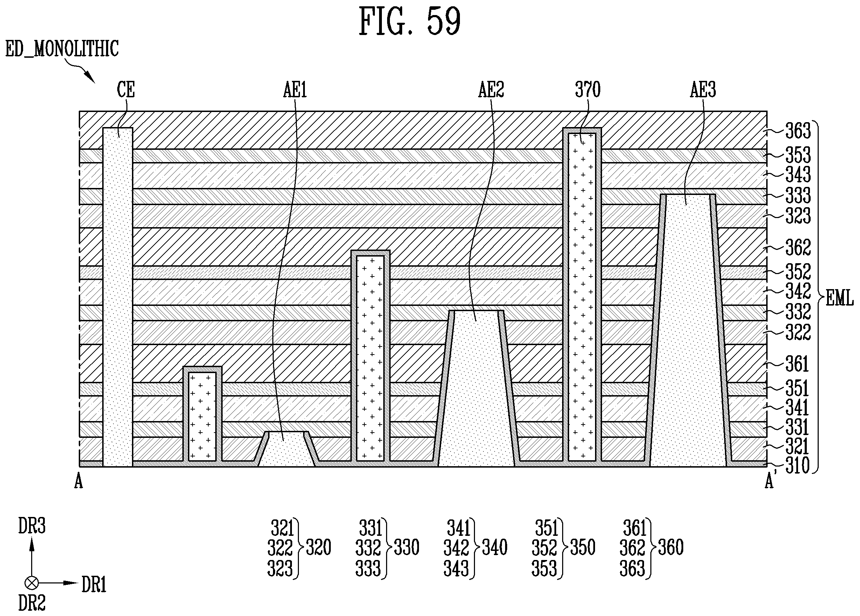

FIG. 59 is an example of a cross-sectional view of the monolithic type light emitting element ED_MONOLITHIC of FIG. 58 taken along line A-A'.

The monolithic type light emitting element ED_MONOLITHIC may include the first to third anode electrodes AE1 to AE3, the cathode electrode CE, an emission layer EML, and a light blocking layer 370. The emission layer EML may include a passivation layer 310, an insulating layer 320, a transmission conductive layer 330, a first semiconductor layer 340, an active layer 350, a second semiconductor layer 360, and the like.

The passivation layer 310 may be configured to electrically insulate between a metal (for example, copper (Cu)) configuring the light blocking layer 370 and the emission layer EML. The passivation layer 310 may include, for example, an inorganic material such as silicon oxide (SiOₓ) (x is a positive number), silicon nitride (SiNₓ), silicon oxynitride (SiOₓN_{y}) (y is a positive number), silicon oxycarbide (SiOₓC_{y}), aluminum oxide (AlOₓ), aluminum nitride (AlNₓ), zirconium oxide (ZrOₓ), hafnium oxide (HfOₓ), or titanium oxide (TiOₓ). However, it is not limited thereto.

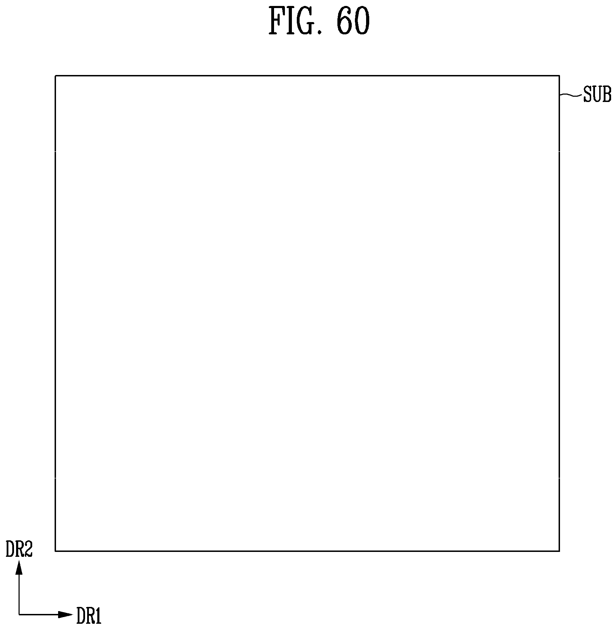

The insulating layer 320 may be positioned on the passivation layer 310 (in the third direction DR3). The insulating layer 320 may perform a function of preventing the transmission conductive layer 330 from being directly connected to a substrate SUB (refer to FIG. 60) described later. The insulating layer 320 may include an inorganic material such as silicon oxide (SiOₓ) (x is a positive number), silicon nitride (SiNₓ), silicon oxynitride (SiOₓN_{y}) (y is a positive number), silicon oxycarbide (SiOₓC_{y}), aluminum oxide (AlOₓ), aluminum nitride (AlNₓ), zirconium oxide (ZrOₓ), hafnium oxide (HfOₓ), or titanium oxide (TiOₓ). The insulating layer 320 may include a first insulating layer 321, a second insulating layer 322, and a third insulating layer 323.

The transmission conductive layer 330 may be disposed on the insulating layer 320. The transmission conductive layer 330 may include a metal or a metal oxide. For example, the transmission conductive layer 330 may include at least one of various transparent conductive materials including indium tin oxide (ITO), indium zinc oxide (IZO), zinc oxide (ZnO), indium tin zinc oxide (ITZO), aluminum zinc oxide (AZO), gallium zinc oxide (GZO), zinc tin oxide (ZTO), and gallium tin oxide (GTO). The transmission conductive layer 330 may be implemented to be substantially transparent or translucent so as to satisfy a predetermined light transmittance. Accordingly, light emitted from the emission layer EML may pass through the transmission conductive layer 330 and may be emitted to an outside of the display panel 110 (refer to FIG. 1). The transmission conductive layer 330 may include a metal or a metal oxide. For example, the transmission conductive layer 330 may include copper (Cu), gold (Au), chromium (Cr), titanium (Ti), aluminum (Al), nickel (Ni), indium tin oxide (ITO), an oxide or an alloy thereof, or the like, but it is not limited thereto. The transmission conductive layer 330 may include a first transmission conductive layer 331, a second transmission conductive layer 332, and a third transmission conductive layer 333.

The first semiconductor layer 340 may be positioned on the transmission conductive layer 330. The first semiconductor layer 340 may include one of a p-type semiconductor layer and an n-type semiconductor layer. Hereinafter, for convenience of description, an example in which the first semiconductor layer 340 includes a p-type semiconductor layer is described as an example, but it is not limited thereto. The first semiconductor layer 340 may include a semiconductor material such as GaN, InGaN, InAlGaN, AlGaN, or AlN, and may include a p-type semiconductor layer doped with a first conductive dopant (or a p-type dopant) such as magnesium (Mg), zinc (Zn), calcium (Ca), strontium (Sr), or barium (Ba). The first semiconductor layer 340 may include a first-first semiconductor layer 341, a second-first semiconductor layer 342, and a third-first semiconductor layer 343.

The active layer 350 may be disposed between the first semiconductor layer 340 and the second semiconductor layer 360. The active layer 350 may include one structure among a single well structure, a multi well structure, a single quantum well structure, a multi quantum well (MQW) structure, a quantum dot structure, and a quantum wire structure, but it is not limited thereto. The active layer 350 may include AlGaN, InGaN, or GaN, and various other materials may also configure the active layer 350. The active layer 350 may include a first active layer 351, a second active layer 352, and a third active layer 353.

The first active layer 351, the second active layer 352, and the third active layer 353 may be configured to emit light of different wavelength bands, respectively. For example, the first active layer 351 may be configured to emit light of a relatively long wavelength band, and the third active layer 353 may be configured to emit light of a relatively short wavelength band. For example, the first active layer 351 may be configured to emit light of a red wavelength band, the second active layer 352 may be configured to emit light of a green wavelength band, and the third active layer 353 may be configured to emit light of a blue wavelength band.

The second semiconductor layer 360 may be positioned on the active layer 350. The second semiconductor layer 360 may include the other of the p-type semiconductor layer and the n-type semiconductor layer. Hereinafter, for convenience of description, an example in which the second semiconductor layer 360 includes the n-type semiconductor layer is described as an example, but it is not limited thereto. The second semiconductor layer 360 may include a semiconductor material such as GaN, InGaN, InAlGaN, AlGaN, or AlN, and may be an n-type semiconductor layer doped with a second conductive dopant (or an n-type dopant) such as germanium (Ge), selenium (Se), tellurium (Te), or tin (Sn). For example, the second semiconductor layer 360 of the monolithic type light emitting element ED_MONOLITHIC may include a GaN semiconductor material doped with a second conductive dopant (or an n-type dopant). However, a material configuring the second semiconductor layer 360 is not limited thereto, and the second semiconductor layer 360 may be configured of various other materials. The second semiconductor layer 360 may include a first-second semiconductor layer 361, a second-second semiconductor layer 362, and a third-second semiconductor layer 363.

The light blocking layer 370 may be configured to prevent color mixing. The light blocking layer 370 surrounded by the passivation layer 310 may perform a function of electrically insulating the first to third anode electrodes AE1 to AE3 and the cathode electrode CE from each other. For example, light emitted from the first sub-pixel SP1 (refer to FIG. 58) may be emitted through an area on the first anode electrode AE1. Light emitted from the second sub-pixel SP2 (refer to FIG. 58) may be emitted through an area on the second anode electrode AE2. Light emitted from the third sub-pixel SP3 (refer to FIG. 58) may be emitted through an area on the third anode electrode AE3. The light blocking layer 370 may be positioned between the respective sub-pixels SP1, SP2, and SP3 so that the light emitted from each of the sub-pixels SP1, SP2, and SP3 does not mix with each other.

The first to third anode electrodes AE1 to AE3 may be connected to the transmission conductive layer 330. The first anode electrode AE1 may be connected to the first transmission conductive layer 331. The second anode electrode AE2 may be connected to the second transmission conductive layer 332. The third anode electrode AE3 may be connected to the third transmission conductive layer 333. The first to third anode electrodes AE1 to AE3 may supply a positive voltage (or a voltage of a relatively high potential) to the transmission conductive layer 330.

The cathode electrode CE may be connected to the second semiconductor layer 360 (for example, a side surface of the second semiconductor layer 360). The cathode electrode CE may supply a negative voltage (or a voltage of a relatively low potential) to the second semiconductor layer 360. A thickness of the second semiconductor layer 360 may be thicker than that of the first semiconductor layer 340. Accordingly, supplying a voltage to the second semiconductor layer 360 through the cathode electrode CE may be relatively easy.

FIGS. 60 to 66 are drawings illustrating a method of manufacturing a display device.

The display device shown through FIGS. 60 to 66 may include a transistor of a bottom-gate structure and/or a transistor of a top-gate structure. For example, the second and third transistors TR2 and TR3 may be implemented as transistors of a bottom-gate structure, and the first transistor TR1 may be implemented as a transistor of a top-gate structure. However, they are not limited thereto. For example, at least one of the second transistor TR2 and the third transistor TR3 may be implemented as a transistor of a top-gate structure, or the first transistor TR1 may be implemented as a transistor of a bottom-gate structure.

Hereafter, the disclosure is described with reference to FIG. 60.

A substrate SUB may be formed of an insulating material such as glass or resin. In addition, the substrate SUB may be formed of a material having flexibility so that the substrate SUB may be bent or folded, and may have a single-layer structure or a multi-layer structure. The substrate SUB may include at least one base layer and at least one barrier layer that are sequentially stacked. The base layer may include polyimide (PI), polyethersulfone (PES), polyarylate, polyetherimide (PEI), polyethylene naphthalate (PEN), polyethylene terephthalate (PET), polyphenylene sulfide (PPS), polycarbonate (PC), cellulose triacetate (CTA), cellulose acetate propionate (CAP), and/or the like. The barrier layer may include an inorganic insulating material such as silicon oxide, silicon oxynitride, and/or silicon nitride.

A buffer layer may be disposed on the substrate SUB. The buffer layer may prevent an impurity from being diffused into a circuit element (for example, a transistor). The buffer layer may be omitted according to a material and a process condition of the base layer. The buffer layer may include an inorganic insulating material such as silicon oxide, silicon oxynitride, or silicon nitride. The buffer layer may be formed as a single-layer structure or a multi-layer structure including the above-described material.

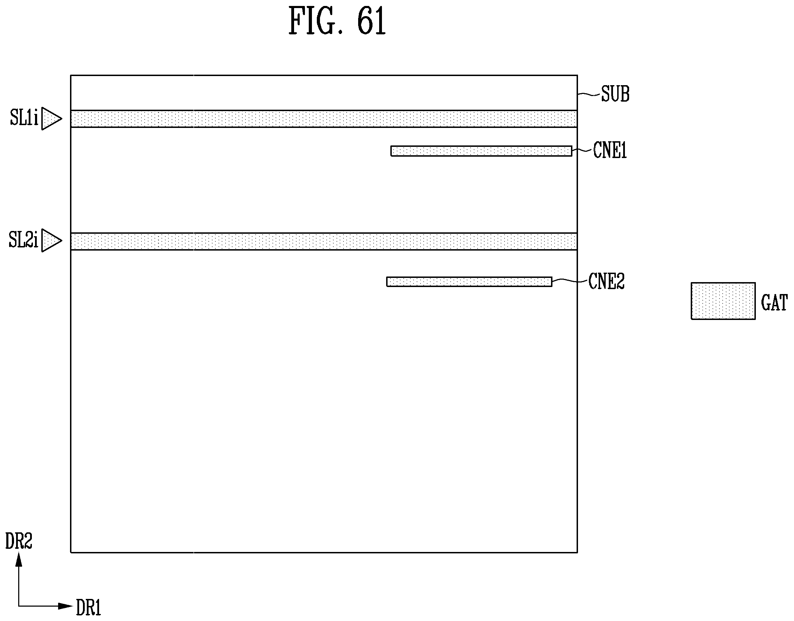

Hereinafter, the disclosure is described with reference to FIG. 61.

The gate electrode layer GAT may be formed on the substrate SUB (or on the buffer layer). The gate electrode layer GAT may include a metal. For example, the gate electrode layer GAT may be formed of at least one of metals such as gold (Au), silver (Ag), aluminum (Al), molybdenum (Mo), chromium (Cr), titanium (Ti), nickel (Ni), neodymium (Nd), and copper (Cu), or an alloy of metals. In addition, the gate electrode layer GAT may be formed as a single layer or may be formed as a multi-layer in which two or more materials among metals and alloys are stacked.

A gate insulating layer may be positioned on the gate electrode layer GAT. The gate insulating layer may include an inorganic insulating layer including an inorganic material. As the inorganic material, polysiloxane, silicon nitride, silicon oxide, silicon oxynitride, or the like may be used.

The gate electrode layer GAT may configure the first scan line SL1i, the second scan line SL2i, a first connection electrode CNE1, and a second connection electrode CNE2. The first scan line SL1i, the second scan line SL2i, the first connection electrode CNE1, and the second connection electrode CNE2 may entirely extend in the first direction DR1.

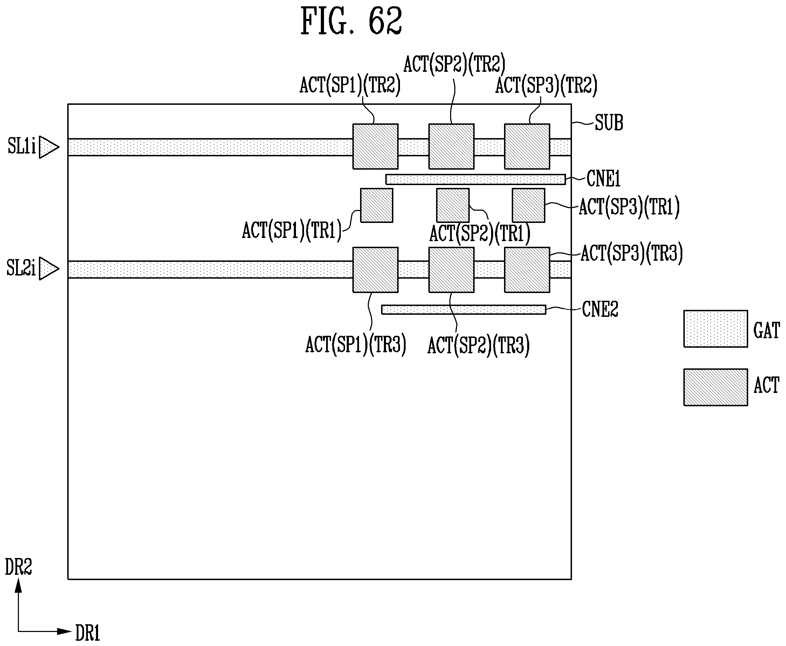

Hereinafter, the disclosure is described with reference to FIG. 62.

A semiconductor layer ACT may be positioned on the gate electrode layer GAT (or on the gate insulating layer). The semiconductor layer ACT may include an oxide semiconductor. For example, the semiconductor layer ACT may be formed through a metal oxide semiconductor forming process. However, embodiments are not limited thereto. For example, the semiconductor layer ACT may be formed of a silicon semiconductor. For example, the semiconductor layer ACT may include a semiconductor of amorphous silicon (a-Si). The semiconductor layer ACT may include a semiconductor of polycrystalline silicon (poly-Si).

The semiconductor layer ACT configuring the semiconductor layer of the second transistor TR2 may be positioned to overlap the first scan line SL1i on the plane. The semiconductor layer ACT configuring the semiconductor layer of the third transistor TR3 may be positioned to overlap the second scan line SL2i on the plane. The semiconductor layer ACT configuring the semiconductor layer of the first transistor TR1 may be positioned between the first scan line SL1i and the second scan line SL2i. The first connection electrode CNE1 may be positioned between the semiconductor layer of the first transistor TR1 and the semiconductor layer of the second transistor TR2. The second connection electrode CNE2 may be positioned adjacent to the semiconductor layer of the third transistor TR3 in the second direction DR2.

An interlayer insulating layer may be provided on the semiconductor layer ACT. The interlayer insulating layer may include an inorganic insulating layer including an inorganic material. As the inorganic material, polysiloxane, silicon nitride, silicon oxide, silicon oxynitride, and the like may be used.

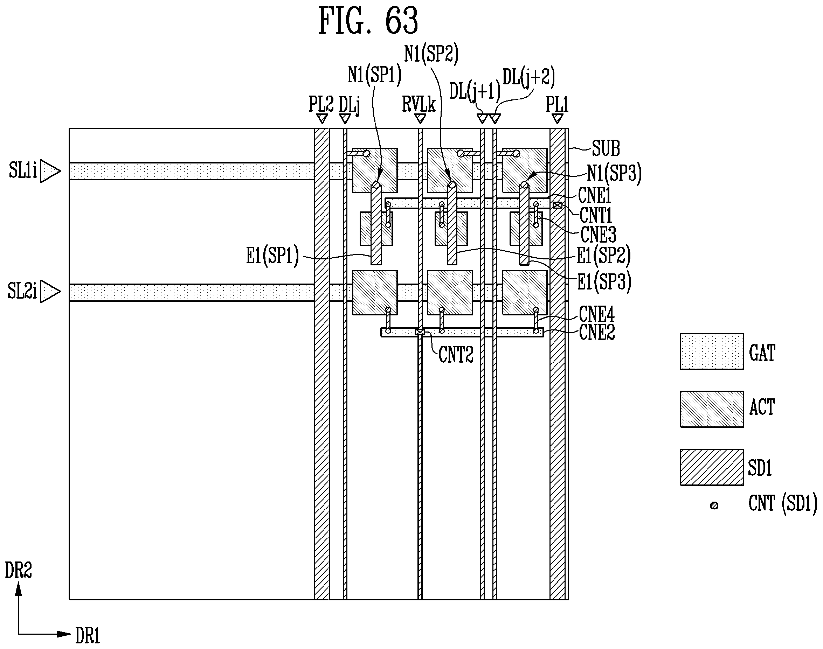

Hereinafter, the disclosure is described with reference to FIG. 63.

A first source drain electrode layer SD1 may be positioned on the semiconductor layer ACT (or on the interlayer insulating layer). The first source drain electrode layer SD1 may include a metal. The first source drain electrode layer SD1 may include a material having excellent conductivity. For example, the first source drain electrode layer SD1 may include a conductive material including molybdenum (Mo), aluminum (Al), copper (Cu), titanium (Ti), and the like. The first source drain electrode layer SD1 may be formed as a multi-layer structure or a single layer structure including the above-described material. For example, the first source drain electrode layer SD1 may have a multi-layer structure of Ti/Al/Ti.

The first source drain electrode layer SD1 may configure the j-th data line DLj, the (j+1)-th data line DL(j+1), the (j+2)-th data line DL(j+2), the reference voltage line RVLk, the first power line PL1, and the second power line PL2. The first source drain electrode layer SD1 may configure a third connection electrode CNE3 and a fourth connection electrode CNE4. The first source drain electrode layer SD1 may configure the first electrode E1.

The first source drain electrode layer SD1 configuring the first power line PL1 may be connected to the first connection electrode CNE1 in the first contact hole CNT1. The third connection electrode CNE3 may be connected to the first connection electrode CNE1. The third connection electrode CNE3 may be connected to the semiconductor layer of the first transistor TR1.

The first source drain electrode layer SD1 configuring the second power line PL2 may entirely extend in the second direction DR2. The second power line PL2 may be positioned to overlap the first scan line SL1i and the second scan line SL2i on the plane. The second power line PL2 may be positioned adjacent to the j-th data line DLj in the first direction DR1. However, embodiments are not limited thereto.

The first source drain electrode layer SD1 configuring the j-th data line DLj may be connected to the semiconductor layer of the second transistor TR2 of the first sub-pixel SP1. The first source drain electrode layer SD1 configuring the (j+1)-th data line DL(j+1) may be connected to the semiconductor layer of the second transistor TR2 of the second sub-pixel SP2. The first source drain electrode layer SD1 configuring the (j+2)-th data line DL(j+2) may be connected to the semiconductor layer of the second transistor TR2 of the third sub-pixel SP3.

The (j+1)-th data line DL(j+1) and the (j+2)-th data line DL(j+2) may be positioned adjacent to each other in the first direction DR1. However, embodiments are not limited thereto.

The reference voltage line RVLk may be positioned adjacent to each of the semiconductor layer of the first sub-pixel SP1 and the semiconductor layer of the second sub-pixel SP2 in the first direction DR1 on the plane. However, embodiments are not limited thereto.

The first source drain electrode layer SD1 configuring the reference voltage line RVLk may be connected to the second connection electrode CNE2 in the second contact hole CNT2. The fourth connection electrode CNE4 may be connected to the second connection electrode CNE2 and the semiconductor layer of the third transistor TR3.

The first power line PL1 may be positioned adjacent to the semiconductor layer of the third sub-pixel SP3 in the first direction DR1 on the plane. However, embodiments are not limited thereto.

The first source drain electrode layer SD1 configuring the first electrode E1 may be connected to the semiconductor layer of the second transistor TR2 and may extend in one direction (for example, the second direction DR2). The first electrode E1 may overlap at least a portion of the semiconductor layer of the first transistor TR1. An area overlapping the first electrode E1 in the semiconductor layer of the first transistor TR1 may configure a channel area of the first transistor TR1. The first electrode E1 may configure one side electrode of the storage capacitor Cstg (refer to FIG. 2) and may configure a gate electrode of the first transistor TR1. The first electrode E1 may correspond to the first node N1.

A first insulating layer may be provided on the first source drain electrode layer SD1. For example, the first insulating layer may be an organic insulating layer including an organic material. The first insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The first insulating layer may perform a function of planarizing an area on the first source drain electrode layer SD1.

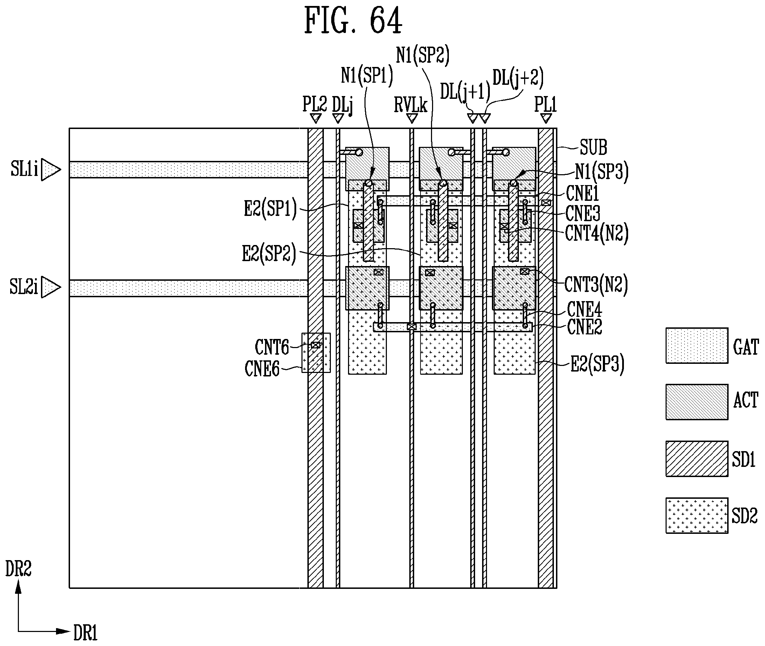

Hereinafter, the disclosure is described with reference to FIG. 64.

A second source drain electrode layer SD2 may be positioned on the first source drain electrode layer SD1 (or on the first insulating layer). The second source drain electrode layer SD2 may include a metal. The second source drain electrode layer SD2 may include a material having excellent conductivity. For example, the second source drain electrode layer SD2 may include a conductive material including molybdenum (Mo), aluminum (Al), copper (Cu), titanium (Ti), and the like. The second source drain electrode layer SD2 may be formed as a multi-layer structure or a single layer structure including the above-described material. For example, the second source drain electrode layer SD2 may have a multi-layer structure of Ti/Al/Ti.

The second source drain electrode layer SD2 may configure the second electrode E2 and a sixth connection electrode CNE6.

The second source drain electrode layer SD2 configuring the second electrode E2 may be connected to the semiconductor layer of the third transistor TR3 through a third contact hole CNT3. The second source drain electrode layer SD2 may be directly connected to the semiconductor layer of the third transistor TR3. The second source drain electrode layer SD2 may be electrically connected to the semiconductor layer of the third transistor TR3 through the first source drain electrode layer SD1.

The second source drain electrode layer SD2 configuring the second electrode E2 may be connected to the semiconductor layer of the first transistor TR1 through a fourth contact hole CNT4. The second source drain electrode layer SD2 may be directly connected to the semiconductor layer of the first transistor TR1. The second source drain electrode layer SD2 may be electrically connected to the semiconductor layer of the first transistor TR1 through the first source drain electrode layer SD1.

The second source drain electrode layer SD2 configuring the sixth connection electrode CNE6 may be connected to the first source drain electrode layer SD1 configuring the second power line PL2 through a sixth contact hole CNT6. The sixth connection electrode CNE6 may be positioned adjacent to at least one of the second electrodes E2 of each of the first to third sub-pixels SP1 to SP3 in the first direction DR1.

A second insulating layer may be provided on the second source drain electrode layer SD2. For example, the second insulating layer may be an organic insulating layer including an organic material. The second insulating layer may include an organic insulating material such as a general-purpose polymer such as polymethylmethacrylate and polystyrene, a polymer derivative having a phenol group, an acrylic polymer, an imide polymer, an aryl ether polymer, an amide polymer, a fluorine polymer, a p-xylene polymer, a vinyl alcohol polymer, and a blend thereof. The second insulating layer may perform a function of planarizing an area on the second source drain electrode layer SD2.

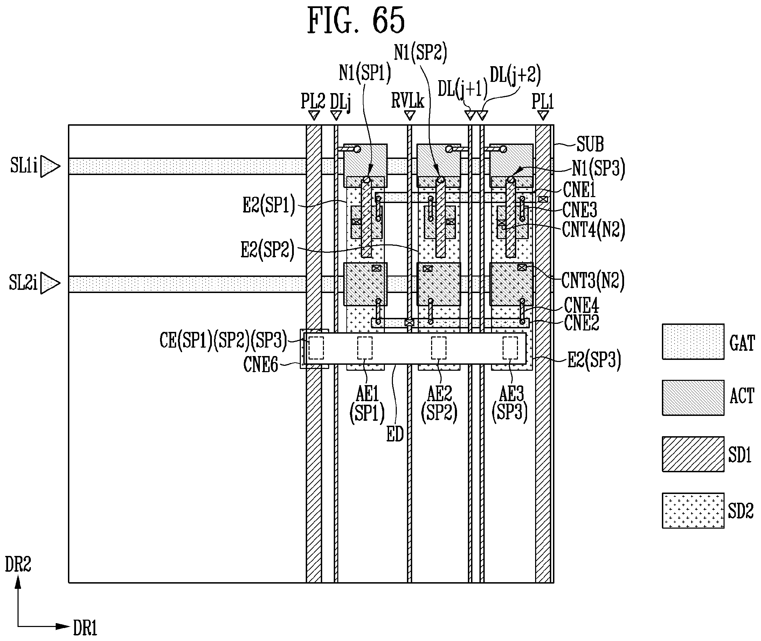

Hereinafter, the disclosure is described with reference to FIG. 65.

One light emitting element ED may be positioned on the second source drain electrode layer SD2 (or on the second insulating layer).

A first anode electrode AE1 of the light emitting element ED may be connected to the second electrode E2 of the first sub-pixel SP1. A second anode electrode AE2 of the light emitting element ED may be connected to the second electrode E2 of the second sub-pixel SP2. A third anode electrode AE3 of the light emitting element ED may be connected to the second electrode E2 of the third sub-pixel SP3.

The cathode electrode CE of the light emitting element ED may be connected to the sixth connection electrode CNE6.

The cathode electrode CE of the light emitting element ED may not overlap the semiconductor layer ACT on the plane. However, embodiments are not limited thereto. For example, the light emitting element ED may be disposed while entirely covering the semiconductor layer of each of the first to third transistors TR1 to TR3. In the above, an emission area where light is emitted by the light emitting element ED may be expanded.

In the light emitting element ED, a width of the first direction DR1 may be longer than a length of the second direction DR2. However, it is not limited thereto. For example, in the light emitting element ED, the width of the first direction DR1 may be longer than or equal to the length of the second direction DR2.

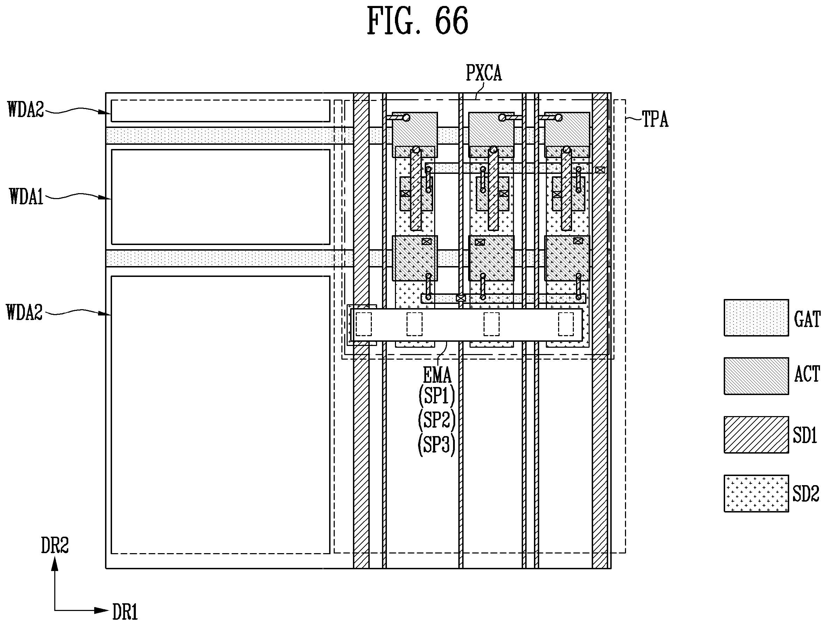

Hereinafter, the disclosure is described with reference to FIG. 66.

The window area WDA may transmit light through the substrate SUB. The window area WDA may include the first window area WDA1 and the second window area WDA2. A semiconductor layer ACT and a metal layer may not be positioned in the window area WDA. For example, the gate electrode layer GAT, the semiconductor layer ACT, the first source drain electrode layer SD1, and the second source drain electrode layer SD2 may not be positioned in the window area WDA.

The first window area WDA1 may be positioned adjacent to the pixel circuit area PXCA in the first direction DR1. At least a portion of the second window area WDA2 may be positioned adjacent to the pixel circuit area PXCA in the first direction DR1. A remaining portion of the second window area WDA2 may be positioned adjacent to the light transmission area TPA in the first direction DR1.

The first window area WDA1 and the second window area WDA2 may be positioned spaced apart from each other in the second direction DR2. The gate electrode layer GAT may be positioned between the first window area WDA1 and the second window area WDA2.

A semiconductor layer ACT and a metal layer may be positioned in the pixel circuit area PXCA. For example, the gate electrode layer GAT, the semiconductor layer ACT, the first source drain electrode layer SD1, and the second source drain electrode layer SD2 may be positioned in the pixel circuit area PXCA.

At least a portion of an emission area EMA may be positioned to overlap the pixel circuit area PXCA. A remaining portion of the emission area EMA may be positioned so as not to overlap the pixel circuit area PXCA on the plane.

The first source drain electrode layer SD1 may be positioned in the light transmission area TPA. Light may pass through the substrate SUB through the light transmission area TPA, but light transmittance of the light transmission area TPA may be lower than light transmittance of the window area WDA and may be higher than light transmittance of the pixel circuit area PXCA.

Compared to the embodiment of FIGS. 13 and 25 described above, the light transmission line TCO and the anode electrode layer AND may not be positioned in the light transmission area TPA. Accordingly, light transmittance may be further increased in the light transmission area TPA.

In accordance with the display device and an electronic device including the same according to embodiments of the invention, a display device with an increased light transmittance may be provided.

The drawings referred to so far and the detailed description herein are merely examples of the invention, are used for merely describing the invention, and are not intended to limit the meaning and the scope of the invention described in the claims. Therefore, those skilled in the art will understand that various modifications and equivalent other embodiments are possible from these.

## Claims

1. A display device comprising:
a sub-pixel area in which a plurality of sub-pixels are disposed on a substrate; and
a window area positioned adjacent to the sub-pixel area in a first direction on the substrate and including an area through which light is transmitted through the substrate on a plane.

2. The display device according to claim 1, wherein the sub-pixel area comprises:
a pixel circuit area in which a pixel circuit, which includes at least one transistor and at least one capacitor, of each of the plurality of sub-pixels is disposed; and
a light transmission area positioned adjacent to the window area in the first direction and adjacent to the pixel circuit area in a second direction intersecting the first direction, and in which at least one line extending in the second direction and electrically connected to the transistor on the substrate is disposed.

3. The display device according to claim 2, wherein a first scan line and a second scan line extend in the first direction, and
the window area comprises:
a first window area positioned adjacent to the pixel circuit area in the first direction; and
a second window area positioned adjacent to the first window area in the second direction with at least one of the first scan line and the second scan line interposed therebetween.

4. The display device according to claim 3, wherein the pixel circuit comprises:
a first transistor including a gate electrode connected to a first node and connected between a first power line and a second node;
a second transistor controlled in response to a first scan signal applied to the first scan line and connected between a data line and the first node; and
a third transistor controlled in response to a second scan signal applied to the second scan line and connected between the second node and a reference voltage line.

5. The display device according to claim 4, wherein the first power line and the data line extend in the second direction and cross the light transmission area.

6. The display device according to claim 4, wherein the pixel circuits of the plurality of sub-pixels is positioned adjacent to each other in the first direction, and
the pixel circuits of the plurality of sub-pixels is positioned adjacent to the light transmission area in the second direction.

7. The display device according to claim 6, wherein the plurality of sub-pixels include at least one light emitting element, and
the light emitting element is positioned so as not to overlap the window area on the plane.

8. The display device according to claim 7, wherein the plurality of sub-pixels comprises:
a first sub-pixel configured to emit light of a first wavelength band;
a second sub-pixel configured to emit light of a second wavelength band different from the first wavelength band; and
a third sub-pixel configured to emit light of a third wavelength band different from the first and second wavelength bands.

9. The display device according to claim 8, wherein each of the first to third sub-pixels includes a light emitting element,
the light emitting element of the first sub-pixel is positioned to overlap the pixel circuit area, and
the light emitting element of each of the second and third sub-pixels is positioned to overlap the light transmission area.

10. The display device according to claim 8, wherein a second power line extending in the second direction is further disposed in the light transmission area,
the first to third sub-pixels include a corresponding one of a first light emitting element, a second light emitting element, and a third light emitting element positioned adjacent to each other in the first direction, and
each of the first to third light emitting elements comprises:
an anode electrode connected to the pixel circuit; and
a cathode electrode electrically connected to the second power line through a connection electrode.

11. The display device according to claim 10, wherein the cathode electrode of each of the first to third sub-pixels is positioned to overlap a semiconductor layer of the second transistor of each of the first to third sub-pixels on the plane, or wherein the cathode electrode of each of the first to third sub-pixels is positioned between a semiconductor layer of the third transistor of each of the first to third sub-pixels and the light transmission area.

12. The display device according to claim 8, wherein the first to third sub-pixels include a corresponding one of a first light emitting element, a second light emitting element, and a third light emitting element positioned adjacent to each other in the first direction, and
each of the first to third light emitting elements comprises:
an anode electrode connected to the pixel circuit at a lower surface of the first to third light emitting elements; and
a cathode electrode to which a second power voltage is applied at an upper surface of the first to third light emitting elements.

13. The display device according to claim 8, wherein a second power line extending in the second direction is further disposed in the light transmission area,
the pixel circuit of each of the first to third sub-pixels is electrically connected to the light emitting element, and
the light emitting element comprises:
first to third anode electrodes respectively connected to the pixel circuits of the first to third sub-pixels; and
a cathode electrode electrically connected to the second power line.

14. The display device according to claim 4, wherein the first window area is positioned adjacent to a semiconductor layer of the first transistor in the first direction, and
the second window area is not positioned adjacent to the semiconductor layer of the first transistor in the first direction, or wherein the first window area at least a portion of and the second window area is positioned adjacent to a semiconductor layer of the first transistor in the first direction,
the semiconductor layer of the first transistor includes a P-type semiconductor layer, and a semiconductor layer of the third transistor includes an N-type semiconductor layer.

15. An electronic device comprising:
a display device according to any one of the preceding claims; and
a host to control the display device.
